# EUROPÄISCHE PATENTSCHRIFT

(11) **EP 0 944 663 B1**
(45) Veröffentlichungstag und Bekanntmachung des Hinweises auf die Patenterteilung: **27.03.2002**
(21) Anmeldenummer: 97953781.8
(22) Anmeldetag: 11.12.1997
(51) Int. Cl.: C08G 61/00, C09K 11/06

(54) **ARYLSUBSTITUIERTE POLY(p-ARYLENVINYLENE), VERFAHREN ZUR HERSTELLUNG UND DEREN VERWENDUNG IN ELEKTROLUMINESZENZBAUELEMENTEN**
ARYL-SUBSTITUTED POLY(p-ARYLENE VINYLENES), METHOD FOR THE PRODUCTION AND USE THEREOF IN ELECTROLUMINESCENT COMPONENTS
POLY(p-ARYLENEVINYLENES) A SUBSTITUTION ARYLE, LEUR PROCEDE DE PREPARATION ET LEUR UTILISATION DANS DES COMPOSANTS ELECTROLUMINESCENTS

(30) Priorität: 16.12.1996 DE 19652261
(43) Veröffentlichungstag der Anmeldung: 29.09.1999
(73) Patentinhaber: Celanese Ventures GmbH, 65926 Frankfurt am Main (DE); Koninklijke Philips Electronics N.V., 5621 BA Eindhoven (NL)
(72) Erfinder: SPREITZER, Hubert, D-65929 Frankfurt am Main (DE); KREUDER, Willi, D-55126 Mainz (DE); BECKER, Heinrich, D-61479 Glashütten (DE); SCHOO, Harmannus, NL-5628 XA Eindhoven (NL); DEMANDT, Robert, NL-5628 WG Eindoven (NL)
(86) Internationale Anmeldenummer: EP9706916
(87) Internationale Veröffentlichungsnummer: WO9827136

(56) Entgegenhaltungen:
- EP-A- 0 443 861
- WO-A-90/13148
- WO-A-94/20589
- US-A- 5 558 904
- VESTWEBER ET AL: "PROGRESS TOWARDS PROCESSIBLE MATERIALS FOR LIGHT-EMITTING DEVICES USING POLY(P-PHENYLPHENYLENEVINYLENE)" ADVANCED MATERIALS, Bd. 4, Nr. 10, 1992, WEINHEIM,DE, Seiten 661-662, XP000321604
- HSIEH ET AL: "CHLORINE PRECURSOR ROUTE(CPR) CHEMISTRY TO POLY(P-PHENYLENE VINYLENE)-BASED LIGHT EMITTING DIODES" ADVANCED MATERIALS, Bd. 7, Nr. 1, 1995, WEINHEIM,DE, Seiten 36-38, XP000486181 in der Anmeldung erwähnt

## Beschreibung

Es besteht ein hoher industrieller Bedarf an großflächigen Festkörper-Lichtquellen für eine Reihe von Anwendungen, überwiegend im Bereich von Anzeigeelementen, der Bildschirmtechnologie und der Beleuchtungstechnik. Die an diese Lichtquellen gestellten Anforderungen können zur Zeit von keiner der bestehenden Technologien völlig befriedigend gelöst werden.

Als Alternative zu herkömmlichen Anzeige- und Beleuchtungselementen, wie Glühlampen, Gasentladungslampen und nicht selbstleuchtenden Flüssigkristallanzeigeelementen, sind bereits seit einiger Zeit Elektrolumineszenz (EL)-materialien und -vorrichtungen, wie lichtemittierende Dioden (LED), in Gebrauch.

Neben anorganischen Elektrolumineszenzmaterialien und -vorrichtungen sind seit etwa 30 Jahren auch niedermolekulare, organische Elektrolumineszenzmaterialien und -vorrichtungen bekannt (siehe z.B. US-A-3,172,862). Bis vor kurzem waren aber solche Vorrichtungen in ihrer praktischen Anwendbarkeit stark eingeschränkt.

In der EP-B 0 423 283 und der EP-B 0 443 861 sind Elektrolumineszenzvorrichtungen beschrieben, die einen Film aus einem konjugierten Polymer als lichtemittierende Schicht (Halbleiterschicht) enthalten. Solche Vorrichtungen bieten zahlreiche Vorteile, wie die Möglichkeit, großflächige, flexible Displays einfach und kostengünstig herzustellen. Im Gegensatz zu Flüssigkristalldisplays sind Elektrolumineszenzdisplays selbstleuchtend und benötigen daher keine zusätzliche rückwärtige Beleuchtungsquelle.

Eine typische Vorrichtung nach EP-B 0 423 283 besteht aus einer lichtemittierenden Schicht in Form eines dünnen, dichten Polymerfilms (Halbleiterschicht), der mindestens ein konjugiertes Polymer enthält. Eine erste Kontaktschicht steht in Kontakt mit einer ersten Oberfläche, eine zweite Kontaktschicht mit einer weiteren Oberfläche der Halbleiterschicht. Der Polymerfilm der Halbleiterschicht hat eine genügend geringe Konzentration von extrinsischen Ladungsträgern, sodaß beim Anlegen eines elektrischen Feldes zwischen den beiden Kontaktschichten Ladungsträger in die Halbleiterschicht eingebracht werden, wobei die eine Kontaktschicht positiv gegenüber der anderen wird, und die Halbleiterschicht Strahlung aussendet. Die in solchen Vorrichtungen verwendeten Polymere sind konjugiert. Unter konjugiertem Polymer versteht man ein Polymer, das ein delokalisiertes Elektronensystem entlang der Hauptkette besitzt. Das delokalisierte Elektronensystem verleiht dem Polymer Haibleitereigenschaften und gibt ihm die Möglichkeit, positive und/oder negative Ladungsträger mit hoher Mobilität zu transportieren.

In EP-B 0 423 283 und der EP-B 0 443 861 ist als polymeres Material für die lichtemittierende Schicht Poly(p-phenylenvinylen) beschrieben, welches mit Alkyl-, Alkoxy-, Halogen- oder Nitrosubstituenten am aromatischen Kem modifiziert werden kann. Derartige Polymere sind seither in einer großen Anzahl von Studien untersucht worden und gerade dialkoxysubstituierte PPVs sind schon sehr weit in Richtung Anwendungsreife hin optimiert worden (vgl. z. B. J. Salbeck, Ber. Bunsenges. Phys. Chem. 1996, 100, 1667). Allerdings kann die Entwicklung derartiger Polymere keinesfalls als abgeschlossen betrachtet werden. So sind unter anderem immer noch Verbesserungen hinsichtlich der Lebensdauer, der Beständigkeit und auch der erzielbaren Farbe nötig. Die am weitesten entwickelte obengenannte Polymerklasse, Dialkoxy-PPV, ist nämlich nur zur Emission orange-roten Lichtes geeignet.

Aufgabe der vorliegenden Erfindung war es daher, neue Elektrolumineszenzmaterialien bereitzustellen, die bei Verwendung in Beleuchtungs- oder Anzeigevorrichtungen geeignet sind, das Eigenschaftsprofil dieser Vorrichtungen zu verbessem.

Es wurde nun überraschend gefunden, daß sich bestimmte Polyarylenvinylene, deren Aryleneinheit durch mindestens einen weiteren substituierten Arylrest substituiert ist, in besonderer Weise als Elektrolumineszenzmaterialien eignen.

Derartige Polymere sind bisher kaum bekannt: So beschreiben zwar H. Vestweber et al. (Adv. Mater. 1992, 4, 661; Synth. Met. 1994, 64, 141) ein phenylsubstituiertes PPV, welches durch Heckreaktion von Ethylen mit 2,5-Dibrombiphenyl gewonnen wird. Dieses Polymer weist jedoch ein extrem niedriges Molekulargewicht (P_{D} ca. 15) auf, was die Filmbildungseigenschaften stark verschlechtert. Zudem ist die Löslichkeit zu niedrig, um mit standardisierten Methoden (z. B. Lackschleudem) homogene Filme im nutzbaren Bereich von 100 nm zu erzeugen. Über ähnliche Probleme berichten auch C. Zhang et al. (Synth. Met. 1994, 62, 35), die das analoge Polymer zwar über eine andere Route (Dehydrohalogenierungspolymerisation von 2,5-Bis(brommethyl)biphenyl) gewinnen, aber analoge Eigenschaften erhalten: geringes Molekulargewicht, schlechte Löslichkeit. Das einzige bis dato bekannte hochmolekulare derartige PPV beschreiben B. R. Hsieh et al. (Adv. Mater. 1995, 7, 36): Diese Gruppe synthetisierte Diphenyl-PPV über ein Precursorverfahren (ausgehend von 1',4'-Bis(chlormethyl)-o-terphenyl). Das Problem hierbei ist offensichtlich, daß auch bei sehr hohen Umwandlungstemperaturen (ca. 290°C) immer noch einen nennenswerter Restgehalt an Chlor im Polymer verbleibt, der für die extrem kurzen Lebensdauern von mit dieser Substanz erzeugten LEDs verantwortlich gemacht wird.

Gegenstand der Erfindung ist daher ein Polymer, enthaltend Wiederholeinheiten der Formel (I), 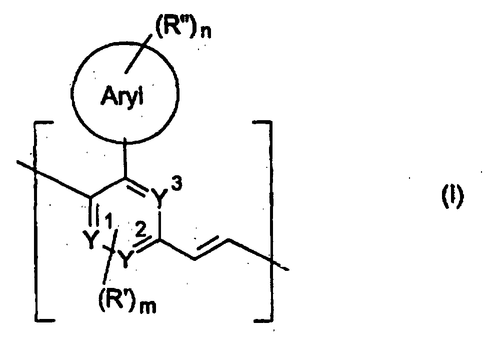 wobei die Symbole und Indizes folgende Bedeutungen haben:
- Y¹, Y², Y³:: gleich oder verschieden, CH, N;
- Aryl :: eine Arylgruppe mit 4 bis 14 C-Atomen;
- R', R" :: gleich oder verschieden eine geradkettige oder verzweigte oder cyclische Alkyl- oder Alkoxygruppe mit 1 bis 20 C-Atomen, wobei ein oder mehrere nicht benachbarte CH₂-Gruppen durch -O-, -S-, -CO-, -COO-, -O-CO-, -NR¹-, -(NR²R³)⁺-A⁻, oder -CONR⁴-ersetzt sein können und wobei ein oder mehrere H-Atome durch F ersetzt sein können, CN, F, Cl oder eine Arylgruppe mit 4 bis 14 C-Atome, die durch einen oder mehrere, nicht aromatische Reste R' substituiert sein kann;
- R¹,R²,R³,R⁴: gleich oder verschieden aliphatische oder aromatische Kohlenwasserstoffreste mit 1 bis 20 C-Atomen oder auch H.
- A⁻ :: ein einfach geladenes Anion oder dessen Äquivalent;
- m :: 0, 1 oder 2;
- n :: 1, 2, 3, 4 oder 5.

Die erfindungsgemäßen Polymere weisen im allgemeinen 2 bis 10 000, vorzugsweise 10 bis 5000, besonders bevorzugt 100 bis 5000, ganz besonders bevorzugt 250 bis 2000 Wiederholeinheiten, vorzugsweise der Formel (I) auf.

Bevorzugt sind Polymere, bestehend aus Wiederholeinheiten der Formel (I).

Bevorzugt sind weiterhin auch Copolymere, bestehend im wesentlichen aus, besonders bevorzugt bestehend aus Wiederholeinheiten der Formel (I) und weiteren Wiederholeinheiten, welche bevorzugt ebenso Poly(arylenvinylen)-Strukturen, besonders bevorzugt 2,5-Dialkoxy-1,4-phenylenvinylenstrukturen enthalten, wobei die Alkoxygruppen vorzugsweise geradkettig oder verzweigt sind und 1 bis 22 C-Atome enthalten.

Weiterhin bevorzugt sind Copolymere, die mindestens zwei verschiedene, besonders bevorzugt mindestens drei verschiedene Wiederholeinheiten der Formel (I) aufweisen.

Ebenso bevorzugt sind Polymere, enthaltend Wiederholeinheiten der Formel (I), bei denen die Symbole und Indizes folgende Bedeutungen haben:
- Y¹, Y², Y³: CH;
- Aryl: Phenyl, 1- bzw. 2-Naphthyl, 1-, 2- bzw. 9-Anthracenyl, 2-, 3- bzw. 4-Pyridinyl, 2-, 4- bzw. 5-Pyrimidinyl, 2-Pyrazinyl, 3- bzw. 4-Pyridazinyl, 2-, 3-, 4-, 5-, 6-, 7- bzw. 8-Chinolin, 2- bzw. 3-Thiophenyl, 2- bzw. 3-Pyrrolyl, 2- bzw. 3-Furanyl und 2-(1,3,4-Oxadiazol)yl;
- R': gleich oder verschieden geradkettige oder verzweigte Alkoxygruppe mit 1 bis 12 C-Atomen;
- R": gleich oder verschieden geradkettige oder verzweigte Alkyl- oder Alkoxygruppe mit 1 bis 12 C-Atomen;
- m: 0, 1, besonders bevorzugt 0;
- n: 1, 2, 3, besonders bevorzugt 1, 2.

Besonders bevorzugt sind Polymere, in denen in der Wiederholeinheit der Formel (I) der Arylsubstituent folgende Bedeutung hat: Phenyl, 1-Naphthyl, 2-Naphthyl oder 9-Anthracenyl.

Des weiteren sind Polymere besonders bevorzugt, in denen in der Wiederholeinheit der Formel (I) der Arylsubstituent folgendes Substitutionsmuster aufweist: 2-, 3- bzw. 4-Alkyl(oxy)phenyl, 2,3-, 2,4-, 2,5-, 2,6-, 3,4- bzw. 3,5-Dialkyl(oxy)phenyl, 2,3,4,-, 2,3,5-, 2,3,6-, 2,4,5,2,4,6- bzw. 3,4,5-Trialkyl(oxy)phenyl, 2-, 3-, 4-, 5-, 6-, 7-bzw. 8-Alkyl(oxy)-1-naphthyl, 1-, 3-, 4-, 5-, 6-, 7- bzw. 8-Alkyl(oxy)-2-naphthyl und 10-Alkyl(oxy)-9-anthracenyl.

Die erfindungsgemäßen Polymere sind beispielsweise und bevorzugt aus Edukten der Formel (II) ― in welcher die Symbole und Indizes die unter Formel (I) erläuterte Bedeutung haben und X für folgende Gruppen steht: Halogenmethylgruppe, Aldehydgruppe, CH₂PO(OR)₂, CH₂S(R)₂⁺A⁻ oder CH₂P(R)₃⁺A⁻―auf folgenden Wegen zu erhalten: 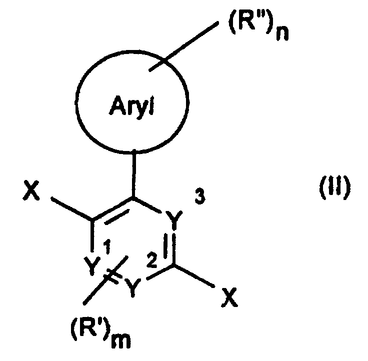
A) Dehydrohalogenierungspolymerisation (X = CH₂Hal, Hal = Cl, Br, I), durch Umsetzung eines oder mehrerer Monomere in einem Lösungsmittel mit einer Base.
   Dazu werden die Monomere in geeigneten Lösungmitteln gelöst, auf die Reaktionstemperatur gebracht und mit einer Base versetzt. Nach Ablauf der Reaktionszeit kann die Reaktionslösung z. B. durch Säurezugabe gequenched werden. Im Anschluß daran reinigt man das Polymer nach geeigneten, dem Fachmann geläufigen Verfahren, wie Umfällen oder Extraktion.
   Geeignete Lösungsmittel stellen beispielsweise Ether (z. B. Diethylether, THF, Dioxan, Dioxolan, tert.-Butylmethylether), aromatische Kohlenwasserstoffe (z. B. Toluol, Xylole, Anisol, Methylnaphthaline), Alkohole (z. B. Ethanol, tert.-Butanol), chlorierte Verbindungen (z. B. Chlorbenzol, Dichlorbenzol) und Mischungen aus diesen Lösungsmitteln dar.
   Einen bevorzugten Konzentrationsbereich für die Monomere stellt das Intervall von 0.005 bis 5 mol/l (Monomer/Lösungsvolumen) dar. Bevorzugt ist dabei der Bereich von 0.01 bis 2 mol/l, ganz besonders bevorzugt der Bereich von 0.01 bis 0.5 mol/l. Die Reaktionstemperatur beträgt in der Regel zwischen -80 und 200°C, bevorzugt zwischen 20 und 140°C
   Als Basen sind beispielsweise Alkalimetallhydroxide (NaOH, KOH), -hydride (NaH, KH) und -alkoholate (NaOEt, KOEt, NaOMe, KOMe, KO^{t}Bu), Metallorganyle (nBuLi, sBuLi, tBuLi, PhLi) und organische Amine (LDA, DBU, DMAP, Pyridin) geeignet. Die Menge liegt bevorzugt im Bereich von 2 bis 10 Äquivalenten (bezogen auf ein Äquivalent Monomer), besonders bevorzugt 3.5 bis 8, ganz besonders bevorzugt 4 bis 6 Äquivalente.
   Die Reaktionszeit beträgt in der Regel zwischen 5 Minuten und 24 Stunden, bevorzugt zwischen 0.5 and 6, ganz besonders bevorzugt zwischen 1 und 4 Stunden.
B) Homer-Polymerisation, durch Umsetzung zweier verschiedener Monomertypen (X¹ = CHO, X² = CH₂PO(OR)₂) in einem geeigneten Lösungsmittel mit einer Base.
C) Wittig-Polymerisation, durch Umsetzung zweier verschiedener Monomertypen (X¹ = CHO, X² = CH₂P(R)₃⁺A⁻) in einem geeigneten Lösungsmittel mit einer Base.
   Die Kondensationsschritte (für die Reaktionen unter B) oder C)) erfolgen durch Einwirkung eines basischen Kondensationsmittels, vorzugsweise einer starken Base, beispielsweise eines Alkoholats, wie Alkalialkoholat, oder Hydrids, wie Natriumhydrid, vorzugsweise von Kalium-tert.-butylat.
   Die Polykondensation wird zweckmäßigerweise so vorgenommen, daß man das Gemisch der Ausgangskomponenten in einem Lösungsmittel vorlegt und unter Inertgasatmosphäre und Rühren vorzugsweise mindestens molare Mengen Kondensationsmittel in Lösung oder Suspension einträgt.
   Nach einer anderen Arbeitsvariante kann das Kondensationsmittel auch allein oder mit dem Bisaldehyd (II, X = CHO) in einem Lösungsmittel vorgelegt and die phosphororganische Verbindung zugegeben werden. Als Lösungsmittel werden vorzugsweise Kohlenwasserstoffe, besonders bevorzugt aromatische Kohlenwasserstoffe, wie Toluol, Anisol oder Xylole, verwendet oder polar aprotische Lösungsmittel, bevorzugt Amide, wie N-Methylpyrrolidon (NMP). Die Reaktionstemperatur beträgt vorzugsweise 60 bis 120°C und die Reaktionszeit 2 bis 20, bevorzugt 3 bis 10 Stunden.
   Durch Zusatz von Wasser, gegebenenfalls einer Säure, wie Essigsäure, und Abtrennung der organischen Reaktionsphasen kann die Aufarbeitung erfolgen. Die erhaltenen Kondensationsprodukte können zur Reinigung extrahiert, z.B. mit Alkoholen oder Essigsäure, oder aus einem Lösungsmittel in einem Nichtlösungsmittel gefällt werden. Allgemein ist dieses Herstellungsverfahren beispielsweise in DD 84 272, Hörhold, H.-H.: Z. Chem. 1972, 12, 41; Hörhold, H.-H.; Bergmann, R.; Gottschaldt, J.; Drefahl, G.: Acta Chim. Acad. Sci. Hung. 81, 239; Hörhold, H.-H.; Bergmann, R.: Advances in the Chemistry of Thermally Stable Polymers, Warszawa, Polish Scientific Publishers 1977, 29-48; Hörhold, H.-H.; Helbig, M.: Makromol. Chem., Macromol. Symp., 1987, 12, 229 und Hörhold, H.-H.; Helbig, M.; Raabe, D.; Opfermann, J.; Scherf, U.; Stockmann, R.; Weiß, D.: Z. Chem 1987, 27, 126 beschrieben.
D) Precursorpolymerisation, durch Erzeugung eines Precursorpolymers ausgehend von einem oder mehreren entsprechenden Monomeren (z. B. X = CH₂S⁺R₂A⁻, CH₂Hal) und anschließende Eliminierung der vorhandenen Precursorreste z. B. durch Temperaturbehandlung (z. B. für CH₂S⁺R₂A⁻) oder Basenbehandlung (z. B. für X = CH₂Hal).
   Dazu werden die Monomere in geeigneten Lösungsmitteln in geeigneten Konzentrationen gelöst, auf die geeignete Reaktionstemperatur gebracht und mit der geeigneten Menge einer geeigneten Base versetzt. Nach Ablauf einer geeigneten Reaktionszeit kann die Reaktionslösung z. B. durch Säurezugabe gequenched werden. Im Anschluß daran reinigt man das Precursorpolymer nach geeigneten, dem Fachmann geläufigen Verfahren, wie z. B. Umfällen oder Extraktion. Dieses Precursorpolymer kann dann entweder in Lösung oder nach Aufbringen auf ein geeignetes Substrat durch eine geeignete Behandlungsmethode in das gewünschte PPV-Derivat überführt werden.
   Geeignete Lösungsmittel stellen bei Precursorpolymerisation über Schwefelsalze beispielsweise Alkohole (z. B. Methanol, Ethanol, tert.-Butanol), Wasser oder Mischungen aus diesen Lösungsmitteln dar. Für Bis(halogenmethyl)monomere sind beispielsweise Ether (z. B. Diethylether, THF, Dioxan, Dioxolan, tert.-Butylmethylether), aromatische Kohlenwasserstoffe (z. B. Toluol, Xylole, Anisol, Methylnaphthaline), Alkohole (z. B. Ethanol, tart.-Butanol) und Mischungen aus diesen geeignet. Einen geeigneten Konzentrationsbereich stellt dabei das Intervall von 0.005 bis 5 mol/l (Monomer/Lösungsvolumen) dar. Bevorzugt ist dabei der Bereich von 0.01 bis 2 mol/l, ganz besonders bevorzugt der Bereich von 0.01 bis 0.5 mol/l.
   Die Reaktionstemperatur für die Synthese des Precursorpolymers beträgt in der Regel zwischen 0 und 200°C, bevorzugt zwischen 20 und 140°C.
   Als Basen sind beispielsweise Alkalimetallhydroxide (NaOH, KOH), -hydride (NaH, KH) und -alkoholate (NaOEt, KOEt, NaOMe, KOMe, KO^{t}Bu), Metallorganyle (nBuLi, sBuLi, tBuLi, PhLi) und organische Amine (LDA, DBU, DMAP, Pyridin) geeignet. Eine geeignete Menge liegt im Bereich von 1 bis 4 Äquivalenten (bezogen auf ein Äquivalent Monomer), bevorzugt 1.5 bis 3, besonders bevorzugt 1.8 bis 2.5 Äquivalente.
   Die Reaktionszeit beträgt in der Regel zwischen 5 Minuten und 24 Stunden, bevorzugt zwischen 0.5 and 6, ganz besonders bevorzugt zwischen 1 und 4 Stunden. Das Precursorpolymer kann dann entweder in Lösung oder auf einem Substrat (z. B. Glas, Quarz, ITO, PET) beispielsweise durch Erhitzen unter einer Gasatmosphäre oder im Vakuum oder durch Behandeln mit Base in das gewünschte PPV-Derivat umgewandelt werden. Für den Temperschritt eignen sich dabei Temperaturen im Bereich von 50 bis 400°C, bevorzugt von 80 bis 300, ganz besonders bevorzugt von 100 bis 250°C. Als Basen kommen die oben genannten Verbindungen bevorzugt in Frage. Die eingesetzte Basenmenge liegt im Bereich von 1 bis 4 Äquivalenten (bezogen auf ein Äquivalent Monomer), bevorzugt 1.5 bis 3, besonders bevorzugt 1.8 bis 2.5 Äquivalente.

Diese Verfahren sind ebenfalls Gegenstand der Erfindung.

Die in Formel (II) angegebenen Biarylderivate können nach dem in Schema 1 skizzierten Weg gewonnen werden:

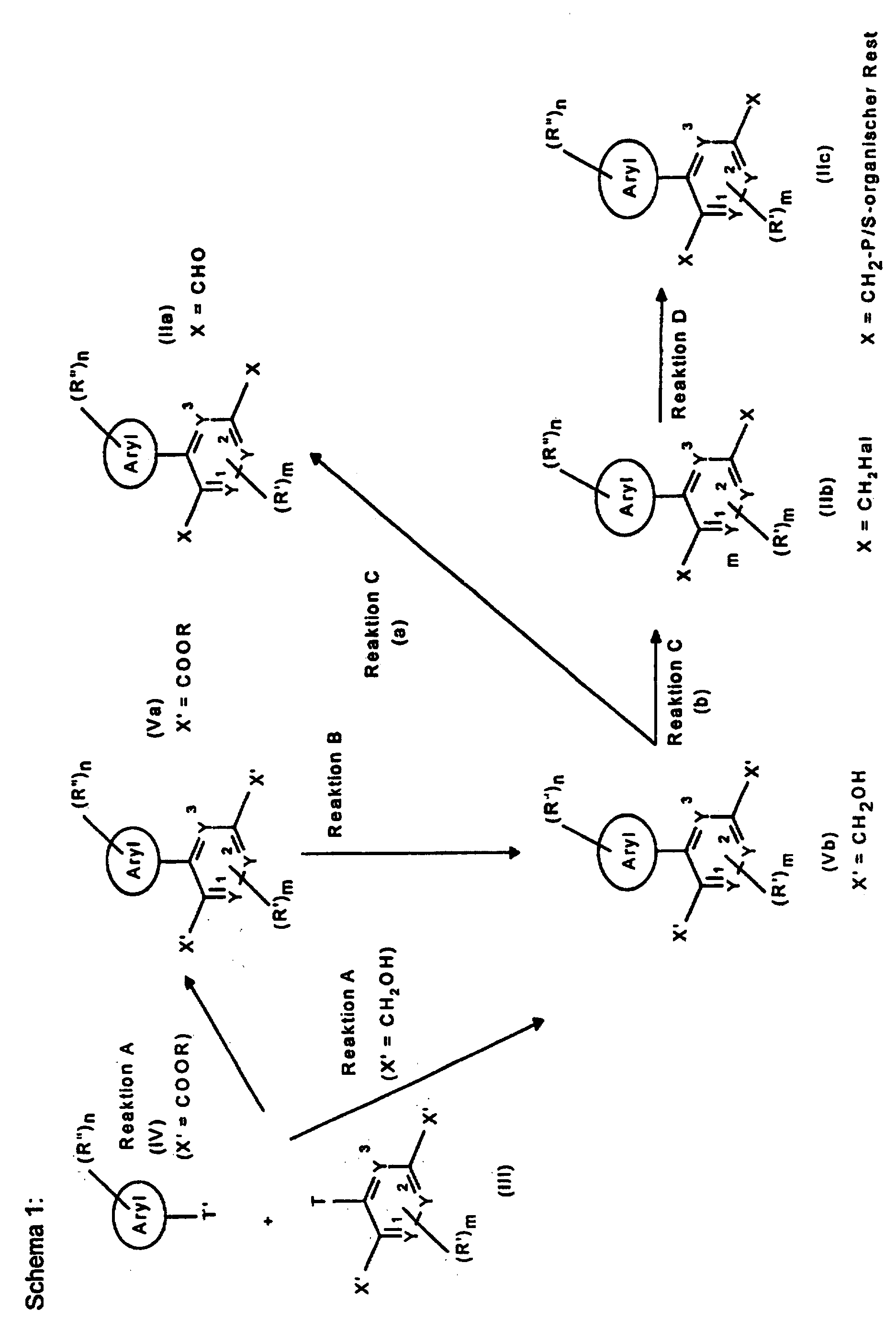

Die Ausgangsverbindungen der Formeln (III) und (IV) sind sehr gut zugänglich, da sie zum Teil kommerziell erhältlich sind, wie Bromterephthalsäure, oder in einfacher Weise und großer Menge aus kommerziell erhältlichen Verbindungen herstellbar sind.

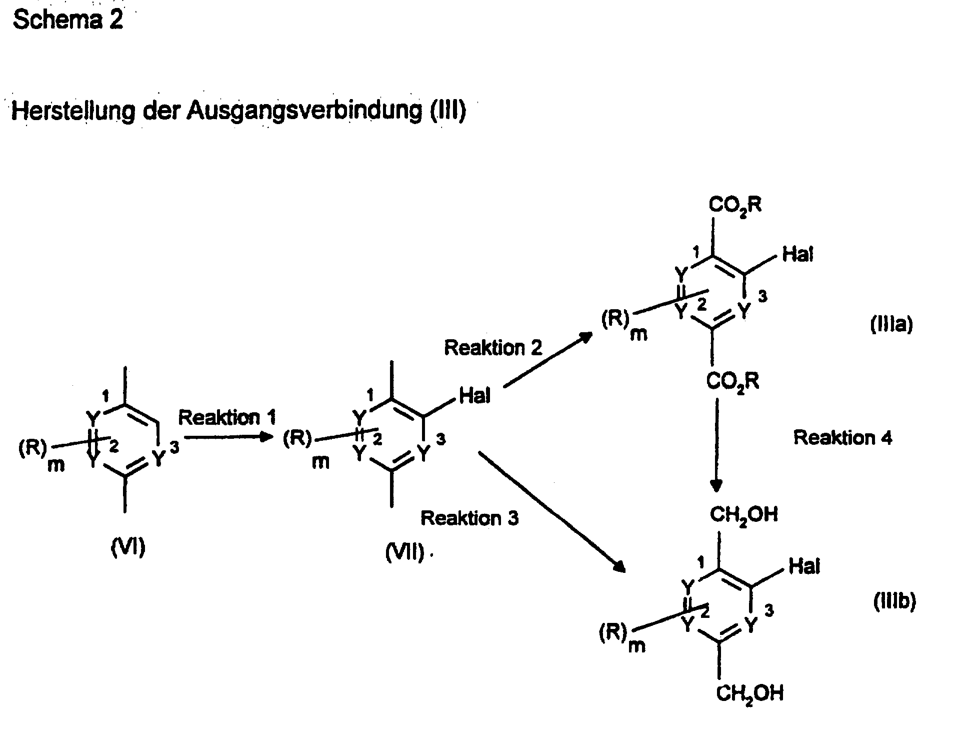

Die Reaktionen in Schema 2 sind wie folgt zu erläutem: 1,4-Dimethyl-Verbindung (VI) ist in der Regel kommerziell erhältlich (z. B. p-Xylol, 2,5-Dimethylphenol, 2,5-Dimethylanilin, 2,5-Dimethylbenzonitril, 2,5-Dimethylpyridin) oder aus kommerziell erhältlichen Verbindungen einfach herzustellen (z. B. Alkylierung eines entsprechenden Phenols oder Amins), Verbindung (VI) kann nach Standardmethoden am Aromaten halogeniert, z.B. chloriert oder bromiert, werden (siehe z.B. Organikum, VEB Deutscher Verlag der Wissenschaften, 15. Auflage, S. 391 ff., Leipzig 1984). Die damit erhaltenen Verbindungen (VII) sind in guten Ausbeuten und industriellen Mengen zugänglich; zum Teil ist die Verbindung (VII) auch kommerziell erhältlich (z. B. 2-Brom-p-xylol).
(VII) kann, vorzugsweise katalytisch (Kobaltkatalysator, Luftsauerstoff, siehe z.B. EP-A 0 121 684) zu den entsprechenden 1,4-Dicarbonsäuren (IIIa) umgesetzt werden. Bei geeigneter Wahl der Reaktionsbedingungen ist dies unabhängig von den Substituenten möglich. Die erhaltenen Säuren, (IIIa) mit R = H, sind gegebenenfalls nach Standardmethoden in entsprechende Ester (R ≠ H) überführbar.

Die auf diese Weise nahezu quantitativ erhaltenen Verbindungen der Formel (IIIa) sind über geläufige Reduktionsreaktionen in die Bisalkohole (IIIb) überführbar. Diese sind auch direkt durch Oxidation (siehe z.B. A. Belli et al., Synthesis 1980, 477) aus den Verbindungen der Formel (VII) erhältlich.

Gegebenenfalls kann das Halogenatom auf einer geeigneten Stufe, wie im folgenden für die Verbindungen der Formel (IVa) beschrieben, gegen eine Boronsäure(ester)- oder Trialkylzinn-Gruppe ausgetauscht werden.

Die Herstellung entsprechender Perfluoralkylsulfonate kann beispielsweise durch Veresterung entsprechender Phenolfunktionen erfolgen.

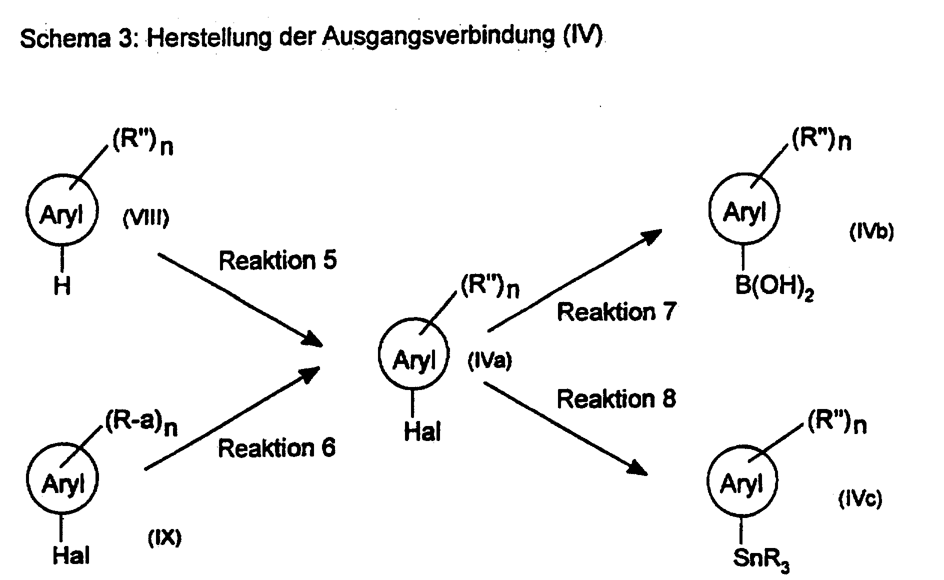

Schema 3 ist wie folgt zu erläutem: Die Verbindungen (VIII) sind in der Regel käuflich zu erwerben (z. B. diverse Alkyl- und Dialkylaromaten, Alkoxyaromaten) oder einfach aus entsprechenden Vorstufen (z. B. Hydrochinon, Brenzcatechin, Naphthol u.ä.) z.B. durch Alkylierung herzustellen. Verbindung (VIII) kann dann durch einfache Halogenierungsreaktionen (Reaktion 5) wie oben beschrieben in Verbindungen der Formel (IVa) umgewandelt werden. Viele Verbindungen der Formel (IX) sind wohlfeile Chemikalien (z. B. Bromphenol, Bromanilin), welche durch Reaktion 6(z. B. Alkylierung von Phenolfunktionen) einfach in Verbindungen der Formel (IVa) überführbar sind. Diese sind nun durch entsprechende Reagentien (z. B. Mg-Späne, n-BuLi, s-BuLi) zu metallieren und dann durch entsprechende weitere Umsetzung, z. B. mit Trialkylzinnchlorid, Borsäuretrialkylester, in die entsprechenden Verbindungen der Formel (IVb) bzw. (IVc) umwandelbar.

Damit wird gezeigt, daß die Ausgangsverbindungen (III) und (IV) in der geforderten Variationsbreite einfach zugänglich sind. Die Ausgangsverbindungen (III) und (IV) werden durch eine Kupplungsreaktion (Reaktion A in Schema 1) zu Zwischenprodukten der Formel (V) umgesetzt.

Dazu werden die Verbindungen der Formeln (III) und (IV) in einem inerten Lösungsmittel bei einer Temperatur im Bereich von 0°C bis 200°C in Gegenwart eines Palladiumkatalysators zur Reaktion gebracht.
Dabei enthält jeweils eine der Verbindungen, vorzugsweise die der Formel (III), eine Halogen- oder Perfluoralkylsulfonat-Gruppe, die andere eine Boronsäure(ester)Gruppe (IVb) oder eine Trialkylzinn-Gruppe (IVc).

Zur Durchführung der angegebenen Reaktion A mit Boronsäure(ester)n der Formel (IVb), Variante Aa, Suzuki-Kupplung, werden die aromatische Borverbindung, die aromatische Halogenverbindung bzw. das Perfluoralkylsulfonat, eine Base und katalytische Mengen des Palladiumkatalysators in Wasser oder in ein oder mehrere inerte organische Lösungsmittel oder vorzugsweise in eine Mischung aus Wasser und einem oder mehreren inerten organischen Lösungsmitteln gegeben und bei einer Temperatur von 0 bis 200°C, bevorzugt bei 30 bis 170°C, besonders bevorzugt bei 50 bis 150°C, insbesonders bevorzugt bei 60 bis 120°C für einen Zeitraum von 1 h bis 100 h, bevorzugt 5 h bis 70 h, besonders bevorzugt 5 h bis 50 h, gerührt. Das Rohprodukt kann nach dem Fachmann bekannten und dem jeweiligen Produkt angemessenen Methoden, z.B. durch Umkristallisation, Destillation, Sublimation, Zonenschmelzen, Schmelzkristallisation oder Chromatographie, aufgereinigt werden.

Für das beschriebene Verfahren geeignete organische Lösungsmittel sind beispielsweise Ether, z. B. Diethylether, Dimethoxyethan, Diethylenglykoldimethylether, Tetrahydrofuran, Dioxan, Dioxolan, Diisopropylether, tert.-Butylmethylether, Kohlenwasserstoffe, z. B. Hexan, iso-Hexan, Heptan, Cyclohexan, Toluol, Xylol, Alkohole, z. B. Methanol, Ethanol,
1-Propanol, 2-Propanol, Ethylenglykol, 1-Butanol, 2-Butanol, tert.-Butanol, Ketone, z. B. Aceton, Ethylmethylketon, iso-Butylmethylketon, Amide, z.B. Dimethylformamid, Dimethylacetamid, N-Methylpyrrolidon, Nitrile, z.B. Acetonitril, Propionitril, Butyronitril, und Mischungen derselben.

Bevorzugte organische Lösungsmittel sind Ether, wie Dimethoxyethan, Diethylenglykoldimethylether, Tetrahydrofuran, Dioxan, Diisopropylether, t-Butylmethylether, Kohlenwasserstoffe, wie Hexan, Heptan, Cyclohexan, Toluol, Xylol, Alkohole, wie Methanol, Ethanol, 1-Propanol, 2-Propanot, 1-Butanol, 2-Butanol, tert.-Butanol, Ethylenglykol, Ketone, wie Ethylmethylketon, iso-Butylmethylketon, Amide, wie Dimethylformamid, Dimethylacetamid, N-Methylpyrrolidon und Mischungen derselben.

Besonders bevorzugte Lösungsmittel sind Ether, z. B. Dimethoxyethan, Tetrahydrofuran, Kohlenwasserstoffe, z. B. Cyclohexan, Toluol, Xylol, Alkohole, z. B. Ethanol, 1-Propanol, 2-Propanol, 1-Butanol, tert.-Butanol und Mischungen derselben.

In einer besonders bevorzugten Variante werden bei dem beschriebenen Verfahren Wasser und ein oder mehrere in Wasser unlösliche Lösungsmittel eingesetzt.
Beispiele sind Mischungen aus Wasser und Toluol sowie Wasser, Toluol und Tetrahydrofuran.

Basen, die bei dem beschriebenen Verfahren vorzugsweise Verwendung finden sind Alkali- und Erdalkalimetallhydroxide, Alkali- und Erdalkalimetallcarbonate, Alkalimetallhydrogencarbonate, Alkali- und Erdalkalimetallacetate, Alkali- und Erdalkalimetallalkoholate, sowie primäre, sekundäre und tertiäre Amine.

Besonders bevorzugt sind Alkali- und Erdalkalimetallhydroxide, Alkali- und Erdalkalimetallcarbonate und Alkalimetallhydrogencarbonate.
Insbesondere bevorzugt sind Alkalimetallhydroxide, wie Natriumhydroxid und Kaliumhydroxid, sowie Alkalimetallcarbonate und Alkalimetallhydrogencarbonate, wie Lithiumcarbonat, Natriumcarbonat und Kaliumcarbonat.

Die Base wird bei dem angebenen Verfahren bevorzugt mit einem Anteil von 100 bis 1000 Mol-%, besonders bevorzugt 100 bis 500 Mol-%, ganz besonders bevorzugt 150 bis 400 Mol-%, insbesondere 180 bis 250 Mol-%, bezogen auf die aromatische Borverbindung, eingesetzt.

Der Palladiumkatalysator enthält Palladiummetall oder eine Palladium (0) oder (II) Verbindung und einen Komplexliganden, vorzugsweise einen Phosphanliganden.

Die beiden Komponenten können eine Verbindung bilden, z.B. das besonders bevorzugte Pd(PPh₃)₄, oder getrennt eingesetzt werden.

Als Palladiumkomponente eignen sich beispielsweise Palladiumverbindungen, wie Palladiumketonate, Palladiumacetylacetonate, Nitrilpalladiumhalogenide, Olefinpalladiumhalogenide, Palladiumhalogenide, Allylpalladiumhalogenide und Palladiumbiscarboxylate, bevorzugt Palladiumketonate, Palladiumacetylacetonate, bis-η²-Olefinpalladiumdihalogenide, Palladium(II)halogenide, η³-Allylpalladiumhalogenid Dimere und Palladiumbiscarboxylate, ganz besonders bevorzugt Bis(dibenzylidenaceton)palladium(0) [Pd(dba)₂)], Pd(dba)₂ CHCl₃, Palladiumbisacetylacetonat, Bis(benzonitril)palladiumdichlorid, PdCl₂, Na₂PdCl₄, Dichlorobis(dimethylsulfoxid)palladium(II), Bis(acetonitril)palladiumdichlorid, Palladium-II-acetat, Palladium-II-propionat, Palladium-II-butanoat und (1c,5c-Cyclooctadien)palladiumdichlorid.

Ebenso als Katalysator dienen kann Palladium in metallischer Form, im folgenden nur Palladium genannt, vorzugsweise Palladium in pulverisierter Form oder auf einem Trägermaterial, z.B. Palladium auf Aktivkohle, Palladium auf Aluminiumoxid, Palladium auf Bariumcarbonat, Palladium auf Bariumsulfat, Palladium auf Aluminiumsilikaten, wie Montmorillonit, Palladium auf SiO₂ und Palladium auf Calciumcarbonat, jeweils mit einem Palladiumgehalt von 0,5 bis 10 Gew.-%. Besonders bevorzugt sind Palladium in pulverisierter Form, Palladium auf Aktivkohle, Palladium auf Barium- undloder Calciumcarbonat und Palladium auf Bariumsulfat, jeweils mit einem Palladiumgehalt von 0,5 bis 10 Gew.-% insbesondere bevorzugt ist Palladium auf Aktivkohle mit einem Palladiumgehalt von 5 oder 10 Gew.-%

Der Palladiumkatalysator wird bei dem erfindungsgemäßen Verfahren mit einem Anteil von 0,01 bis 10 Mol-%, bevorzugt 0,05 bis 5 Mol-%, besonders bevorzugt 0,1 bis 3 Mol-%, insbesondere bevorzugt 0,1 bis 1,5 Mol-%, bezogen auf die aromatische Halogenverbindung oder das Perfluoralkylsulfonat, eingesetzt.

Für das Verfahren geeignete Liganden sind beispielsweise Phosphane, wie Trialkylphosphane, Tricycloalkylphosphane, Triarylphosphane, wobei die drei Substituenten am Phosphor gleich oder verschieden, chiral oder achiral sein können und wobei einer oder mehrere der Liganden die Phosphorgruppen mehrerer Phosphane verknüpfen können und wobei ein Teil dieser Verknüpfung auch ein oder mehrere Metallatome sein können.
Beispiele für im Rahmen des hier beschriebenen Verfahrens verwendbare Phosphane sind Trimethylphosphan, Tributylphosphan, Tricyclohexylphosphan, Triphenylphosphan, Tritolylphosphan, Tris-(4-dimethylaminophenyl)-phosphan, Bis(diphenylphosphano)methan, 1,2-Bis(diphenylphosphano)ethan, 1,3-Bis(diphenylphosphano)propan und 1,1'-Bis(diphenylphosphano)-ferrocen. Weitere geeignete Liganden sind beispielsweise Diketone, z. B. Acetylaceton und Octafluoracetylaceton und tert. Amine, z. B. Trimethylamin, Triethylamin, Tri-n-propylamin und Triisopropylamin.
Bevorzugte Liganden sind Phosphane und Diketone, besonders bevorzugt sind Phosphane.
Ganz besonders bevorzugte Liganden sind Triphenylphosphan, 1,2-Bis(diphenylphosphano)ethan, 1,3-Bis(diphenylphosphano)propan und 1,1'-Bis(diphenylphosphano)-ferrocen, insbesondere Triphenylphosphan.
Für das Verfahren weiterhin geeignet sind wasserlösliche Liganden, die beispielsweise Sulfonsäuresalz- und/oder Sulfonsäurereste und/oder Carbonsäuresalz- und/oder Carbonsäurereste und/oder Phosphonsäuresalz und/oder Phosphonsäurereste und/oder Phosphoniumgruppen und/oder Peralkylammoniumgruppen und/oder Hydroxygruppen und/oder Polyethergruppen mit geeigneter Kettenlänge enthalten.

Bevorzugte Klassen von wasserlöslichen Liganden sind mit den obigen Gruppen substituierte Phosphane, wie Trialkylphosphane, Tricycloalkylphosphane, Triarylphosphane, Dialkylarylphosphane, Alkyldiarylphosphane und Heteroarylphosphane wie Tripyridylphosphan und Trifurylphosphan, wobei die drei Substituenten am Phosphor gleich oder verschieden, chiral oder achiral sein können und wobei einer oder mehrere der Liganden die Phosphorgruppen mehrerer Phosphane verknüpfen können und wobei ein Teil dieser Verknüpfung auch ein oder mehrere Metallatome sein können, Phosphite, Phosphinigsäureester und Phosphonigsäureester, Phosphole, Dibenzophosphole und Phosphoratome enthaltende cyclische bzw. oligo- und polycyclische Verbindungen.

Der Ligand wird bei dem Verfahren mit einem Anteil von 0,1 bis 20 Mol %, bevorzugt 0,2 bis 15 Mol %, besonders bevorzugt 0,5 bis 10 Mol %, insbesonders bevorzugt 1 bis 6 Mol %, bezogen auf die aromatische Halogenverbindung oder das Perfluoralkylsulfonat, eingesetzt. Es können gegebenenfalls auch Mischungen zweier oder mehrerer verschiedener Liganden eingesetzt werden.
Das eingesetzte Boronsäurederivat kann ganz oder teilweise als Anhydrid vorliegen.

Vorteilhafte Ausführungsformen des beschriebenen Verfahrens der Variante Aa sind z.B. in WO 94/101 05, EP-A-0 679 619, EP-A-0 694 530 und PCT/EP96/03154 beschrieben, auf die hiermit ausdrücklich Bezug genommen wird. Sie gelten durch Zitat als Bestandteil der Beschreibung dieser Anmeldung.

Bei der Variante Ab, auch Stille-Kupplung genannt, wird eine aromatische Zinnverbindung, vorzugsweise der Formel (IVc), mit einer aromatischen Halogenverbindung oder einen aromatischen Perfluoralkylsulfonat vorzugsweise der Formel (III), bei einer Temperatur im Bereich von 0°C bis 200°C in einem inerten organischen Lösungsmittel in Gegenwart eines Palladiumkatalysators umgesetzt.

Ein Überblick über diese Reaktion findet sich z.B. bei J.K. Stille, Angew. Chemie Int. Ed. Engl. 1986, 25, 508.

Zur Durchführung des Verfahrens werden bevorzugt die aromatische Zinnverbindung, die aromatische Halogenverbindung bzw. das Perfluoralkylsulfonat, in ein oder mehrere inerte organische Lösungsmittel gegeben und bei einer Temperatur von 0°C bis 200°C, bevorzugt bei 30°C bis 170°C, besonders bevorzugt bei 50°C bis 150°C, insbesondere bevorzugt bei 60°C bis 120°C für einen Zeitraum von 1 h bis 100 h, bevorzugt 5 h bis 70 h, besonders bevorzugt 5 h bis 50 h, gerührt. Nach beendeter Umsetzung wird der als Feststoff anfallende Pd-Katalysator beispielsweise durch Filtration abgetrennt und das Rohprodukt vom Lösungsmittel bzw. den Lösungsmitteln befreit. Anschließend kann nach dem Fachmann bekannten und dem jeweiligen Produkt angemessene Methoden, z.B. durch Umkristallisation, Destillation, Sublimation, Zonenschmelzen, Schmelz-kristallisation oder Chromatographie, weiter aufgereinigt werden.
Für das beschriebene Verfahren geeignete organische Lösungsmittel sind beispielsweise Ether, z.B. Diethylether, Dimethoxyethan, Diethylenglykoldimethylether, Tetrahydrofuran, Dioxan, Dioxolan, Diisopropylether, tart.-Butylmethylether, Kohlenwasserstoff, z.B. Hexan, iso-Hexan, Heptan, Cyclohexan, Benzol, Toluol, Xylol, Alkohole, z.B. Methanol, Ethanol, 1-Propanol, 2-Propanol, Ethylenglykol, 1-Butanol, 2-Butanol, tert.-Butanol, Ketone, z.B. Aceton, Ethyl-methylketon, iso-Butylmethylketon, Amide, z.B. Dimethylformamid (DMF), Dimethylacetamid, N-Methylpyrrolidon, Nitrile, z.B. Acetonitril, Propionitril, Butyronitril und Mischungen derselben.

Bevorzugte organische Lösungsmittel sind Ether, wie Dimethoxyethan, Diethylenglykoldimethylether, Tetrahydrofuran, Dioxan, Diisopropylether, Kohlenwasserstoffe, wie Hexan, Heptan, Cyclohexan, Benzol, Toluol, Xylol, Alkohole, wie Methanol, Ethanol, 1-Propanol, 2-Propanol, 1-Butanol, 2-Butanol, tert.-Butanol, Ethylenglykol, Ketone, wie Ethylmethylketon, oder Amide, wie DMF.

Besonders bevorzugte Lösungsmittel sind Amide, ganz besonders bevorzugt ist DMF.

Der Palladiumkatalysator enthält Palladiummetall oder eine Palladium (0) oder (II) Verbindung und einen Komplexliganden, vorzugsweise einen Phosphanliganden.

Die beiden Komponenten können eine Verbindung bilden, z.B. Pd(PPh₃)₄, oder getrennt eingesetzt werden.

Als Palladiumkomponente eignen sich beispielsweise Palladiumverbindungen, wie Palladiumketonate, Palladiumacetylacetonate, Nitrilpalladiumhalogenide, Olefinpalladiumhalogenide, Palladiumhalogenide, Allylpalladiumhalogenide und Palladiumbiscarboxylate, bevorzugt Palladiumketonate, Palladiumacetylacetonate, bis-η²-Olefinpalladiumdihalogenide, Palladium(II)halogenide, η³-Allylpalladiumhalogenid Dimere und Palladiumbiscarboxylate, ganz besonders bevorzugt Bis(dibenzylidenaceton)palladium(0) [Pd(dba)₂)], Pd(dba)₂ CHCl₃, Palladiumbisacetylacetonat, Bis(benzonitril)palladiumdichlorid, PdCl₂, Na₂PdCl₄, Dichlorobis(dimethylsulfoxid)palladium(II), Bis(acetonitrll)palladiumdichlorid, Palladium-II-acetat, Palladium-II-propionat, Palladium-II-butanoat und (1c,5c-Cyclooctadien)palladiumdichlorid.

Der Palladiumkatalysator wird bei dem beschriebenen Verfahren mit einem Anteil von 0,01 bis 10 Mol-%, bevorzugt 0,05 bis 5 Mol-%, besonders bevorzugt 0,1 bis 3 Mol-%, insbesondere bevorzugt 0,1 bis 1,5 Mol-%, bezogen auf die aromatische Halogenverbindung oder das Perfluoralkylsulfonat, eingesetzt.

Für das beschriebene Verfahren geeignete Liganden sind beispielsweise Phosphane, wie Trialkylphosphane, Tricycloalkylphosphane, Triarylphosphane, wobei die drei Substituenten am Phosphor gleich oder verschieden, chiral oder achiral sein können und wobei einer oder mehrere der Liganden die Phosphorgruppen mehrerer Phosphane verknüpfen können und wobei ein Teil dieser Verknüpfung auch ein oder mehrere Metallatome sein können.

Der Ligand wird bei dem beschriebenen Verfahren mit einem Anteil von 0,1 bis 20 Mol-%, bevorzugt 0,2 bis 15 Mol-%, besonders bevorzugt 0,5 bis 10 Mol-%, insbesonders bevorzugt 1 bis 6 Mol-%, bezogen auf die aromatische Halogenverbindung oder das Perfluoralkylsulfonat, eingesetzt.

### Reaktion B

Falls die Gruppe X' in dem Zwischenprodukt (V) -COOR ist, wird zum Bisalkohol, X' = CH₂OH, reduziert.

Die Reduktion kann nach bekannten, dem Fachmann geläufigen Methoden erfolgen, wie sie beispielsweise in Houben-Weyl, 4. Aufl, Bd. 6, 16, Kap. VIII, Georg-ThiemeVerlag, Stuttgart 1984, beschrieben sind.

Bevorzugte Ausführungsformen sind
a) Umsetzung mit LiAlH₄ oder Diisobutylaluminiumhydrid (DIBAL-H) in Tetrahydrofuran (THF) oder Toluol, wie beispielsweise in Organikum (s.o), S. 612 ff. beschrieben
b) Umsetzung mit Borhydriden, wie BH₃, wie beispielsweise in Houben-Weyl, 4. Aufl, Bd. 6, 16, Kap. VIII, S. 211-219, Georg-Thieme-Verlag, Stuttgart 1984, beschrieben.
c) Umsetzung mit Wasserstoff in Gegenwart eines Katalysators, wie beispielsweise in Houben-Weyl, 4. Aufl, Bd. 6, 16, Kap. VIII, S. 110 f, Georg-Thieme-Verlag, Stuttgart 1984, beschrieben
d) Reaktion mit Natrium oder Natriumhydrid.

Besonders bevorzugt ist die Reduktion mit LiAlH₄ oder DIBAL-H.

### Reaktion C (a)

Die aus den Reaktionen A oder B erhaltenen Bisalkohole der Formel (V) (X = CH₂OH) können durch selektive Oxidation in erfindungsgemäße Bisaldehyde der Formel (II) überführt werden. Eine solche Oxidation kann nach an sich bekannten, dem Fachmann geläufigen Verfahren durchgeführt werden, wie sie beispielsweise in R.C. Larock, Comprehensive Organic Transformations, VCH, 1989, S. 604-614, und der dort zitierten Literatur beschrieben sind.

Bevorzugt sind:
a) die Oxidation mit Dimethylsulfoxid / Oxalylchlorid (Swern-Oxidation), wie sie beispielsweise bei A.J. Mancoso, D. Swern, Synthesis 1981, 165 beschrieben ist, und
b) die Oxidation mit Pyridiniumchlorochromat (PCC) oder Pyridiniumdichromat, wie sie beispielsweise in Houben-Weyl, 4. Auflage, Band E3, S. 291-296, Georg-Thieme Verlag, Stuttgart, 1983 beschrieben ist.

### Reaktion C (b)

Erfindungsgemäß können die OH-Gruppen in den Bisalkoholen der Formel (V) durch nucleophile Substitution gegen Halogen ausgetauscht werden.

Zur Herstellung von Chloriden und Bromiden ist es bevorzugt, den entsprechenden Bisalkohol mit HCl bzw. HBr, beispielsweise in Eisessig, umzusetzen (siehe z.B. Houben-Weyl, Band 5/4, S. 385 ff, 1960) oder mit Thionylchlorid bzw. -bromid, gegebenenfalls in Gegenwart eines Katalysators, zur Reaktion zu bringen (siehe z.B. Houben-Weyl, Band 5/1b, S. 862 ff., 1962).
Chloride lassen sich auch bevorzugt durch Reaktion mit Phosgen (siehe z.B. Houben-Weyl, Band V, 3, S. 952 ff, 1962), Bromide durch Reaktion mit PBr₃ herstellen.

lodide lassen sich vorzugweise durch Reaktion mit Phosphor/lod nach A.I. Vogel (siehe z.B. Houben-Weyl, Band V, 4, s. 615 f., 1969) herstellen.
Die Aufarbeitung erfolgt in allen Fällen in einfacher Weise nach bekannten, dem Fachmann geläufigen Methoden.

### Reaktion D

Die Umwandlung von Halogenverbindungen der Formel (IIb) in Bis(diphenylphosphanoxide) bzw. Bis(phosphonsäureester) der Formel (IIc) ist beispielsweise unter Anwendung der Michaelis-Arbusov-Reaktion aus den entsprechenden Bis(halogenmethyl)-Verbindungen mit Diphenylphosphinigsäureethylester (C₆H₅)P-O-C₂H₅ bzw. mit Triethylphosphit leicht möglich. Bisphosphoniumsalze sind ebenfalls einfach durch Umsetzung der Halogenide mit bspw. Triarylphosphanen erhältlich. Bisthiosalze sind analog dazu durch Umsetzung mit Dialkylsulfiden, beispielsweise Tetrahydrothiophen, zu erhalten.

Aus den derartig zugänglichen Monomeren der Formel (II) lassen sich nun durch die oben angegebenen Polymerisationsvarianten - eventuell unter Zusatz weiterer hier nicht explizit aufgeführter Comonomere - Polymere, weiche Wiederholeinheiten der Formel (I) enthalten, synthetisieren. Diese eignen sich ganz besonders als Elektoluminszenzmaterialien.

Als Elektrolumineszenzmaterialien im Sinne der Erfindung gelten Materialien, die als aktive Schicht in einer Elektrolumineszenzvorrichtung. Verwendung finden können. Aktive Schicht bedeutet, daß die Schicht befähigt ist, bei Anlegen eines elektrischen Feldes Licht abzustrahlen (lichtemittierende Schicht) und/oder daß sie die Injektion und/oder den Transport der positiven und/oder negativen Ladungen verbessert (Ladungsinjektions- oder Ladungstransportschicht).

Gegenstand der Erfindung ist daher auch die Verwendung eines Polymers, enthaltend Wiederholeinheiten der Formel (I), als Elektrolumineszenzmaterial.

Um als Elektrolumineszenzmaterialien Verwendung zu finden, werden die Polymere, enthaltend Struktureinheiten der Formel (I), im allgemeinen nach bekannten, dem Fachmann geläufigen Methoden, wie Eintauchen (Dipping) oder Lackschleudem (Spincoating), in Form eines Films auf ein Substat aufgebracht.

Gegenstand der Erfindung ist somit ebenfalls eine Elektrolumineszenzvorrichtung mit einer oder mehreren aktiven Schichten, wobei mindestens eine dieser aktiven Schichten ein oder mehrere erfindungsgemäße Polymere enthält. Die aktive Schicht kann beispielsweise eine lichtemittierende Schicht und/oder eine Transportschicht und/oder eine Ladungsinjektionsschicht sein.

Der allgemeine Aufbau solcher Elektrolumineszenzvorrichtungen ist beispielsweise in US 4,539,507 und US 5,151,629 beschrieben. Polymere enthaltende Elektrolumineszenzvorrichtungen sind beispielsweise in WO-A 90/13148 oder EP-B-0 443 861 beschrieben.

Sie enthatten üblicherweise eine elektrolumineszierende Schicht zwischen einer Kathode und einer Anode, wobei mindestens eine der Elektroden transparent ist. Zusätzlich können zwischen der elektrolumineszierenden Schicht und der Kathode eine oder mehrere Elektroneninjektions- und/oder Elektronentransportschichten eingebracht sein und/oder zwischen der elektrolumineszierenden Schicht und der Anode eine oder mehrere Lochinjektions- und/oder Lochtransportschichten eingebracht sein. Als Kathode können vorzugsweise Metalle oder metallische Legierungen, z.B. Ca, Mg, Al, In, Mg/Ag dienen. Als Anode können Metalle, z.B. Au, oder andere metallisch leitende Stoffe, wie Oxide, z.B. ITO (Indiumoxid/Zinnoxid) auf einem transparentem Substrat, z.B. aus Glas oder einem transparenten Polymer, dienen.

Im Betrieb wird die Kathode auf negatives Potential gegenüber der Anode gesetzt. Dabei werden Elektronen von der Kathode in die Elektroneninjektionsschicht-/Elektronentransportschicht bzw. direkt in die lichtemittierende Schicht injiziert. Gleichzeitig werden Löcher von der Anode in die Lochinjektionsschicht/ Lochtransportschicht bzw. direkt in die lichtemittierende Schicht injiziert.

Die injizierten Ladungsträger bewegen sich unter dem Einfluß der angelegten Spannung durch die aktiven Schichten aufeinander zu. Dies führt an der Grenzfläche zwischen Ladungstransportschicht und lichtemittierender Schicht bzw. innerhalb der lichtemittierenden Schicht zu Elektronen/Loch-Paaren, die unter Aussendung von Licht rekombinieren.
Die Farbe des emittierten Lichtes kann durch die als lichtemittierende Schicht verwendeten Materialien variiert werden.

Elektrolumineszenzvorrichtungen finden Anwendung z.B. als selbstleuchtende Anzeigeelemente, wie Kontrollampen, alphanumerische Displays, Hinweisschilder, und in optoelektronischen Kopplern.

In der vorliegenden Anmeldung sind verschiedene Dokumente zitiert, beispielsweise um das technische Umfeld der Erfindung zu illustrieren. Auf alle diese Dokumente wird hiermit ausdrücklich Bezug genommen, sie gelten durch Zitat als Bestandteil der vorliegenden Anmeldung.
Auf den Inhalt der deutschen Patentanmeldung 196 51 439.8, deren Priorität die vorliegenden Anmeldung beansprucht, sowie auf die Zusammenfassung der vorliegenden Anmeldung wird hiermit ausdrücklich Bezug genommen, sie gelten durch Zitat als Bestandteil der vorliegenden Anmeldung.

Die Erfindung wird durch die Beispiele näher erläutert, ohne sie dadurch einschränken zu wollen.

### Teil 1: Synthese der Monomere

### A. Synthese von Verbindungen der Formel (III)

### Beispiel A1: Synthese von 2-Bromterephthalsäurediethylester und 2-Brom-1,4-bis(hydroxymethyl)benzol:

### a) Synthese von 2-Brom-p-xylol:

p-Xylol (934,4 g; 8,8 mol) wurde mit Fe-Pulver (16 g) vorgelegt, und ca. 20 ml Brom langsam zugetropft. Der Beginn der Reaktion (Dauer ca. 10 min.) war durch Gasentwicklung beobachtbar. Nachdem die Reaktion begonnen hatte, wurde das restliche Brom (gesamt: 1278,4 g; 8,0 mol) bei RT, mit Wasserbadkühlung, zugetropft (4 h). Es wurde 2 h bei RT nachgerührt. Die leicht braun gefärbte Reaktionslösung wurde abfiltriert und zuerst mit Wasser, dann mit 480 ml gesättigter, wäßriger Na₂SO₃-Lösung ausgerührt, anschließend noch einmal mit verdünnter, wäßriger NaOH und zweimal mit H₂O ausgeschüttelt; die organische Phase (wasserklar) wurde mit MgSO₄ getrocknet, filtriert und durch zweifache Vakuumdestillation (Membranpumpe / Ölbad ca. 100-120 °C / 60 cm Kolonne) gereinigt.
Produkt (Sdp. ca. 85-89°C bei 13 - 9 mbar; Ölbad = 120-155°C): 1234,1 g (83,4 %)
¹H NMR (400 MHZ; CDCl₃): δ [ppm] = 7.33 (dd; 1 H; J₁ = 2, J₂ = 0.7 Hz; H-3), 7.06 (d (br); 1 H; J₁ = 8 Hz; H-6), 6.97, (dd; 1 H; J₁ = 8, J₂ = 2 Hz; H-5), 2.33 und 2.26 (jeweils: s (br); 3 H; Me).

### b) Synthese von 2-Bromterephthalsäure:

In einem 1L-Hastelloy-C22-Autoklaven wurde eine Lösung von Brom-p-xylol (92.5 g, 0.5 mol), Kobaltacetattetrahydrat (0.62 g, 2.5 mmol), Manganacetattetrahydrat (0.61 g, 2.5 mmol), Bromwasserstoff (0.4 g, 5.0 mmol) und Kaliumacetat (0.98 g, 10 mmol) in 350 g Eisessig vorgelegt.

Die Lösung wurde unter Rühren in einer Stickstoffatmosphäre (18 bar) erhitzt. Bei 154°C wurde Pressluft durch die Lösung geleitet (18 bar; Lufteinspeisung ca. 180 Liter pro Stunde). Die Reaktion begann sofort. Die Reaktionstemperatur wurde durch Außenkühlung bei ca. 165°C gehalten. Nach einer Stunde ist die exotherme Reaktion beendet, der Reaktorinhalt wurde erneut mit Stickstoff überlagert und auf 100°C abgekühlt. Die bei dieser Temperatur entnommene Suspension wurde unter Rühren auf 20°C abgekühlt und das Kristallisat abfiltriert.
Nach dreimaligem Waschen mit jeweils 50 ml Eisessig wurde das farblose Produkt bei 50 °C und 65 mbar getrocknet.Produkt: farbloses, mikrokristallines Pulver, 102.2 g (83.7 % d. Th.). Schmelzpunkt 302°C.
¹H NMR (400 MHz; d₆-DMSO): δ [ppm] = 13.7 (br; 2 H; CO₂H), 8.18 (d; 1 H; J₁ = 2 Hz; H-3), 8.02 (dd; 1 H; J₁ = 8, J₂ = 2 Hz; H-5), 7.85 (d; 1 H; J₁ = 8 Hz; H-6).

### c1) Erste Syntheseroute zu 2-Bromterephthalsäurediethylester:

2-Bromterephthalsäure (122.52 g; 0,5 mol) wurde in Ethanol (138 g; 3 mol) und Tetrachlorkohlenstoff (150 ml) suspendiert, 15 ml Schwefelsäure wurden mit einer Pipette zugegeben und die Mischung unter kräftigem Rühren für 5 Tage am Rückfluß gekocht. Die Suspension wandelte sich innerhalb von ca. 24 Stunden in eine klare Lösung um, die Reaktion war aber (DC-Kontrolle) erst nach 5 Tagen beendet. Anschließend wurden die Phasen getrennt und die organische Phase mit H₂O, sowie wäßriger NaHCO₃-Lösung ausgeschüttelt, wobei die überstehende wäßrige Phase leicht alkalisch wurde. Nach nochmaligem Ausschütteln mit H₂O wurde die organische Phase über Na₂SO₄ getrocknet und das Lösungsmittel abgezogen. Das gewünschte Produkt fiel ohne weitere Reinigung als gelbliches, schwach viskoses Öl nahezu sauber an (97- 98 %) an: 118 g (78 %),
d 1,38 kg/dm³. Zur weiteren Reinigung war fraktionierte Vakuumdestillation geeignet. Es wurde 99.9 %iges Produkt (¹H-NMR) bei 1.1 mbar und 142°C erhalten.
¹H NMR (400 MHz; CDCl₃): δ [ppm] = 8.30 (d; 1 H; J₁ = 1.7 Hz; H-3), 8.01 (dd; 1 H; J₁ = 8, J₂ = 1.7 Hz; H-5), 7.79 (d; 1 H; J₁ = 8 Hz; H-6), 4.43, 4.41 (jeweils: q; 2 H; J = 7.1 Hz; O-CH₂), 1.42, 1.41 (jeweils: t; 3 H; J = 7.1 Hz; CH₃).

### c2) Zweite Syntheseroute zu 2-Bromterephthalsäurediethylester:

Bromterephthalsäure (500 g, 2.04 mol) wurde unter Schutegas vorgelegt, bei Raumtemperatur unter Rühren mit SOCl₂ (728 g, 446 ml, 6.12 mol) vermischt und mit 3 Tropfen DMF (N,N-Dimethylformamid) versetzt. Die Mischung war auch nach Ende der 90-minütigen Zugabe breiartig und damit schlecht rührbar. Anschließend wurde auf 60°C Innentemperatur aufgeheizt und bei dieser Temperatur 4 Tage gerührt; danach lag eine klare Lösung vor. Der Ansatz wurde vom überschüssigem Thionylchlorid befreit, indem man 2x je 100 ml Toluol zusetzte und das Thionylchlorid/Toluol-Gemisch bei Normaldruck jeweils abdestillierte (140° Badtem.). Das resultierende flüssige Säurechlorid wurde unter Wasserbadkühlung innerhalb ca. 50 min mit absolutem Ethanol (460 g, 583 ml, 10 mol) versetzt (Temperaturanstieg auf 45°) und über Nacht unter Rückfluß erhitzt. Verunreinigungen wurden abfiltiert und das Lösungsmittel abgezogen. Das honigfarbene, leicht viskose Produkt wurde im Ölpumpenvakuum getrocknet: 612.7 g (+99 % d. Th.); ca. 97%ige Reinheit (¹H-NMR).
NMR: analog zu c1). Weitere Reinigung analog c1.

### c3) Dritte Syntheseroute zu 2-Bromterephthalsäuredieethylester:

Bromterephthalsäure (49 g, 0.2 mol) wurde mit EtOH (184 g, 233 ml, 4.0 mol) unter Schutzgas vorgelegt und dann bei RT unter Rühren mit H₂SO₄ (1 ml) versetzt. Anschließend wurde am Rückfluß (78°C) gekocht. Die anfangs weiße Suspension lag nach 20 Minuten als klare Lösung vor. Das Ethanol wurde abdestilliert, bis die Innentemperatur 110°C erreicht hatte. Anschließend wurde erneut frisches Ethanol (200 ml) zugesetzt und die Prozedur von vorne begonnen. Dieses Verfahren wurde insgesamt fünfmal wiederholt, dann war die Reaktion laut DC beendet. Am Ende der Reaktion wurde restliches Ethanol möglichst vollständig abdestilliert, der Reaktionsansatz mit etwas Ethylacetat versetzt und durch Schütteln zunächst mit wäßriger NaHCO₃-Lösung und schließlich mit H₂O neutral gewaschen. Das organische Lösungsmittel wurde abgezogen und das ölige Produkt an der Ölpumpe getrocknet:
56.6 g (94%), Reinheit (it. ¹H-NMR) ca. 97%. Weitere Reinigung analog c1.
NMR: analog zu c1).

### d) Synthese von 2-Brom-1,4-bishydroxymethylbenzol:

### 1. Stufe:

122.82 g (0.50 mol) Bromterephthalsäure wurden vorgelegt und unter N₂ mit 3 Tropfen DMF versetzt. 110 ml (1.5 mol) SOCl₂ wurden bei Raumtemperatur zuerst langsam und dann schnell zugetropft (Suspension etwas besser rührbar, aber noch immer breiförmig; Dauer : ca. 70 min). Die Suspension wurde vorsichtig erhitzt und bei 55 °C Innentemperatur 7 Std. gerührt. Nach Stehen über Nacht bei Raumtemperatur wurde der Ansatz destillativ von überschüssigem Thionylchlorid befreit. Dazu wurde der Ansatz 2x mit je 50 ml Hexan versetzt und das Thionylchlorid-Hexan-Gemisch bei Normaldruck abdestilliert. Zum Schluß wurde noch für ca. 30 min. ein Vakuum von 100 mbar angelegt.

### 2. Stufe:

23.1 g (0.6 mol) LiAlH₄ wurden unter N₂ mit 500 ml THF abs. versetzt. Zur grauen Suspension wurde bei Raumtemperatur eine Lösung aus der 1. Stufe (ca. 90 ml) in 200 ml THF abs. zugetropft (Dauer: ca. 3 Std.). Der Ansatz wurde nun zum Rückfluß erhitzt und 5.5 Stunden gerührt. Nach Abkühlen auf Raumtemperatur wurde die beige Suspension im Eisbad weiter abgekühlt. 46 g Eiswasser wurden vorsichtig zugetropft (Dauer: ca. 1 Std.). Nach Zugabe von weiteren 50 ml H₂O wurden 100 ml 1 N wäßrige H₂SO₄ und dann 90 ml ½ konzentrierter wäßriger H₂SO₄ zugetropft. Man erhielt 2 Phasen: obere: gelb, homogen; untere: graue Suspension. Die Phasen wurden getrennt und die untere, graue Phase wurde 2x mit je 200 ml Ethylacetat extrahiert. Die vereinigten organischen Phasen wurden 4x mit je 200 ml H₂O extrahiert und schließlich zur Trockene eingeengt. Man erhielt das Rohprodukt als beigen Feststoff (110 g), der durch Umkristallisation (H₂O/Ethanol = 2/1) weiter zu reinigen war. Produkt: farblose Nadeln (78 g; 72%), Schmelzpunkt: 106-108°C.
¹H NMR (400 MHz; d₆-Aceton): δ [ppm] = 7.55 (m; 2 H; H-3, H-6), 7.35 (dd; 1 H; J₁ = 8, J₂ = 1.9 Hz; H-5), 4.66, 4.62 (jeweils: d; 2 H; J = 5.9 Hz; CH₂-O), 4.37, 4.28 (jeweils: t; 1 H; J = 5.9 Hz; OH).

### Beispiel A2: Synthese von 2-Brom-5-methoxyterephthalsäurediethylester:

### a) Synthese von 4-Brom-2,5-dimethylanisol

Zu einer vorgelegten Mischung aus 2,5-Dimethylanisol (250 g, 1835 mmol) und Fe-Pulver (3.25 g) wurde unter Rühren tropfenweise Brom (291.5 g, 1835 mmol) zugesetzt. Der Beginn der Reaktion war durch Gasentwicklung sichtbar. Danach tropfte man das restliche Brom bei Raumtemperatur unter Wasserbadkühlung innerhalb 30-40 Minuten zu. Die Reaktionsmischung wurde ca. 4 Stunden weitergerührt. Anschließend wurde vom Fe-Pulver abgetrennt, wenig Chloroform zugesetzt und mit Wasser ausgeschüttelt, was zu einer Aufhellung der Lösung führte. Nach Schütteln mit 50 ml gesättigter wäßriger Na₂SO₃-Lösung war die Lösung vollends entfärbt. Man schüttelte noch einmal mit verdünnter wäßriger NaOH und zweimal mit H₂O und zog nach Trocknung das Lösemittel ab.
Das Rohprodukt wurde im Vakuum fraktioniert destilliert.
Das Produkt erhielt man als viskoses, farbloses Öl (Siedepunkt 68°C, 0.8 mbar): 285 g (72%)
¹H NMR (CDCl₃): δ [ppm] = 7.25 (s, 1 H, H-Aryl), 6.68 (s, 1 H, H-Aryl), 3.78 (s, 3 H, O-Me), 2.36, 2.14 (jeweils s, 3 + 3 H, CH₃).

### b) Synthese von 2-Brom-5-methoxyterephthalsäure

In einem 1-l-Autoklav (HC-22) mit Scheibenrührer, Rückflußkühler, Gaseinleitung und Gasauslaß wurde eine Lösung von Kobaltacetattetrahydrat (1.25 g, 5 mmol), Manganacetat-tetrahydrat (1.23 g), HBr (0.81 g), Natriumacetat (1.37 g) und 4-Brom-2,5-dimethylanisol (107.5 g, 0.5 mol) in 380 g Eisessig vorgelegt.
Die Reaktionslösung wurde unter Stickstoffatmosphäre (17 bar) unter Rühren auf 150°C erhitzt. Bei dieser Temperatur wurde Luft (17 bar) durch die Lösung geleitet (180-200 l/h), worauf die exotherme Reaktion sofort ansprang. Die Reaktionstemperatur blieb durch Außenkühlung bei 150°C. Nach ca. 45 Minuten war die exotherme Reaktion beendet. Zur Ermöglichung einer Nachreaktion wurde bei 150°C für 30 min. ein Luft/Stickstoff-Gemisch (10% O₂) durchgeleitet. Danach wurde die Luftzufuhr abgebrochen und Stickstoff eingeleitet.
Der Reaktorinhalt wurde unter Stickstoffatmosphäre auf 100°C abgekühlt, als Lösung in einen Kolben abgelassen und unter Rühren auf 20°C abgekühlt, wobei das Produkt auskristallisierte. Der farblose Kristallbrei wurde abgesaugt und viermal mit jeweils 40 g Eisessig gewaschen.
Nach Trocknung erhielt man 96.2 g 2-Brom-5-methoxyterephthalsäure (70%).
¹H NMR (DMSO): δ [ppm] = 13.5 (br, 2 H, COOH), 7.87 (s. 1 H, H-Aryl), 7.42 (s, 1 H, H-Aryl). 3.88 (s, 3 H, O-Me).

### c) Synthese von 2-Brom-5-methoxyterephthalsäurediethylester

2-Brom-5-methoxyterephthalsäure (202.89 g, 738 mmol) wurde mit 500 ml EtOH unter Schutzgas vorgelegt und dann bei RT unter Rühren mit H₂SO₄ versetzt. Anschließend kochte man bei 78°C Innentemperatur am Rückfluß und destillierte EtOH ab, bis die Innentemperatur über 100 °C lag. Es wurde zunächst emeut Ethanol zugeführt, dieses dann wieder abdestilliert. Der Vorgang wurde solange wiederholt, bis laut DC nur noch der Diester vorhanden war. Schließlich wurde alles Ethanol abgezogen, das erhaltene Rohprodukt in Ethylacetat aufgenommen, mit wäßriger NaHCO₃-Lösung extrahiert und schließlich nach Phasentrennung und Trocknung emeut alles Lösungsmittel abgezogen. Der dabei erhaltene erstarrte Feststoff konnte, nach Zerkleinern, durch Rühren mit Hexan gereinigt werden.
Man erhielt 190.4 g (78%) hellgelbe Kristalle.
Schmelzpunkt: 61-63 °C
¹H NMR (CDCl₃): δ [ppm] = 8.00 (s, 1 H, H-Aryl), 7.34 (s, 1 H, H-Aryl), 4.43+4.37 (jeweils q, 2 + 2 H, OCH₂, J = 7.5 Hz), 3.92 (s, 3 H, O-Me), 1.42 + 1.38 (jeweils t, 3 + 3 H, CH₃, J = 7.5 Hz).

### B. Synthese von Verbindungen der Formel (IV)

### Beispiel B1: Synthese von 4-Hexyloxybenzolboronsäure:

### a) Synthese von 4-Hexytoxybrombenzol:

4-Bromphenol (173 g, 1 mol) wurde in ca. 500 ml frisch dest. THF unter Schutzgas gelöst und nach Durchleiten von Argon portionsweise mit NaH (33 g, (80%ig in Öl), 1.1 mol) versetzt. Dabei wurde die klare Lösung bei 20° Temperaturerhöhung trübgrau. Die Suspension wurde unter Schutzgasüberlagerung bei RT ca. 1 Stunde, gerührt. Hexylbromid (181 g; 149 ml; 1,1 mol) wurde im Tropftrichter kurz mit N₂ begast und unter Rühren innerhalb 25 Minuten zugegeben. Die immer noch graue Mischung wurde bei 75°C am Rückfluß gekocht. Nach 3 Tagen (die Suspension war mittlerweile heller) wurde das entstandene Salz abgesaugt und das Filtrat zur Vernichtung eventueller Reste von NaH mit 20 ml EtOH (keine Gasentwicklung) versetzt. Die gelbliche Lösung wurde eingeengt und aus der Lösung (trüb) das Produkt mittels fraktionierter Vakuumdestillation isoliert: Produkt: 95°C/1 mbar; 172.5 g (67 %); (d ∼ 1.17).
¹H NMR (400 MHz; CDCl₃): δ [ppm] = 7.35, 6.76 (AA'BB'; 4 H; H-aryl), 3.91 (t; 2 H; J = 7.5 Hz; O-CH₂), 1.77 (pseudo-quin; 2 H; J = 7.3 Hz; O-CH₂-CH₂), 1.45-1.25 (m; 6 H; H-alkyl), 0.91 (pseudo-t; 3 H; J = 7.7 Hz; CH₃).

### b) Synthese von 4-Hexyloxybenzolboronsäure:

Magnesiumspäne (1.89 g; 78 mmol) wurden in einer ausgeheizten, unter Argon stehenden Apparatur mit einem Kristall lod versetzt und mit getrocknetem THF überdeckt. Anschließend tropfte man in die ruhende Lösung einige Tropfen 4-Hexyloxybrombenzol zu. Die Grignardreaktion begann sehr schnell, anschließend tropfte man unter Rühren das 4-Hexyloxybrombenzol (Gesamtmenge: 20 g; 78 mmol) so zu, daß der Ansatz leicht siedete und verdünnte in der Zwischenzeit mit etwas THF (insgesamt ca. 100 ml). Es wurde für 3 Stunden am Rückfluß gekocht (nur noch wenige Magnesiumflitter in der Lösung), anschließend ließ man abkühlen. Die Grignardlösung wurde im Schutzgasgegenstrom in einen 250 ml Tropftrichter überführt und unter Rühren bei -70°C in eine Lösung von Borsäuretrimethylester (8.9 g; 9.6 ml; 86 mmol) in 50 ml trockenem THF getropft, wobei sich ein Niederschlag bildete. Man ließ über Nacht auf RT erwärmen und trug die Reaktionsmischung unter Rühren in eine Mischung aus 100 g Eis und 3 ml konz. Schwefelsäure ein. Die organische Phase wurde abgetrennt und die wäßrige Phase 3x mit je 100 ml Chloroform extrahiert, die vereinigten organischen Phasen wurden eingeengt. Das Rohprodukt wurde anschließend aus Hexan umkristallisiert.
Produkt: farbloser, wachsartiger Feststoff (11.28 g; 66 %); Schmelzpunkt: 84-87°C.
¹H NMR (400 MHz; CDCl₃): δ [ppm] = 8.15, 7.00 (AA'BB'; 4 H; H-aryl), 4.07 (t; 2 H; J = 7.7 Hz; O-CH₂), 1.83 (pseudo-quin; 2 H; J = 7.5 Hz; O-CH₂-CH₂), 1.55-1.32 (m; 6 H; H-alkyl), 0.93 (pseudo-t; 3 H; J = 7.7 Hz; CH₃). Enthielt variable Anteile an Anhydriden.

### Beispiel B2: Synthese von 3-(3,7-Dimethyloctyloxy)benzolboronsäure:

### a) Synthese von 3-(3,7-Dimethyloctyloxy)brombenzol:

450 ml Ethanol wurden vorgelegt und mit Nal (10.5 g; 70 mmol) und KOH (67.3 g; 1,2 mol) versetzt. Man beobachtete einen Temperaturanstieg nach KOH-Zugabe von 25 auf 40 °C. Nach Abkühlen auf Raumtemperatur wurde 3-Bromphenol (176.5 g; 1 mol) zugegeben. Die weiße Suspension wurde dabei beige. 3,7-Dimethyloctylchlorid (186.32 g; 212.94 ml; 1,05 mol) wurde über einen Tropftrichter innerhalb 3 min. zugegeben. Es wurde 2 Stunden bei RT nachgerührt und anschließend für 96 Stunden bei 80°C Innentemperatur gerührt. Ethanol wurde abdestilliert. Der Rückstand wurde in Ethylacetat aufgenommen und der Niederschlag wurde durch Filtration separiert. Die organische Phase wurde mit 10 gew.-%iger wäßriger NaOH-Lösung dreimal extrahiert, einmal mit H₂O gewaschen, dreimal mit H₂O, das mit CO₂ angesäuert wurde, und nochmals mit H₂O gewaschen. Nach Trocknung mit MgSO₄ wurde erneut am Rotationsverdampfer das Lösungsmittel abgezogen und das Rohprodukt durch fraktionierte Vakuumdestillation gereinigt.
Produkt: hochsiedendes farbloses Öl; 180°C bei 2-3 mbar; 262,3 g (84%)
¹H NMR (400 MHz; CDCl₃): δ [ppm] = 7.12 (pseudo-t; 1 H; J = 8 Hz; H-5), 7.05 (m; 2 H; H-2, H-6), 6.81 (ddd; 1 H; J₁ = 8, J₂ = 2, J₃ = 0.7 Hz; H-4), 3.97 (m; 2 H; O-CH₂), 1.81 (m; 1 H; O-CH₂-CH₂-CH), 1.70-1.50 (m; 3 H; H-alkyl), 1.35-1.13 (m; 6 H; H-alkyl), 0.93 (d; 3 H; J = 7.7 Hz; CH₃), 0.87 (d; 6H; J = 7.7 Hz; CH₃).

### b) Synthese von 3-(3,7-Dimethyloctyloxy)benzolboronsäure:

Mg-Späne (24.7 g, 1.02 mol) wurden vorgelegt und die Apparatur unter Argon ausgeheizt. Bei Raumtemperatur wurden ca. 100 ml THF über den Tropftricher eingefüllt, sowie einige Kristalle lod zugegeben. Anschließend tropfte man in die ruhende Lösung einige ml 3-(3,7-Dimethyloctyloxy)-brombenzol und erhitzte mit einem Heißluftgebläse an der Eintropfstelle. Nachdem die Reaktion gestartet war, ließ man unter Rühren das restliche 3-(3,7-Dimethyloctyloxy)-brombenzol (gesamt: 313 g, 1 mol, 280 ml) kontinuierlich zutropfen (70 min). Gleichzeitig wurden weitere 1100 ml THF zugegeben. Der Reaktionsansatz wurde für weitere zwei Stunden am Rückfluß gerührt.
Das erhaltene, auf Raumtemperatur abgekühlte Grignard-Reagenz wurde unter Schutzgas und schnellem Rühren so zu einer auf -70°C gekühlten Mischung aus 800 ml THF sowie 123 ml Trimethylborat (114 g, 1.10 mol) getropft, daß die Innentemperatur -60°C nicht überschritt (Dauer: 3 h). Es bildete sich eine helle Suspension.
Die Reaktionsmischung wurde in 1200 g Eiswasser/40 ml konz. H₂SO₄ eingerührt.
Die klaren Phasen wurden getrennt und die Wasserphase mit Ethylacetat ausgeschüttelt. Die vereinigten organischen Phasen wurden mit Wasser gerührt und nach Trocknen eingeengt.
Zur weiteren Reinigung wurde der so erhaltene farblose Feststoff mit ca. 500 ml Hexan (welches mit 2 ml konz. wäßriger HCl versetzt wurden) gerührt.
Man erhielt 239 g (86%) farbloses Kristallpulver.
Schmelzpunkt: 83-89°C.
¹H NMR (400 MHz; CDCl₃): δ [ppm] = 7.81 (td; 1 H; J₁ = 8, J₂ = 1.3 Hz; H-4), 7.73 (dd; 1 H; J₁ = 2, J₂ = 1.1 Hz; H-2), 7.43 (t; 1 H; J = 8 Hz; H-5), 7.13 (ddd; 1 H; J₁ = 8, J₂ = 2, J₃ = 1.1 Hz; H-6), 4.11 (m; 2 H; O-CH₂), 1.90 (m; 1 H; O-CH₂-CH₂-C*H*), 1.75-1.50 (m; 3 H; H-alkyl), 1.44-1.14 (m; 6 H; H-alkyl), 1.00 (d; 3 H; J = 7.9 Hz; CH₃), 0.88 (d; 6 H; J = 7.8 Hz; CH₃). Enthält variable Anteile an Anhydriden.

### Beispiel B3: Synthese von 2,5-Dimethylbenzolboronsäure:

In eine ausgeheizte, Argon geflutete Apparatur werden Magnesiumspäne (13,3 g; 0,55 mol) eingefüllt, mit ca. 30 ml THF überlagert und einigen Kristallen lod versetzt. Anschließend tropfte man in die ruhende Lösung einige Tropfen Brom-p-xylol (vgl. Beispiel A1 a)) zu. Die Grignardreaktion begann sehr schnell, anschließend tropfte man unter Rühren das restliche Brom-p-xylol (Gesamtmenge: 92.5 g; ca. 70 ml; 0.5 mol) weiter zu. Es wurde für 4 Stunden am Rückfluß gekocht, danach abgekühlt. Die Grignardlösung wurde dann im Schutzgasgegenstrom in einen 500 ml Tropftrichter überführt und unter Rühren bei -70°C in eine Lösung von Borsäuretrimethylester (62.4 g; 67 ml; 0.6 mol) in 350 ml THF getropft (Dauer ca. 1 h). Dabei fiel ein Niederschlag aus. Man ließ über Nacht auf RT erwärmen und trug die Reaktionsmischung unter Rühren in eine Mischung aus 700 g Eis und 20 ml konz. Schwefelsäure ein. Die organische Phase wurde abgetrennt, die wäßrige Phase dreimal mit Chloroform extrahiert und die vereinigten organischen Phasen eingeengt. Das Rohprodukt wurde aus Chloroform/Hexan umkristallisiert.
Man erhielt ein farbloses mikrokristallines Pulver: 47.71 g (64 %).
¹H NMR (400 MHz; CDCl₃): δ [ppm] = 8.00 (d; 1 H; J = 1.4 Hz; H-6), 7.26 (dd; 1 H; J₁ = 8.0, J₂ = 1.4 Hz; H-4), 7.17 (d; 1 H; J = 8 Hz; H-3), 2.76, 2.38 (jeweils: s; 3 H; CH₃). Enthielt variable Anteile an Anhydriden.

### Beispiel B4: Synthese von 4-(3,7-Dimethyloctyloxy)benzolboronsäure:

a) Synthese von 4-(3,7-Dimethyloctyloxy)-brombenzol
   Durchführung analog zu Beispiel B2, a).
   Ausbeute: 85%
   Siedepunkt: 180°C bei 2 mbar
   ¹H NMR (CDCl₃): δ [ppm] = 7.36, 6.77 (AA'BB', 4 H, H-Aryl), 3.95 (m, 2 H, O-CH₂), 1.82 (m, 1 H, H-3'), 1.6 (m, 3 H, H-2', H-7'), 1.24 (m, 6 H, H-4', H-5', H-6'), 0.94 (d, 3 H, Me, J = 7 Hz), 0.87 (d, 6 H, Me, J = 7 Hz).
b) Synthese von 4-(3,7-Dimethyloctyloxy)benzolboronsäure
   Durchführung analog zu Beispiel B2, b).
   Ausbeute: 83%
   Schmelzpunkt: 57-63°C.
   ¹H NMR (CDCl₃): δ [ppm] = 7.67, 6.92 (AA'BB', 4 H, H-Aryl), 4.6 (br, 2 H, B(OH)₂), 4.03 (m, 2 H, O-CH₂), 1.87 (m, 1 H, H-3'), 1.65 (m, 3 H, H-2', H-7'), 1.27 (m, 6 H, H-4', H-5', H-6'), 0.95 (d, 3 H, Me, J = 7 Hz), 0.87 (d, 6 H, Me, J = 7 Hz). Enthält variable Anteile von Anhydriden.

### Beispiel B5: Synthese von 3,4-Bis(2-methylpropyloxy)benzolboronsäure

a) Synthese von 1,2-Bis(2-methylpropyloxy)benzol:
   Brenzkatechin (220.22 g, 2 mol) und Nal (10.49. g, 0.14. mol) wurden in 900 ml Ethanol vorgelegt und zum Rückfluß erhitzt. Anschließend wurden in ca. 300 ml Ethanol gelöstes KOH (56.11 g, 1 mol) und gleichzeitig 1-Brom-2-methylpropan (137.03 g, 1 mol, 108.75 ml) langsam zugetropft. Es wurde über Nacht weiter am Rückfluß gekocht. Am nächsten Tag wurden erneut dieselbe Menge KOH und Alkylbromid zugegeben. Insgesamt wurde dieser Vorgang siebenmal wiederholt.
   Nach Abkühlen der Reaktionsmischung wurde vom Feststoff abdekantiert. Der Filterkuchen wurde mit Ethanol nachgewaschen. Die organische Phase wurde eingeengt. Der Filterkuchen wurde in 1l warmen Wasser aufgelöst und mit der mit Ethylacetat verdünnten organischen Phase versetzt. Nach Phasentrennung wurde wiederholt mit 10 %iger wäßriger NaOH gerührt, mit Wasser ausgewaschen und über Na₂SO₄ getrocknet. Das nach Abziehen des Lösungsmittels erhaltene Rohprodukt wurde im Vakuum fraktioniert destilliert.
   Man erhielt das Produkt als farbloses Öl (Siedepunkt: 82°C bei 0.18 mbar): 333.4 g (75%).
   ¹H NMR (CDCl₃): δ [ppm] = 6.87 (ps-s, 4 H, H-Aryl), 3.75 (d, 4 H, O-CH₂, J = 8 Hz), 2.13 (ps-non, 2 H, C-H, J = 8 Hz), 1.05 (d, 12 H, CH₃, J = 8 Hz).
b) Synthese von 3,4-Bis(2-methylpropyloxy)brombenzol:
   1,2-Bis(-2-methylpropyloxy)benzol (359.61 g, 1.62 mol) wurde mit 500 ml CH₂Cl₂ vorgelegt und mit wenig Eisenpulver versetzt. Nun tropfte man unter Kühlung langsam Brom (266.88 g, 1.78 mol) (vermischt mit ca. 200 ml CH₂Cl₂) zu. Der Ansatz wurde für ca. 20 h bei Raumtemperatur gerührt. Zur Aufarbeitung wurde der Ansatz mit wäßriger Na₂SO₃ Lösung ausgerührt und anschließend das Eisenpulver abfiltriert. Die organische Phase wurde dann noch 2x mit NaHCO₃ Lösung ausgeschüttelt und anschließend mit Wasser neutral gewaschen. Nach Trocknung wurde die organische Phase eingeengt.
   Durch doppelte fraktionierte Destillation erhielt man das gewünschte Produkt als farblosen Feststoff (166.9 g, 34%).
   Schmelzpunkt: 47°C
   ¹H NMR(CDCl₃): δ [ppm] = 6.98 (m, 2 H, H-2, H-6), 6.73 (m, 1 H, H-5), 3.72, 3.70(2 x d, 2 x 2 H, O-CH₂, J = 8 Hz), 2.12 (m, 2 H, CH), 1.04 (m, 12 H, CH₃).
c) Synthese von 3,4-Bis(2-methylpropyloxy)benzolboronsäure:
   Durchführung analog zu Beispiel B2, b).
   Ausbeute: 76%
   Schmelzpunkt: 146°C.
   ¹H NMR (CDCl₃): δ [ppm] = 7.81 (dd, 1 H, H-6, J₁ = 8 Hz, J₂ = 1.8 Hz), 7.68 (d, 1 H, H-2, J = 1.8 Hz), 6.99 (d, 1 H, H-5, J = 8 Hz), 3.89, 3.84 (2 x d, 2 x 2 H, O-CH₂, J = 8 Hz), 2.13 (m, 2 H, CH), 1.07 (m, 12 H, CH₃). Enthält variable Anteile von Anhydriden.

### Beispiel B6: Synthese von 4'-(3,7-Dimethyloctyloxy)-biphenyl-4-boronsäure

a) Synthese von 4-(3,7-Dimethyloctyloxy)-4'-brombiphenyl:
   Durchführung analog zu Beispiel B2, a).
   Aufarbeitung durch Umkristallisation aus Ethanol.
   Farblose Kristalle, 85% Ausbeute.
   Schmelzpunkt: 104°C
   ¹H NMR (CDCl₃): δ [ppm] = 7.53, 7.40 (AA'BB', 4 H, H-Aryl), 7.47, 6.96 (AA'BB', 4 H, H-Aryl), 4.03 (m, 2 H, O-CH₂), 1.83 (m, 1 H, H-3'), 1.62 (m, 3 H, H-2', H-7'), 1.3 (m, 6 H, H-4', H-5', H-6'), 0.96 (d, 3 H, Me, J = 7.5 Hz), 0.87 (d, 6 H, Me, J = 7.5 Hz).
b) Synthese von 4'-(3,7-Dimethyloctyloxy)-biphenyl-4-boronsäure:
   Durchführung analog zu Beispiei B2, b).
   Ausbeute: 78%
   Schmelzpunkt: 116°C
   ¹H NMR (DMSO-d₆): δ [ppm] = 8.02 (br, 2 H, B(OH)₂), 7.83, 7.58 (AA'BB', 4 H, H-Aryl), 7.61, 7.01 (AA'BB', 4 H, H-Aryl), 4.04 (m, 2 H, O-CH₂), 1.77 (m, 1 H, H-3'), 1.58 (m, 3 H, H-2', H-7'), 1.25 (m, 6 H, H-4', H-5', H-6'), 0.92 (d, 3 H, Me, J = 7.5 Hz), 0.86 (d, 6 H, Me, J = 7.5 Hz).

### C. Kupplungsreaktionen gemäß Reaktion A

### Beispiel C1: Synthese von 2-(4'-Hexyloxyphenyl)terephthalsäurediethylester:

Bromterephthalsäurediethylester (30.1 g, 100 mmol), K₂CO₃ (27.6 g, 200 mmol) und 140 ml Toluol und 140 ml H₂O wurden vorgelegt und 30 Minuten mit Argon gespült. Anschließend wurde 4-Hexyloxyphenylboronsäure (26.7 g, 120 mmol) (vgl. **B1**), sowie Pd(PPh₃)₄ (1.16 g, 1 mmol) unter Schutzgas zugegeben. Das gelb-grünliche, trübe Gemisch wurde unter Schutzgasüberlagerung bei 85° C Innentemperatur kräftig gerührt. Nach 7 Stunden war die Reaktion beendet. Nach Phasentrennung wurde die organische Phase mit verdünnter HCl / H₂O ausgeschüttelt (neutral). Die wäßrige Phase schüttelte man mit Toluol aus und vereinigt die organischen Phasen. Nach Abfiltrieren von eventuellen Palladium-Resten wurde eingeengt. Man erhielt das Produkt als gelb-braunes Öl in ausreichender Reinheit (ca. 85%): 44.7 g (112%).
¹H NMR (400 MHz; CDCl₃): δ [ppm] = 8.03 (dd; 1 H; J₁ = 2, J₂ = 1 Hz; H-3), 8.02 (dd; 1 H; J₁ = 8, J₂ = 2 Hz; H-5), 7.79 (dd; 1 H; J₁ = 8, J₂ = 1 Hz; H-6), 7.25, 6.93 (AA'BB'; 4 H; H-phenyl), 4.40, 4.14 (jeweils: q; 2 H; J = 8 Hz; CO₂-CH₂), 3.99 (t; 2 H; J = 7.5 Hz; O-CH₂), 1.81 (m; 2 H; O-CH₂-CH₂), 1.53-1.33 (m; 6 H; H-alkyl), 1.40, 1.07 (jeweils: t; 3 H; J = 8 Hz; CO₂-CH₂-CH₃), 0.91 (m; 3 H; CH₃).

### Beispiel C2: Synthese von 2-(3'-(3,7-Dimethyloctyloxy)phenyl)terephthalsäuredimethylester:

Bromterephthalsäuredimethylester (49.7 g, 182 mmol, von TransWorld, Rockville MD, USA, bezogen bzw. analog Beispiel A1 c) hergestellt), K₂CO₃ (50.3 g, 364 mmol) und 170 ml Toluol und 170 ml H₂O wurden vorgelegt und 30 Minuten mit Argon gespült. Anschließend wurde 3-(3,7-Dimethyloctyloxy)boronsäure (55.7 g, 200 mmol) (vgl. B2), sowie Pd(PPh₃)₄ (0.93 g, 0.8 mmol) unter Schutzgas zugegeben. Das gelb-grünliche, trübe Gemisch wurde unter Schutzgasüberlagerung bei 85° C Innentemperatur kräftig gerührt. Nach 24 Stunden war die Reaktion beendet. Nach Phasentrennung wurde die organische Phase mit verdünnter HCl / H₂O ausgeschüttelt (neutral). Die wäßrige Phase schüttelte man mit Ethylacetat aus und vereinigte die organischen Phasen. Diese wurden eingeengt und bei 2 mbar getrocknet. Man erhielt das Produkt als gelbes Öl in ausreichender Reinheit (größer 95%): 76.1 g (98%).
¹H NMR (400 MHz; CDCl₃): δ [ppm] = 8.07(d; 1 H; J = 2 Hz; H-3), 8.05 (dd; 1 H; J₁ = 8, J₂ = 2 Hz; H-5), 7.82 (d; 1 H; J = 8 Hz; H-6), 7.29 (t; 1 H; J = 8 Hz; H-5'), 6.90 (m; 3 H; H-2', H-4'; H-6')', 4.01 (m; 2 H; O-CH₂), 3.94, 3.67 (jeweils: s; 3 H; CO₂-CH₃), 1.84 (m; 1 H; O-CH₂-CH₂-CH), 1.63-1.48 (m; 3 H; H-alkyl), 1.37-1.12 (m; 6 H; H-alkyl), 0.96 (d; 3 H; J = 7.8 Hz; CH₃), 0.87 (d; 6 H; J =7.7 Hz; CH₃).

### Beispiel C3: Synthese von 2-(2',5'-Dimethylphenyl)terephthalsäurediethylester:

Bromterephthalsäurediethylester (45.2 g, 150 mmol), K₂CO₃ (41.5 g, 300 mmol), 140 ml Toluol und 140 ml H₂O wurden vorgelegt und 30 Minuten mit Argon gespült. Anschließend wurde 2,5-Dimethylbenzolboronsäure (24.8 g, 165 mmol) (vgl. B3), sowie Pd(PPh₃)₄ (0.7 g, 0,6 mmol) unter Schutzgas zugegeben. Das bräunliche, durch Phasentrennung trübe Gemisch wurde unter Schutzgasüberlagerung bei 85° C Innentemperatur kräftig gerührt. Die Reaktion war nach 24 Stunden (laut DC) beendet. Nach Phasentrennung wurde die org. Phase mit verdünnter HCl / H₂O ausgeschüttelt (neutral). Die wäßrige Phase schüttelte man mit Toluol aus und vereinigte die organischen Phasen. Nach Abfiltrieren von evtl. Palladium-Resten wurde eingeengt. Man erhielt das Produkt als gelbes Öl in ausreichender Reinheit (größer 97%). Ausbeute: 48.7 g (99 %).
¹H NMR (400 MHz; CDCl₃): δ [ppm] = 8.07 (dd; 1 H; J₁ = 8, J₂ = 2 Hz; H-5), 7.96 (d; 1 H; J = 8 Hz; H-6), 7.92 (d; 1 H; J = 2 Hz; H-3), 7.14 (d; 1 H; J = 7.9 Hz; H-3'), 7.09 (dd; 1 H; J₁ = 7.9, J₂ = 2 Hz; H-4'), 6.91 (d; 1 H; J = 2 Hz; H-6'), 4.39, 4,16 (jeweils: q; 2 H; J = 8 Hz; CO₂-CH₂), 2.32, 2.02. (jeweils: s; 3 H; aryl-CH₃), 1.39, 0.97 (jeweils: t; 3 H; J = 8 Hz; CO₂-CH₂-CH₃).

### Beispiel C4: Synthese von 4'-(3,7-Dimethyloctyloxyphenyl)terephthalsäuredi-ethylester

Durchführung analog Beispiel C3; Palladiumreste wurden noch durch Ausrühren mit mit 1%iger wäßriger NaCN-Lösung beseitigt.
Das Produkt (100% Ausbeute) ist ein farbloses hochviskoses Öl.
¹H NMR (CDCl₃): δ [ppm] = 8.04 (d, 1 H, H-3, J = 1.8 Hz), 8.03 (dd, 1 H, H-5, J₁ = 7.8, J₂ = 1.8 Hz), 7.8 (d, 1 H, H-6, J = 7.8 Hz), 7.25, 6.93 (AA'BB', 4 H, H-Aryl), 4.40, 4.15 (2 x q, 2, x 2 H, CO₂CH₂, J = 7.6 Hz), 4.04 (m, 2 H, O-CH₂), 1.86 (m, 1 H. H-3"), 1.60 (m, 3 H, H-2", H-7"), 1.40, 1.07 (2 x t, 2 x 3H, Ester-CH₃, J =7.6 Hz), 1.30 (m, 6 H, H-4", H-5", H-6"), 0.92 (d, 3 H, Me, J = 7.5 Hz), 0.86 (d, 6 H, Me, J = 7.5 Hz).

### Beispiel C5: Synthese von 3,4-Bis(2-methylpropyloxy)phenylterephthalsäurediethylester

Synthese analog Beispiel C4. Das Produkt (99% Ausbeute) ist ein farbloses hochviskoses Öl.
¹H NMR (CDCl₃): δ [ppm] = 8.05 (d, 1 H, H-3, J =1.9 Hz), 8.03 (dd, 1 H, H-5, J₁ = 7.9, J₂ =1.9 Hz), 7.77 (d, 1 H, H-6, J = 7.9 Hz), 6.87 (m, 3 H, H-Aryl), 4.40, 4.13 (2 x q, 2 x 2 H, CO₂CH₂, J = 7.5 Hz), 3.79, 3.76 (2 x d, 2 x 2 H, O-CH₂, J = 8 Hz), 2.13 (m, 2 H, CH), 1.41, 1.07 (2 x t, 2 x 3H, Ester-CH₃, J = 7.5 Hz), 1.04 (m, 12 H, CH₃).

### Beispiel C6: Synthese von 4-[4'-(3,7-Dimethyloctyloxy)biphenyl]terephthalsäurediethylester

Synthese analog Beispiel C4. Das Produkt (99% Ausbeute) ist ein farbloses hochviskoses Öl.
¹H NMR (CDCl₃): δ [ppm] = 8.10 (d, 1 H, H-3, J = 1.9 Hz), 8.07 (dd, 1 H, H-5, J₁ = 7.9, J₂ = 1.9 Hz), 7.86 (d, 1 H, H-6, J = 7.9 Hz), 7.59, 7.38 (AA'BB', 4 H, H-Aryl), 7.56, 6.99 (AA'BB', 4 H, H-Aryl), 4.41, 4.14 (2 x q, 2 x 2 H, CO₂CH₂, J = 7.6 Hz), 4.05 (m, 2 H, O-CH₂), 1.86 (m, 1 H, H-3"), 1.65 (m, 3 H, H-2", H-7"), 1.41"; 1.04 (2 x t, 2 x 3H, Ester-CH₃, J =7.6 Hz), 1.30 (m, 6 H, H-4", H-5", H-6"); 0.96 (d, 3 H, Me, J = 7.5 Hz), 0.87 (d, 6 H, Me, J = 7.5 Hz).

### Beispiel C7: Synthese von 2-[4-(3,7-Dimethyloctyloxy)phenyl]-5-methoxyterephthalsäurediethylester

Synthese analog Beispiel C4 (hier unter Verwendung von 2-Brom-5-methoxyterephthalsäurediethylester, vgl. Bsp. A2). Das Produkt (95% Ausbeute) war ein farbloses hochviskoses Öl.
¹H NMR (CDCl₃): δ [ppm] = 7.75, 7.35 (2 x s, 2 x 1 H, H-3, H-6), 7.20, 6.91 (AA'BB', 4 H, H-Aryl), 4.37, 4.12 (2 x q, 2 x 2 H, CO₂CH₂, J = 7.6 Hz), 4.02 (m, 2 H, O-CH₂), 3.97 (s, 3 H, O-Me), 1.84 (m, 1 H, H-3"), 1.62 (m, 3 H, H-2", H-7"), 1.37, 1.03 (2 x t, 2 x 3H, Ester-CH₃, J = 7.6 Hz), 1.28 (m, 6 H, H-4", H-5", H-6"), 0.96 (d, 3 H, Me, J = 7.5 Hz), 0.87 (d, 6 H, Me, J = 7.5 Hz).

### Beispiel C8: Synthese von 2-[3-(3,7-Dimethyloctyloxy)phenyl]-5-methoxyterephthalsäurediethylester

Synthese analog Beispiel C7. Das Produkt (95% Ausbeute) war ein farbloses hochviskoses Öl.
¹H NMR (CDCl₃): δ [ppm] = 7.78, 7.37 (2 x s, 2 x 1 H, H-3, H-6), 7.26 (t; 1 H; H-5', J = 8 Hz), 6.86 (m; 3 H; H-2', H-4', H-6'), 4.37, 4.10 (2 x q, 2 x 2 H, CO₂CH₂, J = 7.6 Hz), 4.00 (m, 2 H, O-CH₂), 3.97 (s, 3 H, O-Me), 1.83 (m, 1 H, H-3"), 1.62 (m, 3 H, H-2", H-7"), 1.37, 1.01 (2 x t, 2 x 3H, Ester-CH₃, J = 7.6 Hz), 1.28 (m, 6 H, H-4", H-5", H-6"), 0.95 (d, 3 H, Me, J = 7.5 Hz), 0.86 (d, 6 H, Me, J = 7.5 Hz).

### D. Reduktionen gemäß Reaktion B

### Beispiel D1: Synthese von 2,5-Bishydroxymethyl-4'-hexyloxybiphenyl:

LiAlH₄ (5,3 g, 140 mmol) wurde in ca. 200 ml THF mit Argonüberlagerung vorgelegt und 2-(4'-Hexyloxyphenyl)terephthalsäurediethylester (40 g, 100 mmol) (vgl. C1) mit weiteren 50 ml THF über einen Tropftrichter langsam zugetropft. Dabei wurde die Reaktionsmischung kräftig gerührt. Anschließend kocht man für ca. eine Stunde am Rückfluß. Die Reaktionsmischung wurde auf RT gebracht und unter Wasserbadkühlung sowie Argonüberlagerung vorsichtig bis zum Ende der Gasentwicklung tropfenweise mit Eiswasser versetzt. Anschließend wurde solange verdünnte (10 %-ig) Schwefelsäure zugetropft, bis die trüb-graue Mischung klar war. Die Phasen wurden durch Chloroformzugabe getrennt und die wäßrige Phase mit Chloroform (zweimal) ausgeschüttelt. Die organischen Phasen wurden einmal mit H₂O gewaschen und anschließend eingeengt. Das erhaltene Rohprodukt wurde aus Hexan/Ethylacetat (5/1) umkristallisiert.
Produkt: 20,3 g (65%) farblose Nadel, Reinheit > 98%. Schmelzpunkt: 72.5-74°C.
¹H NMR (400 MHz; CDCl₃): δ [ppm] = 7.53 (d; 1 H; J = 8 Hz; H-6), 7.36 (dd; 1 H; J₁ = 8, J₂ = 2 Hz; H-5), 7.27 (d; 1 H; J = 2 Hz; H-3), 7.26, 6.94 (AA'BB'; 4 H; H-phenyl), 4.72, 4.61 (jeweils: s; 2 H; CH₂-OH), 3.99 (t; 2 H; J = 7.5 Hz; O-CH₂), 1.81 (m; 2 H; O-CH₂-CH₂), 1.53-1.26 (m; 6 H; H-alkyl), 0.92 (m; 3 H; CH₃).

### Beispiel D2: Synthese von 2,5-Bishydroxymethyl-3'-(3,7-dimethyloctyloxy)biphenyl:

LiAlH₄ (9.4 g, 248 mmol) wurde unter N₂ in 300 ml THF vorgelegt. Bei RT wurde dann langsam 2-(3'-(3,7-Dimethyloctyloxy)phenyl)terephthalsäuredimethylester (75.5 g, 177 mmol), gelöst in 120 ml THF, zutropft. Anschließend wurde 4 h unter Rückfluß gerührt. Nach dem Abkühlen wurde überschüssiges LiAlH₄ vorsichtig durch H₂O-Zugabe vernichtet. Anschließend wurde halbkonzentrierte H₂SO₄ vorsichtig ( ca. 50 ml ) zugetropft. Der Ansatz war dabei sehr zähflüssig. Nach 1 h Nachrührzeit war eine klare Lösung und unten im Kolben ein schleimiger grauer Niederschlag zu sehen. Die klare Lösung wurde abdekantiert und das Lösungsmittel abgezogen. Der zurückgebliebene Niederschlag wurde mit viel Wasser und Ethylacetat gerührt, nach Filtration die organische Phase abgetrennt, das Lösungsmittel abgezogen und mit der ersten organischen Phase vereinigt. Die vereinigten organischen Phasen wurden in Ethylacetat aufgenommen und mit Wasser fünfmal extrahiert. Nach Trocknung über MgSO₄ wurde das Lösungsmittel abgezogen. Das entstehende Öl wurde mehrfach mit Hexan gerührt und am Ölpumpenvakuum getrocknet. Das Produkt wurde so als reines hellgelbes, hochviskoses Öl (54 g, 82 %) erhalten.
¹H NMR (400 MHz; CDCl₃): δ [ppm] = 7.50 (d; 1 H; J = 7.8 Hz; H-6); 7.34 (dd, 1 H; J₁ = 7.8, J₂ = 1.9 Hz; H-5), 7.30 (dt; 1H, J₁ = 8, J₂ = 1 Hz; H-5'), 7.26 (d; 1 H; J = 1.9 Hz; H-3), 6.88 (m; 3 H; H-2', H-4', H-6'), 4.69, 4.59 (jeweils: s; 2 H; CH₂-OH), 4.00 (m; 2 H; O-CH₂), 1.97 (s; 2 H; OH), 1.82 (m; 1 H; O-CH₂-CH₂-CH), 1.67-1.50 (m; 3 H; H-alkyl), 1.40-1.13 (m; 6 H; H-alkyl), 0.95 (d; 3 H; J = 7.5 Hz; CH₃), 0.87 (d; 6 H; J = 7.6 Hz; CH₃).

### Beispiel D3: Synthese von 2,5-Bishydroxymethyl-2',5'-dimethylbiphenyl:

LiAlH₄ (7.9 g, 208 mmol) wurde unter Argonüberlagerung mit ca. 250 ml THF vorgelegt. 2-(2',5'-Dimethylphenyl)terephthalsäurediethylester (48.6 g, 149 mmol) (vgl. C3) wurde im Tropftrichter mit etwa 60 ml THF verdünnt und langsam zugetropft. Dabei wurde die Reaktionsmischung kräftig gerührt. Der mit nochmals 100 ml THF verdünnte Ansatz wurde dann bei 67°C am Rückfluß gekocht. Nach 2 h wurde auf RT abgekühlt. Unter Wasserbadkühlung und Argonüberlagerung wurde bis zum Ende der Gasentwicklung tropfenweise mit Eiswasser versetzt. Anschließend wurde solange verdünnte (10 %-ige) Schwefelsäure zugetropft, bis die trüb-graue Mischung aufklarte. Das Phasengemisch wurde durch großzügige Chloroformzugabe getrennt und anschließend die wäßrige Phase zweimal mit Chloroform ausgeschüttelt. Die organischen Phasen wurden einmal mit H₂O geschüttelt und eingeengt. Das Rohprodukt wurde aus Chloroform/Hexan umkristallisiert: 24.7 g (68 %) farbloses, mikrokristallines Pulver; Schmelzpunkt:
145 - 148° C (Reinheit > 95%).
¹H NMR (400 MHz; CDCl₃): δ [ppm] = 7.54 (d; 1 H; J = 7.8 Hz; H-6), 7.38 (dd; 1 H; J₁ = 7.8, J₂ = 1.8 Hz; H-5), 7.15 (d; 1 H; J = 7.8 Hz; H-3'). 7.13 (d; 1 H; J = 1.9 Hz; H-3), 7.08 (dd; 1 H; J₁ = 7.7, J₂ = 1.5 Hz; H-4'), 6.94 (d; 1 H; J = 1.5 Hz; H-6'), 4.72, 4.42 (jeweils: s; 2 H; CH₂-OH), 2.33, 2.01 (jeweils: s; 3 H; aryl-CH₃).

### Beispiel D4: Synthese von 2,5-Bishydroxymethyl-4'-(3,7-dimethyloctyloxy)biphenyl

Durchführung analog Beispiel D3; der Ansatz wurde jedoch nicht sauer, sondern alkalisch aufgearbeitet: dazu gab man nach beendeter Reduktion vorsichtig x ml Wasser (bei einem Einsatz von x g LiAlH₄) zu. Anschließend wurden x ml wäßriger NaOH-Lösung (15%ig) und schließlich 3 x ml Wasser zugegeben. Nach jeder Zugabe wurde für ca. 15 Minuten nachgerührt ("1:1:3 Methode"). Von dem entstandenen Feststoff wurde abgesaugt, dieser emeut mit THF gerührt und schließlich die vereinigten organischen Phasen eingeengt. Diese Aufarbeitung erwies sich als vorteilhafter im Vergleich zu der saueren Variante, die in den Beispielen D1 bis D3 Verwendung fand. Umkristallisation aus Hexan/Ethylacetat (30:1).
Man erhielt das Produkt (88% Ausbeute) als farblosen, wachsartigen Feststoff. Schmelzpunkt: 67°C
¹H NMR (CDCl₃): δ [ppm] = 7.53 (d, 1 H, H-6, J = 7.9 Hz), 7.36 (dd, 1 H, H-5, J₁ = 7.9, J₂ = 2 Hz), 7.27 (d, 1 H, H-3, J = 2 Hz), 7.28, 6.95 (AA'BB', 4 H, H-Aryl), 4.72, 4.63 (2 x d, 2 x 2 H, CH₂-OH, J = 8 Hz), 4.03 (m, 2 H, O-CH₂), 1.90, 1.68 (2 x t, 2 x 1 H, OH, J = 8 Hz), 1.85 (m, 1 H, H-3'), 1.65 (m, 3 H, H-2', H-7'), 1.30 (m, 6 H, H-4', H-5', H-6'), 0.97 (d, 3 H, Me, J = 7.5 Hz), 0.87 (d, 6 H, Me, J = 7.5 Hz).

### Beispiel D5: Synthese von 2,5-Bishydroxymethyl-3',4'-bis(2-methylpropyloxy)biphenyl

Synthese analog Beispiel D4. Umkristallisation aus Hexan/Ethylacetat (15:1). Man erhielt das Produkt (84% Ausbeute) als farblose Kristalle.
Schmelzpunkt: 73°C
¹H NMR (CDCl₃): δ [ppm] = 7.53 (d, 1 H, H-6, J = 7.9 Hz), 7.37 (dd,1 1 H, H-5, J₁ = 7.9, J₂ = 2 Hz); 7.29 (d, 1 H, H-3, J = 2 Hz), 6.89 (m, 3 H, H-Aryl), 4.73, 4.63 (2 x s, 2 x 2 H, CH₂O), 3.80, 3.77 (2 x d, 2 x 2 H, O-CH₂, J = 8 Hz), 2.15 (m, 2 H, CH), 1.55 (br, 2 H + H₂O, OH), 1.06, 1.03 (2 x d, 2 x 6 H, CH₃).

### Beispiel D6: Synthese von 2,5-Bishydroxymethyl-4"-(3,7-dimethyloctyloxy)terphenyl

Synthese analog Beispiel D4. Umkristallisation aus Hexan/Ethylacetat (15:1). Man erhielt das Produkt (88% Ausbeute) als farblose Kristalle. Schmelzpunkt: 106°C ¹H NMR (CDCl₃): δ [ppm] =7.60, 7.41 (AA'BB', 4 H, H-Aryl), 7.56, 6.99 (AA'BB', 4 H, H-Aryl), 7.54 (d, 1 H, H-6, J = 7.9 Hz), 7.39 (dd, 1 H, H-5, J₁ = 7.9, J₂ = 2 Hz), 7.32 (d, 1 H, H-3, J = 2 Hz), 4.74, 4.66 (2 x d, 2 x 2 H, CH₂O, J = 4 Hz), 4.05 (m, 2 H, O-CH₂), 1.87 (m, 1 H, H-3'), 1.77, 1.67 (2 x br, 2 x 1 H, OH), 1.65 (m. 3 H, H-2', H-7'), 1.27 (m, 6 H, H-4', H-5', H-6'), 0.96 (d, 3 H, Me, J = 7.5 Hz), 0.88 (d, 6 H, Me, J = 7.5 Hz).

### Beispiel D7: Synthese von 2,5-Bishydroxymethyl-4-methoxy-4'-(3,7-dimethyloctyloxy)biphenyl

Synthese analog Beispiel D4. Umkristallisation aus Hexan/Ethylacetat (20:1). Man erhielt das Produkt (93% Ausbeute) als farblose Kristalle.
Schmelzpunkt: 101°C
¹H NMR (CDCl₃): δ [ppm] = 7.21, 6.93 (AA'BB', 4 H, H-Aryl), 7.18, 7.10 (2 x s, 2 x 1 H, H-3, H-6), 4.70, 4.62 (2 x s, 2 x 2 H, CH₂O), 4.02 (m, 2 H, O-CH₂), 3.93 (s, 3 H, O-Me), 1.85 (m, 1 H, H-3'), 1.65 (br, 2 H, OH), 1.60 (m, 3 H, H-2', H-7'), 1.28 (m, 6 H, H-4', H-5', H-6'), 0.96 (d, 3 H, Me, J = 7.5 Hz), 0.86 (d, 6 H, Me, J = 7.5 Hz).

### Beispiel D8: Synthese von 2,5-Bishydroxymethyl-4-methoxy-3'-(3,7-dimethyloctyloxy)biphenyl

Synthese analog Beispiel D4. Ausrühren mit heißem Hexan. Man erhielt das Produkt (99% Ausbeute) als farblosen, wachsartigen Feststoff. Schmelzpunkt: 55°C
¹H NMR (CDCl₃): δ [ppm] = 7.29 (t; 1 H; J = 8 Hz; H-5'), 7.21, 7.12 (2 x s, 2 x 1 H, H-3, H-6), 6.87 (m; 3 H; H-2', H-4', H-6'), 4.70, 4.64 (2 x d, 2 x 2 H, CH₂O, J = 8 Hz), 4.01 (m, 2 H, O-CH₂), 3.93 (s, 3 H, O-Me), 2.29, 1.63 (2 x t, 2 x 1 H, OH, J = 8 Hz), 1.84 (m, 1 H, H-3'), 1.60 (m, 3 H, H-2', H-7'), 1.25 (m, 6 H, H-4', H-5', H-6'), 0.94 (d, 3 H, Me, J = 7.5 Hz), 0.87 (d, 6 H, Me, J = 7.5 Hz).

### E. Halogenierungen gemäß Reaktion C(b)

### Beispiel E1: Synthese von 2,5-Bisbrommethyl-4'-hexyloxybiphenyl:

Unter Wasserkühlung wurden in HBr (33%ig in HAc, 36 ml, 200 mmol) 2,5-Bishydroxymethyl-4'-hexyloxybiphenyl (12.6 g, 40 mmol) (vgl. D1) eingerührt. Die zweiphasige, hellbraune und leicht viskose Suspension wurde bei RT unter. Schutzgas über Nacht gerührt. Die resultierende Reaktionsmischung schüttelte man mit Chloroform so oft aus, bis die Wasserphase farblos war. Aus der eingeengten organischen Phase erhielt man ein klares, honigfarbenes Öl, welches in der Kälte innerhalb 1-2 Tagen zu einem wachsartigen, trüben Feststoff erstarrte: 16.9 g (96 %); Schmelzpunkt: 38,5° - 40,5° C; Reinheit > 98%.
¹H NMR (400 MHz; CDCl₃): δ [ppm] = 7.49 (d; 1 H: J = 8 Hz; H-6), 7.35 (dd; 1 H; J₁ = 8, J₂ = 2 Hz; H-5), 7.26 (d; 1 H; J = 2 Hz; H-3), 7.36, 6.98 (AA'BB'; 4 H; H-phenyl), 4.48, 4.44 (jeweils: s; 2 H; CH₂-Br), 4.01 (t; 2 H; J = 6.5 Hz; O-CH₂), 1.81 (quint; 2 H; J = 6.9 Hz; O-CH₂-CH₂), 1.50-1.30 (m; 6 H; H-alkyl), 0.92 (t; 3 H; J = 7.0 Hz; CH₃).

### Beispiel E2: Synthese von 2,5-Bischlormethyl-4'-hexyloxybiphenyl:

2,5-Bis(hydroxymethyl)-4'-hexyloxybiphenyl (9.43 g, 30 mmol) (vgl. D1) wurde mit 50 ml Toluol, vermischt mit einem Tropfen Pyridin vorgelegt (ungelöst) und SOCl₂ innerhalb ca. 10 min zugetropft. Nach wenigen Tropfen Zugabe klarte die Suspension auf, was mit einem leichten Temperaturanstieg einherging. Die Lösung wurde anschließend bei 60° Innentemperatur gerührt. Nach 90 Minuten wurde der Ansatz aufgearbeitet. Die Reaktionsmischung wurde nach Abkühlen mit ca. 20 ml Wasser versetzt und dann mit H₂O ausgeschüttelt. Die Wasserphase schüttelte man mit Toluol, vereinigte die organischen Phasen und engte ein: 10,5 g (100%) honigfarbenes, öliges Produkt. Reinheit ca. 90% (¹H-NMR).
¹H NMR (400 MHz; CDCl₃): δ [ppm] = 7.53 (d; 1 H; J = 8 Hz; H-6), 7.38 (dd; 1 H; J₁ = 8, J₂ = 2 Hz; H-5), 7.28 (d; 1 H; J = 2 Hz; H-3), 7.33, 6.97 (AA'BB'; 4 H; H-phenyl), 4.60, 4.53 (jeweils: s; 2 H; CH₂-Cl), 4.01 (t; 2 H; J = 6.9 Hz; O-CH₂), 1.83 (pseudo-quint; 2 H; J = 6.9 Hz; O-CH₂-CH₂), 1.55-1.33 (m; 6 H; H-alkyl), 0.94 (m; 3 H; CH₃).

### Beispiel E3: Synthese von 2,5-Bisbrommethyl-2',5'-dimethylbiphenyl:

In mittels Wasserbad gekühlte HBr (33%ig in HAc, 36 ml, 200 mmol) wurde 2,5-Bishydroxymethyl-2',5'-dimethylbiphenyl (10 g, 41 mmol) (vgl. D3) eingerührt. Die klare Lösung wurde bei RT unter Schutzgas über Nacht eingerührt. Man schüttelte mit Chloroform mehrmals aus, bis die Wasserphase farblos war. Aus der eingeengten organischen Phase erhielt man ein honigfarbenes Öl, welches auch in der Kälte (-18°C) nicht kristallisierte: 14.3 g (94 %); Reinheit > 98%.
¹H NMR (400 MHz; CDCl₃): δ [ppm] = 7.52 (d; 1 H; J = 7.8 Hz; H-6), 7.37 (dd; 1 H; J₁ = 7.8, J₂ = 1.9 Hz; H-5), 7.18 (d; 1 H; J = 7.8 Hz; H-3'), 7.17 (d; 1 H; J = 1.9 Hz; H-3), 7.11 (dd; 1 H; J₁ = 7.7, J₂ = 1.6 Hz; H-4"), 7.00 (d; 1 H; J = 1.7 Hz; H-6'), 4.48, 4.28 (jeweils: AB; 2 H; J_{AB} = 12 Hz; CH₂-Br), 2.35, 2.03 (jeweils: s; 3 H; aryl-CH₃).

### Beispiel E4: Synthese von 2,5-Bischlormethyl-2',5'-dimethylbiphenyl:

Zu 2,5-Bishydroxymethyl-2',5'-dimethylbiphenyl (34.2 g, 141 mmol) wurde SOCl₂ (36.9 g; 22.7 ml, 310 mmol) innerhalb etwa 20 Minuten unter Schutzgas bei Raumtemperatur unter Rühren eingetropft. Am Ende der Zugabe lag eine ölige, leicht trübe Lösung vor. Der Reaktionsansatz wurde 20 Stunden bei Raumtemperatur gerührt, anschließend vorsichtig in 200 ml wäßriger NaHCO₃- Lösung eingerührt und mit Ethylacetat kräftig verrührt. Nach Phasentrennung schüttelte man die organische Phase mit Wasser aus, bis sie neutral war und zog schließlich nach Trocknen über Na₂SO₄ das Lösungsmittel ab. Reinigung erfolgt durch fraktionierte Vakuumdestillation über etwas NaHCO₃. Man erhielt 27.9 g (65%) Produkt als klares viskoses Öl; Reinheit >99% (Siedepunkt: 135°C bei 0,3 mbar).
¹H NMR (400 MHz; CDCl₃): δ [ppm] = 7.56 (d; 1 H; J = 7.9 Hz; H-6), 7.40 (dd; 1 H; J₁ = 7.9, J₂ = 1.8 Hz; H-5), 7.18 (d; 1 H; J = 1.8 Hz; H-3), 7.16 (d; 1 H; J = 8 Hz; H-3'), 7.11 (dd; 1 H; J₁ = 7.9, J₂ = 1.6 Hz; H-4'), 6.97 (d; 1 H; J = 1.5 Hz; H-6'), 4.60, 4.35 (jeweils: AB; 2 H; J_{AB} = 12 Hz; CH₂-Cl), 2.33, 2.02 (jeweils: s; 3 H; aryl-CH₃).

### Beispiel E5: Synthese von 2,5-Bischlormethyl-3'-(3,7-dimethyloctyloxy)biphenyl:

Unter N₂ wurde 2,5-Bishydroxymethyl-3'-(3,7-dimethyloctyloxy)biphenyl (50.7 g, 137 mmol) vorlegt und Thionylchlorid (20 ml, 274 mmol) vorsichtig zugeben. Es wurde noch zweimal (nach 2 und nach 8 Stunden) jeweils 2 ml Thionylchlorid nachgegeben und der Ansatz schließlich insgesamt 20 Stunden bei Raumtemperatur gerührt. Der Ansatz wurde vorsichtig auf wäßrige NaHCO₃-Lösung gegossen, und mit Ethylacetat extrahiert und schließlich wurde die organische Phase noch neutral gewaschen. Nach dem Trocknen über MgSO₄ wurde das Ethylacetat abgezogen und der Ansatz im Vakuum fraktioniert destilliert. Man erhielt das Produkt (39 g, 70 %) als hochviskoses farbloses Öl (Siedepunkt: 212°C bei 0.67 mbar).
¹H NMR (300 MHz; CDCl₃): δ [ppm] = 7.54 (d; 1 H; J = 8.3 Hz; H-6), 7.41 (dd; 1 H; J₁ = 8.2, J₂ = 2.1 Hz; H-5), 7.34 (d; 1 H; J₁ = 8, J₂ = 1 Hz; H-5'), 7.31 (d; 1 H; J = 2 Hz; H-3), 6.94 (m; 3.H; H-2'; H-4', H-6'); 4.61, 4.52 (jeweils: s; 2 H; CH₂Cl), 4.04 (m; 2H; O-CH₂), 1.84 (m; 1 H; O-CH₂-CH₂-CH), 1.72-1.46 (m; 3 H; H-alkyl), 1.38-1.10 (m; 6 H; H-alkyl), 0.94 (d; 3 H; J = 6.7 Hz; CH₃), 0.86 (d; 6 H; J = 6.9 Hz; CH₃).

### Beispiel E6: Synthese von 2,5-Bischlormethyl-4'-(3,7-dimethyloctyloxy)biphenyl

Durchführung analog Beispiel E5; das Produkt (67% Ausbeute) wurde durch Destillation an einer Kurzwegdestille (0.3 mbar, 243°C) als farbloses, hochviskoses Öl erhalten (Reinheit: 99 %).
¹H NMR (CDCl₃): δ [ppm] = 7.52 (d, 1 H, H-6, J =7.9 Hz), 7.38 (dd, 1 H, H-5, J₁ = 7.9, J₂ =2 Hz), 7.32, 6.97 (AA'BB', 4 H, H-Aryl), 7.29 (d, 1 H, H-3, J = 2 Hz), 4.59, 4.52 (2 x s, 2 x 2 H, CH₂Cl), 4.04 (m, 2 H, O-CH₂), 1.85 (m, 1 H, H-3'), 1.60 (m, 3 H, H-2', H-7'), 1.30 (m, 6 H, H-4', H-5', H-6'), 0.97 (d, 3 H, Me, J = 7.5 Hz), 0.87 (d, 6 H, Me, J = 7.5 Hz).

### Beispiel E7: Synthese von 2,5-Bischlormethyl-3',4'-bis(2-methylpropyloxy)biphenyl

Durchführung analog Beispiel E5; das Produkt (42% Ausbeute) wurde durch Destillation an einer Kurzwegdestille (0.5 mbar, 240°C) als farbloses, hochviskoses Öl erhalten (Reinheit: 99 %).
¹H NMR (CDCl₃): δ [ppm] = 7.53 (d, 1 H, H-6, J = 7.8 Hz), 7.38 (dd, 1 H, H-5, J₁ = 7.8, J₂ = 2 Hz), 7.31 (d, 1 H, H-3, J = 2 Hz), 6.98 (d, 1 H, H-2', J = 2 Hz), 6.93 (d, 1 H, H-5', J = 8 Hz),), 6.90 (dd, 1 H, H-6', J₁ = 8, J₂ = 2 Hz), 4.60, 4.53 (2 x s, 2 x 2 H, CH₂Cl), 3.80 (m, 4 H, O-CH₂), 2.16 (m, 2 H, CH), 1.07, 1.04 (2 x d, 2 x 6 H, CH₃, J = 7 Hz).

### Beispiel E8: Synthese von 2,5-Bischlormethyl-4"-(3,7-dimethyloctyloxy)terphenyl

Durchführung analog Beispiel E5; das Produkt (25% Ausbeute) wurde durch Destillation an einer Kurzwegdestille (0.1 mbar, 265°C) als farbloses, hochviskoses Öl erhalten (Reinheit: > 99 %).
¹H NMR (CDCl₃): δ [ppm] = 7.65, 7.45 (AA'BB', 4 H, H-Aryl), 7.58, 7.00 (AA'BB', 4 H, H-Aryl), 7.56 (d, 1 H, H-6, J = 8 Hz), 7.43 (dd, 1 H, H-5, J₁ = 8, J₂ = 2 Hz), 7.35 (d, 1 H, H-3, J = 2 Hz), 4.62, 4.57 (2 x s, 2 x 2 H, CH₂Cl), 4.06 (m, 2 H, O-CH₂), 1.87 (m, 1 H, H-3'), 1.60 (m, 3 H, H-2', H-7'), 1.27 (m, 6 H, H-4', H-5', H-6'), 0.97 (d, 3 H, Me, J = 7.5 Hz), 0.87 (d, 6 H, Me, J = 7.5 Hz).

### Beispiel E9: Synthese von 2,5-Bischlormethyl-4-methoxy-4'-(3,7-dimethyloctyloxy)biphenyl

Durchführung analog Beispiel E5; das Produkt (40% Ausbeute) wurde durch Destillation an einer Kurzwegdestille (0.3 mbar, 265°C) als farbloses, hochviskoses Öl erhalten (Reinheit: 99 %).
¹H NMR (CDCl₃): δ [ppm] = 7.29, 6.95 (AA'BB', 4 H, H-Aryl), 7.27, 7.03 (2 x s, 2 x 1 H, H-3, H-6), 4.65, 4.53 (2 x s, 2 x 2 H, CH₂Cl), 4.04 (m, 2 H, O-CH₂), 3.94 (s, 3 H, O-Me), 1.85 (m, 1 H, H-3'), 1.63 (m, 3 H, H-2', H-7'), 1.28 (m, 6 H, H-4', H-5', H-6'), 0.97 (d, 3 H, Me, J = 7.5 Hz), 0.88 (d, 6 H, Me, J = 7.5 Hz).

### Beispiel E10: Synthese von 2,5-Bischlormethyl-4-methoxy-3'-(3,7-dimethyloctyloxy)biphenyl

Durchführung analog Beispiel E5; das Produkt (25% Ausbeute) wurde durch Destillation an einer Kurzwegdestille (0.2 mbar, 247°C) als farbloses, hochviskoses Öl erhalten. Mehr Produkt konnte aus dem Destillationsrückstand durch Säulenchromatographie gewonnen werden (Reinheit: 99 %).
¹H NMR (CDCl₃): δ [ppm] = 7.32 (t; 1 H; J = 8 Hz; H-5'), 7.30, 7.04 (2 x s, 2 x 1 H, H-3, H-6), 6.93 (m; 3 H; H-2', H-4', H-6'), 4.66, 4.53 (2 x s, 2 x 2 H, CH₂Cl), 4.04 (m, 2 H, O-CH₂), 3.95 (s, 3 H, O-Me), 1.84 (m, 1 H, H-3'), 1.60 (m, 3 H, H-2', H-7'), 1.25 (m, 6 H, H-4', H-5', H-6'), 0.94 (d, 3 H, Me, J = 7.5 Hz), 0.86 (d, 6 H, Me, J = 7.5 Hz).

### F) Oxidationen gemäß Reaktion C(a)

### Beispiel F1: Synthese von 2-(4'-Hexyloxyphenyl)terephthaldehyd:

70 ml Dichlormethan wurden vorgelegt und mit Oxalylchlorid (8.4 g, 5.7 ml, 66 mmol) versetzt und auf -60°C abgekühlt. Dazu wurde innerhalb von 10 Minuten eine Lösung von DMSO (10.2 g, 9.3 ml, 131 mmol) in 30 ml Dichlormethan getropft. Die Mischung wurde 5 Minuten nachgerührt. Dann wurde innerhalb von 15 Minuten eine Lösung aus 2,5-Bis(hydroxymethyl)-4'-hexyloxybiphenyl (10 g, 32 mmol) (vgl. D1) in 70 ml Dichlormethan zugetropft (die Reaktionslösung wurde trüb). Es wurde 10 Minuten nachgerührt, anschließend wurde Triethylamin (15.9 g, 21.8 ml, 157 mmol) zugetropft. Dabei färbte sich die Reaktionslösung gelb, und es bildete sich Niederschlag. Das Aceton/Trockeneis-Bad wurde entfernt und der Ansatz für 2 Stunden bei RT gerührt. Anschließend schwamm heller Feststoff auf der gelben, flüssigen Phase. Die Mischung wurde mit 150 ml Wasser versetzt, 10 Minuten nachgerührt (Feststoff ging in Lösung), die organische Phase wurde abgetrennt, die wäßrige Phase zweimal mit Dichlormethan extrahiert, die vereinigten organischen Phasen anschließend dreimal mit Wasser gewaschen, über Na₂SO₄ getrocknet, abfiltriert und anschließend, am Rotationsverdampfer zur Trockene eingeengt. Das gelbe Öl kristallisierte nach einiger Zeit bei RT, es wurde anschließend aus Hexan umkristallisiert. Es dauerte relativ lange, bis das Produkt fest wurde: hellbeiges, mikrokristallines Pulver, 5.67 g (57%), Reinheit ca. 98%ig. Schmelzpunkt: 44.5-45.5°C.
¹H NMR (400 MHz; CDCl₃): δ [ppm] = 10.14 (s; 1 H; 1-CHO), 10.05 (d; 1 H; J = 0.8 Hz; 4-CHO), 8.13 (d; 1 H; J = 7.5 Hz; H-6), 7.96 (d; 1 H; J = 1.5 Hz; H-3), 7.94 (ddd; 1 H; J₁ = 7.7, J₂ = 1.5, J₃ = 0.8 Hz; H-5), 7.33, 7.03 (AA'BB'; 4 H; H-phenyl), 4.03 (t; 2 H; J = 6.7 Hz; O-CH₂), 1.83 (quint; 2 H; J = 6.6 Hz; O-CH₂-CH₂), 1.55-1.35 (m; 6 H; H-alkyl), 0.92 (t; 3 H; J = 7.2 Hz; CH₃).

### G. Reaktionen gemäß Reaktion D

### Beispiel G1: Synthese von 2,5-Bis(methylendiethylphosphonat)-4'-hexyloxybiphenyl:

2,5-Bis(chlormethyl)-4'-hexyloxybiphenyl (9.2 g, 26.2 mmol) (vgl. E2) und Triethylphosphit (10.9 g, 11.2 ml, 65.5 mmol) wurden unter Schutzgas gemischt und auf 60°C Ölbadtemperatur erwärmt (ohne Kühler), dabei entwich Chlorethan. Nach 40 Minuten Reaktionszeit wurde langsam mit Kühler erwärmt und anschließend für 3 Stunden bei 190°C gerührt. Anschließend wurde zunächst bei RT dann bei Erwärmung bis 190°C bei ca. 1 mbar getrocknet. Das Rohprodukt wurde in Ethylacetat aufgenommen, mit Wasser extrahiert und schließlich am Rotationsverdampfer erneut vom Lösungsmittel befreit: 13.11 g (90%) leicht bräunliches Öl. Reinheit: ca. 90%ig (¹H-NMR).
¹H NMR (400 MHz; CDCl₃): δ [ppm] = 7.50 (dd; 1 H; J₁ = 8.2, J₂ = 2.5 Hz; H-6), 7.28, 6.93 (AA'BB'; 4 H; H-phenyl), 7.24 (td; 1 H; J₁ = 8.2, J₂ = 2.2 Hz; H-5), 7.16 (m; 1 H; H-3), 3.97 (m; 10 H; P-O-CH₂, Aryl-O-CH₂), 3.17, 3.13 (jeweils: d; 2 H; J = 8 Hz; CH₂-P), 1.82 (m; 2 H; O-CH₂-CH₂), 1.54-1.33 (m; 6 H; H-alkyl), 1.25, 1.22 (jeweils: t; 6 H; J = 6.7 Hz; P-O-CH₂-CH₃), 0.92 (m; 3 H; CH₃).

### V. Synthese von Comonomeren

### Beispiel V1: Herstellung von 3,7-Dimethyloctyl-1-chlorid:

In einem 1 L Vierhalsrundkolben mit Tropftrichter, Intensivkühler und Magnetrührkem wurden 275 ml (1.46 mol) 3,7-Dimethyl-1-octanol vorgelegt und auf -3°C gekühlt. Dann wurden 0.7 ml Pyridin zugefügt und 129 ml (1.77 mol, 1.2 eq) Thionylchlorid so zugetropft, daß die Temperatur 15°C nicht überstieg (75 Minuten). Das entstehende HCl-Gas wurde in einer Waschflasche mit Ca(OH)₂/Wasser abgefangen. Dann wurde innerhalb von 40 Minuten aut 130°C erhitzt. Nach zwei Stunden bei dieser Temperatur wurde auf 50°C abgekühlt, flüchtige Bestandteile wurden durch Anlegen eines Vakuums von 100 mbar abdestilliert. Der Rückstand wurde nun auf Raumtemperatur abgekühlt, mit 200 ml n-Hexan verdünnt und zuerst zweimal mit je 50 ml 10%iger NaOH Lösung in Wasser, dann mit 50 ml Wasser und schließlich mit 50 ml gesättigter wäßriger NaHCO₃-Lösung gewaschen. Die Lösung wurde mit Na₂SO₄ getrocknet, das Lösungsmittel durch Destillation am Rotationsverdampfer entfernt. Der Rückstand wurde durch Destillation im Vakuum (13 mbar, 86-87°C) gereinigt. Man erhielt 178.9 g (1.01 mol, 69%) 3,7-Dimethyloctyl-1-chlorid als farbloses Öl.
Siedepunkt: 86-87°C, 13 mbar. ¹H NMR (400 MHz, CDCl₃): δ (ppm) = 3.61-3.49 (m, 2H, CH₂Cl); 1.82-1.74 (m, 1H); 1.69-1.48 (m, 3H); 1.37-1.21 (m, 3H); 1.19-1.09 (m, 3H); 0.89 (d, J = 6.7 Hz, 3H; CH₃); 0.87 (d, J = 6.7 Hz, 6H; 2 x CH₃).

### Beispiel V2: Herstellung von 1-Methoxy-4-(3,7-dimethyloctyloxy)benzol:

In einem 2 L Vierhalsrundkolben mit Tropftrichter, Intensivkühler, Gasableitung und Magnetrührkern wurden 184.4 g (1.48 mol) p-Methoxyphenol, 275.9 g (1.56 mol, 1.05 eq) 3,7-Dimethyloctyl-1-chlorid, 106.9 g KOH (85%ig, 1.62 mol, 1.09 eq) und 15.04 g Natrumiodid in 620 ml trockenem Ethanol gelöst und unter magnetischem Rühren 64 Stunden zum Sieden erhitzt. Es wurde auf Raumtemperatur abgekühlt und die Reaktionslösung wurde von dem angefallenen Feststoff abdekantiert. Die Reaktionslösung wurde im Rotationsverdampfer eingeengt. Der Feststoff wurde in 400 ml 10%iger wäßriger NaOH Lösung aufgenommen. Diese Lösung wurde zweimal mit je 400 ml Toluol extrahiert. Die organischen Phasen wurden vereinigt, mit 100 ml 10%iger wäßriger NaOH Lösung gewaschen und mit Na₂SO₄ getrocknet.
Das Lösungsmittel wurde im Vakuum im Rotationsverdampfer abdestilliert. Der Rückstand wurde im Vakuum (1 mbar) destilliert (Kopftemperatur: 159-162°C). Man erhielt 372.4 g (1.41 mol, 95%) 1-Methoxy-4-(3,7-dimethyloctyloxy)benzol als farbloses Öl.
Siedepunkt: 159-162°C/1 mbar. ¹H NMR (400 MHz, CDCl₃): δ (ppm) = 6.82 (d, J = 0.8 Hz, 4H; Hₐᵣₒₘ); 3.97-3.88 (m, 2H; OCH₂); 3.75 (s, 3H; OCH₃); 1.84-1.75 (m, 1H); 1.71-1.47 (m, 3H); 1.38-1.23 (m, 3H); 1.22-1.09 (m, 3H); 0.93 (d, J = 6.6 Hz, 6H; CH₃); 0.86 (d, J = 6.7 Hz, 6H; 2 x CH₃).

### Beispiel V3: Herstellung von 2,5-Bis(chlormethyl)-1-methoxy-4-(3,7-dimethyloctyloxy)benzol:

In einem 4 L Vierhalskolben mit mechanischem Rührer, Rückflußkühler, Thermometer und Tropftrichter wurden unter N₂ 304.96 g (1.03 mol) 1-(3,7-Dimethyloctyloxy)-4-methoxybenzol und 85.38 g (2.84 mol) Paraformaldehyd vorgelegt und mit 490 ml (580.6 g, 5.89 mol) 37proz. HCl versetzt; man erhielt eine gelbe Suspension. Daraufhin wurden 990 ml (1070 g, 10.5 mol) Essigsäureanhydrid so zugetropft, daß die Innentemperatur 70°C nicht überschritt (Dauer: 1.5 Std.). Die letzten 100 ml wurden auf einmal zugegeben; hierbei kam es zu einem Temperaturanstieg von 70°C auf 75°C; die Reaktionsmischung verfärbte sich von beigebraun nach rötlich. Der Ansatz wird 3.5 Stunden bei 70-75°C gerührt. Dann wurde unter Rühren auf Raumtemperatur abgekühlt, dabei kristallisierte bei 32°C ein heller Feststoff aus und es kam zu einem Temperaturanstieg auf 35°C. Der Ansatz wurde über Nacht bei Raumtemperatur stehengelassen, es schied sich dabei ein heller Feststoff ab. Das Reaktionsgemisch wurde mit 940 ml kalt gesättigter Na-Acetat-Lösung versetzt ( Dauer: ca. 15 min. ) 700 ml 25 %ige NaOH wurden nun so zugetropft, daß die Innentemperatur 30°C nicht überschritt (Dauer: ca. 35 min.). Der Ansatz wurde nun auf 52°C hochgeheizt (Dauer: ca. 30 min.) und dann unter schnellem Rühren im Eisbad abgekühlt (Dauer: ca. 30 min.). Der cremefarbene, kömige Feststoff wurde abgesaugt und mit 200 ml H₂O gewaschen. Der Feststoff (451g) wurde mit 2500 ml Hexan versetzt, bei Raumtemperatur gerührt und dann mit 300 ml kochendem H₂O versetzt Es wurde 20 Minuten gerührt und die wäßrige Phase abgetrennt. Die gelbliche org. Phase wurde noch 3x mit je 300 ml H₂O ausgerührt, der pH-Wert betrug 5. Die org. Phase wurde über Na₂SO₄ getrocknet und filtriert. Das Filtrat wurde eingeengt und' in der Tiefkühltruhe kristallisiert.
Der auskristallisierte Niederschlag (447 g) wurde abgesaugt, mit -20°C kaltem Hexan gewaschen und zur Umkristallisation in 1000 ml Hexan bei 60°C gelöst. Es wurde bei -20°C kristallisiert, der Feststoff abgesaugt und im Vakuum bei Raumtemperatur getrocknet. Man erhielt 279.6 g (0.774 mol, 75%)
2,5-Bis(chlormethyl)-1-methoxy-4-(3,7-dimethyloctyloxy)benzol als farblosen Feststoff. Schmelzpunkt: 65°C;
¹H NMR (400 MHz, CDCl₃): δ (ppm) = 6.92 (d, J = 2.0 Hz, 2H; Hₐᵣₒₘ); 4.63 (d, J = 2.6 Hz, 4 H; CH₂Cl); 4.07-3.98 (m, 2H; OCH₂); 3.85 (s, 3H; OCH₃); 1.88-1.80 (m, 1H); 1.76-1.66 (br. m, 1H); 1.65-1.49 (m, 2H); 1.40-1.26 (m, 3H); 1.23-1.12 (m, 3H); 0.95 (d, J = 6.8 Hz, 3H; CH₃); 0.87 (d, J = 6.8 Hz, 6H; 2 x CH₃). ¹³C NMR (100 MHz, CDCl₃): δ (ppm) = 151.0, 150.7 (C1, C4); 127.1, 126.8 (C2, C5); 114.4, 113.3 (C3, C6); 67.5 (OCH₂); 56.3 (OCH₃); 41.3 (2 x CH₂Cl); 39.2 (C2'); 37.3, 36.3 (C4', C6'); 29.9 (C3'); 28.0 (C7'); 24.7 (C5'); 22.7, 22.6, 19.7 (3 x CH₃).

### Beispiel V4: Herstellung von 1,4-Bis(3,7-dimethyloctyloxy)benzol:

In einem 2 L Vierhalsrundkolben mit Tropftrichter, Intensivkühler, Gaszuleitung und Magnetrührkem wurden 84.2 g KOH (85%ig, 1.28 mol, 1.28 eq) und 14.9 g Natrumiodid (0.10 mol) in 600 ml trockenem Ethanol gelöst. Hierbei stieg die Temperatur auf 35°C an. In die trübe Lösung wurden nun 55.1 g (0.50 mol) Hydrochinon zugegeben und 221 g 3,7-Dimethyloctyl-1-chlorid (1.25 mol, 1.25 eq) wurden langsam zugetropft. Die hellbraune Suspension wurde unter magnetischem Rühren 10 Stunden zum Sieden erhitzt. Es wurden nun weitere 21 g KOH (85%ig, 0.32 mol) und 55 g 3,7-Dimethyloctyl-1-chlorid (0.31 mol, 0.31 eq) zugesetzt. Man erhitzte dann weitere 84 Stunden zum Sieden.
Es wurde auf Raumtemperatur abgekühlt und die Reaktionslösung wurde im Rotationsverdampfer eingeengt. Der Feststoff wurde mit 500 ml Essigsäureethylester extrahiert. Diese Lösung wurde je dreimal mit je 200 ml 10%iger wäßriger NaOH Lösung und 200 ml Wasser gewaschen and dann mit MgSO₄ getrocknet. Das Lösungsmittel wurde im Vakuum im Rotationsverdampfer abdestilliert. Der Rückstand wurde im Vakuum (0.05 mbar) destilliert (Kopftemperatur: 166-170°C). Man erhielt 147.4 g (0.37 mol, 75%) 1,4-Bis(3,7-dimethyloctyloxy)benzol als farbloses Öl.
Siedepunkt: 166-170°C/0.05 mbar. ¹H NMR (400 MHz, CDCl₃): δ (ppm) = 6.82 (s, 4H; Hₐᵣₒₘ); 3.98-3.88 (m, 4H; OCH₂); 1.84-1.75 (m, 2H); 1.71-1.61 (br. m, 2H); 1.59-1.49 (m, 4H); 1.40-1.09 (m, 12H); 0.93 (d, J = 6.5 Hz, 6H; 2xCH₃); 0.86 (d, J = 6.5 Hz, 12H; 4 x CH₃).

### Beispiel V5: Herstellung von 2,5-Bis(chlormethyl)-1,4-bis(3,7-dimethyloctyloxy)benzol:

In einem 1 L Vierhalskolben mit mechanischem Rührer, Rückflußkühler, Thermometer und Tropftrichter wurden unter N₂ 58.6 g (150 mmol) 1,4-Bis(3,7-dimethyloctyloxy)benzol und 12.43 g (414 mmol) Paraformaldehyd vorgelegt und mit 71.4 ml (858 mmol) 37proz. HCI versetzt; man erhielt eine gelbe Suspension. Daraufhin wurden 144 ml (156 g, 1.53 mol) Essigsäureanhydrid so zugetropft, daß die Innentemperatur 70°C nicht überschritt ( Dauer: 2 Std.). Der Ansatz wurde 9 Stunden bei 70-75°C gerührt. Dann wurden nochmais 110 ml (119 g, 1.17 mol) Essigsäureanhydrid zugesetzt und es wurde nochmals 8 Stunden bei 70-75°C gerührt. Dann wurde unter Rühren auf Raumtemperatur abgekühlt, dabei kristallisierte ein heller Feststoff aus. Das Reaktionsgemisch wird mit 240 ml kalt gesättigter Na-Acetat-Lösung versetzt ( Dauer: ca. 15 min. ) und 100 ml 25 %ige NaOH wurden nun so zugetropft, daß die Innentemperatur 30°C nicht überschreitet ( Dauer: ca. 35 min.). Der körnige Feststoff wurde abfiltriert und zwischen 300 ml Hexan und 300 ml Wasser verteilt. Die org. Phase wird über Na₂SO₄ getrocknet und filtriert. Das Filtrat wurde eingeengt und im Kühlschrank kristallisiert.
Es wurde nochmals aus 170 ml Hexan umkristallisiert (waschen mit -20°C kaltem Hexan). Man erhielt 28.3 g (58.0 mmol, 39%) 2,5-Bis(chlormethyl)-1,4-bis(3,7-dimethyloctyloxy)benzol als farblosen Feststoff. Schmelzpunkt: 55°C;
¹H NMR (400 MHz, CDCl₃): δ (ppm) = 6.92 (s, 2H; Hₐᵣₒₘ); 4.62 (s, 4 H; CH₂Cl); 4.07-3.97 (m, 4H; OCH₂); 1.88-1.80 (m, 2H); 1.76-1.66 (br. m, 2H); 1.65-1.49 (m, 4H); 1.40-1.13 (m, 12H); 0.95 (d, J = 6.5 Hz, 6H; 2 x CH₃); 0.87 (d, J = 6.8 Hz, 12H; 2 x CH₃).

### Teil 2: Synthese und Charakterisierung der Polymere:

### A. Synthese von Copolymeren

### Beispiel A1:

### Copolymer aus 50% 2,5-Bis(chlormethyl)-1-methoxy-4-(3,7-dimethyloctyloxy)benzol und 50% 2,5-Bis(chlormethyl)-4'-(3,7-dimethyloctyloxy)biphenyl (Polymer A1):

### Herstellung von Poly(2-methoxy-5-(3,7-dimethyloctyloxy)-p-phenylenvinylen)co-(2-(4'-(3,7-dimethyloctyloxy)phenyl)-p-phenylenvinylen).

In einem trockenen 6 L Vierhalskolben mit mechanischem Teflonrührer, Rückflußkühler, Thermometer und Tropftrichter wurden 3400 ml trockenes und O₂-freies 1,4-Dioxan auf 97°C erhitzt. Dann wurde eine Lösung von 8.44 g (23.35 mmol) 2,5-Bis(chlormethyl)-1-methoxy-4-(3,7-dimethyloctyloxy)benzol und 9.52 g (23.35 mmol) 2,5-Bis(chlormethyl)-4'-(3,7-dimethyloctyloxy)biphenyl in 50 ml trockenem 1,4-Dioxan zugesetzt. Nun wurde eine Lösung von 13.10 g (117 mmol) Kalium-tert.-butylat in 117 ml trockenem 1,4-Dioxan innerhalb von 5 Minuten zu der intensiv gerührten Mischung getropft. Die Farbe veränderte sich dabei von farblos über gelb nach orangerot. Nach 5 Minuten wurden weitere 10.48 g (93 mmol) Kalium-tert-butylat, gelöst in 93 ml 1,4-Dioxan, zugegeben. Nach 2 Stunden Rühren bei 95-97°C wurde auf 45°C abgekühlt und ein Gemisch aus 19 ml Essigsäure und 20 ml 1,4-Dioxan zu-gesetzt. Die nun orange Lösung wurde auf 4 L intensiv gerührtes Wasser gegossen. Das ausgefallene Polymer wurde durch Filtration durch einen Polypropylenfilter isoliert und im Vakuum getrocknet Die Rohausbeute betrug 12.65 g (40.6 mmol, 87%).
Das Polymer wurde unter Erhitzen auf 60°C in 1690 ml THF gelöst und durch Zusatz von 1700 ml Methanol bei 40°C gefällt. Nach Trocknen im Vakuum wurde dieser Schritt wiederholt. Man erhielt nach Trocknung im Vakuum 7.10 g (= 22.79 mmol, 49 %) des Polymers A1 als hell-orange Fasern.
¹H NMR (400 MHz, CDCl₃): δ (ppm) = 7.9-6.9 (br. m, 6.5 H); 4.2-3.6 (br. m, 3.5 H); 2.0-0.9 (br. m, 10H); 0.89, 0.86 (2 s, 9H).
GPC: THF + 0.25% Oxalsäure; Säulensatz SDV500, SDV1000, SDV10000 (Fa. PSS), 35°C, UV Detektion 254 nm. Polystyrol-Standard: M_{w} = 1.5×10⁶ g/mol, Mₙ = 2.8×10⁵ g/mol.

### Beispiel A2:

### Copolymer aus 50% 2,5-Bis(chlormethyl)-1-methoxy-4-(3,7-dimethyloctyloxy)benzol und 50% 2,5-Bis(chlormethyl)-3'-(3,7-dimethyloctyloxy)biphenyl (Polymer A2):

### Herstellung von Poly(2-methoxy-5-(3,7-dimethyloctyloxy)-p-phenylenvinylen)co-(2-(3'-(3,7-dimethyloctyloxy)phenyl)-p-phenylenvinylen).

In einem trockenen 6 L Vierhalskolben mit mechanischem Rührer, Rückflußkühler, Thermometer und Tropftrichter wurden 3.5 L trockenes und O₂-freies 1,4-Dioxan vorgelegt und unter Rühren auf 95°C erhitzt. Dann wurden 9.00 g (24.9 mmol) 2,5-Bis(chlormethyl)-1-methoxy-4-(3,7-dimethyloctyloxy)benzol und 10.13 g (24.9 mmol) 2,5-Bis(chlormethyl)-3'-(3,7-dimethyloctyloxy)biphenyl, gelöst in 30 ml trockenem 1,4-Dioxan, zugesetzt. Nun wurde eine Lösung von 13.97 g (124.5 mmol, 2.5 eq) Kalium-*tert*-butylat in 125 ml trockenem 1,4-Dioxan innerhalb von 5 Minuten zu der intensiv gerührten Mischung getropft. Die Farbe veränderte sich dabei von farblos über gelb nach orangerot. Nach 5 Minuten Rühren bei 95-96°C wurde nochmals dieselbe Menge (13.97 g, 124.5 mmol, 2.5 eq) Kalium-tert-butylat in 125 ml 1,4-Dioxan innerhalb von einer Minute zugesetzt. Nach weiteren 2 Stunden Rühren bei 95°-97°C wurde auf 55°C abgekühlt und ein Gemisch aus 30 ml Essigsäure und 30 ml 1,4-Dioxan zugesetzt. Zu der nun hell-orangen Lösung wurden unter intensivem Rühren 1.8 L Wasser innerhalb von 5 Minuten zugegeben. Das ausgefallene Polymer wurde abfiltriert und zweimal mit je 100 ml Methanol gewaschen. Nach Vakuumtrocknung wurden 14.1 g rohes Polymer erhalten.

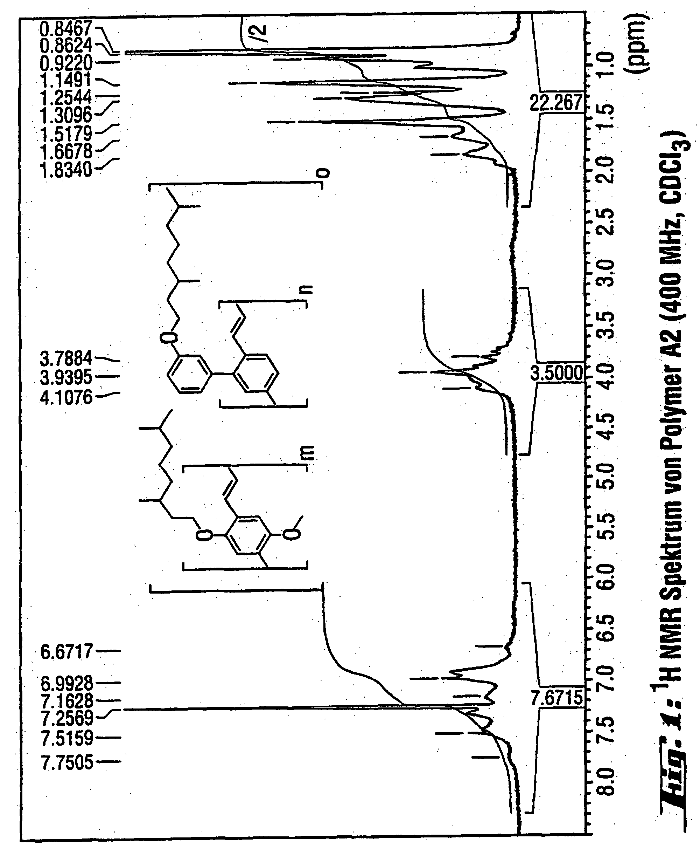

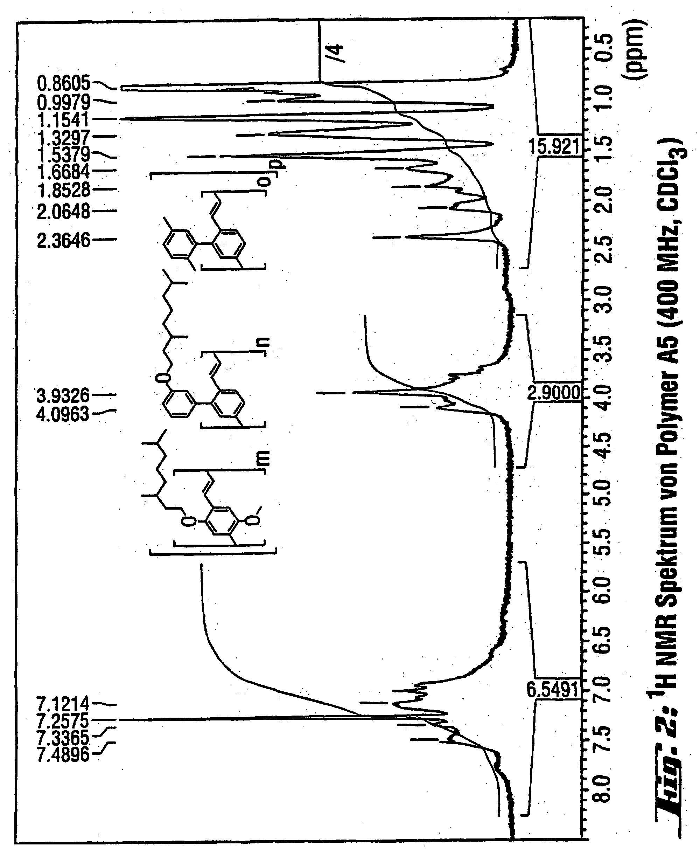

Das Rohprodukt wurde unter Erhitzen auf 60°C in 1.8 L THF gelöst und durch Zusatz von 2 L Methanol gefällt. Nach Trocknen im Vakuum und Waschen mit 200 ml Methanol wurde dieser Schritt wiederholt. Man erhielt nach zweitägiger Trocknung im Vakuum 10.80 g (= 34.7 mmol, 70%) des Polymer A2 als hell-orange Fasern.
¹H NMR (400 MHz, CDCl₃): δ (ppm) = 7.9-6.6 (br. m; 6.5 H); 4.2-3.6 (br. m, 3.5 H); 2.0-0.95 (br. m, 10H); 0.86, 0.84 (2 s, 9H).
GPC: THF + 0.25% Oxalsäure; Säulensatz SDV500, SDV1000, SDV10000 (Fa. PSS), 35°C, UV Detektion 254 nm, Polystyrol-Standard: M_{w} = 7.4×10⁵ g/mol, Mₙ = 7×10⁴ g/mol.
Das ¹H NMR dieses Polymers ist in Figur 1 wiedergegeben.

### Beispiel A3:

### Copolymer aus 50% 2,5-Bis(chlormethyl)-1-methoxy-4-(3,7-dimethyloctyloxy)benzol und 50% 2,5-Bis(chlormethyl)-2',5'-dimethylbiphenyl (Polymer A3):

### Herstellung von Poly(2-methoxy-5-(3,7-dimethyloctyloxy)-p-phenylenvinylen)co-(2-(2',5'-dimethyl)phenyl)-p-phenylenvinylen).

In einem ausgeheizten 6 L Vierhalskolben mit mechanischem Teflonrührer, Rückflußkühler, Thermometer und Tropftrichter wurden 3.5L trockenes 1,4-Dioxan vorgelegt, durch 15 minütiges Durchleiten von N₂ entgast und dann unter Rühren auf 95°C erhitzt., Dann wurden 9.00 g (24.9 mmol) 2,5-Bis(chlormethyl)-1-methoxy-4-(3,7-dimethyloctyloxy)benzol und 6.95 g (24.9 mmol) 2,5-Bis(chlormethyl)-2',5'-dimethylbiphenyl, gelöst in 30 ml trockenem 1,4-Dioxan, zugesetzt. Nun wurde eine Lösung von 13.97 g (124.5 mmol, 2.5 eq) Kalium-tert-butylat in 125 ml trockenem 1,4-Dioxan innerhalb von 5 Minuten zu der intensiv gerührten Mischung getropft. Nach weiteren 5 Minuten Rühren bei 95°C wurde nochmals dieselbe Menge (13.97 g, 124.5 mmol, 2.5 eq) Kalium-tert-butylat in 125 ml 1,4-Dioxan innerhalb von einer Minute zugesetzt. Die Temperatur wurde weitere 2 Stunden zwischen 95 und 98°C gehalten; nach dieser Zeit wurde auf 55°C abgekühlt und ein Gemisch aus 30 ml Essigsäure und 30 ml 1,4-Dioxan wurde zugesetzt. Die Farbe der Reaktionsmischung veränderte sich dabei von hell-rot nach hell-orange. Zu der Mischung wurden 1.8 L Wasser innerhalb von 2 Minuten zugesetzt. Das hierbei flockig ausgefallene Polymer wurde abfiltriert, zweimal mit je 200 ml Methanol gewaschen und im Vakuum bei Raumtemperatur getrocknet. Man erhielt 11.1 g rohes Polymer.

Das Rohprodukt wird unter Erhitzen auf 60°C in 1.5 L THF gelöst und durch Zutropfen von 1.5 L Methanol gefällt. Nach Trocknen im Vakuum und Waschen mit 300 ml Methanol wird dieser Schritt wiederholt. Man erhielt nach zweitägiger Trocknung im Vakuum 6.60 g (= 26.7 mmol, 54%) des Polymer A3 als hell-oranges Pulver.
¹H NMR (400 MHz, CDCl₃): δ (ppm) = 7.9-6.1 (br. m; 6 H); 4.2-3.4 (br. m, 2.5 H); 2.35 (br. s, 1.5 H); 2.1-0.95 (br. m, 6.5 H); 0.85 (br. s, 4.5 H).
GPC: THF + 0.25% Oxals.; Säulensatz SDV500, SDV1000, SDV10000 (Fa. PSS), 35°C, UV Detektion 254 nm, Polystyrol-Standard: M_{w} = 6.2×10⁵ g/mol, Mₙ = 9×10⁴ g/mol.

### Beispiel A4:

### Copolymer aus 50% 2,5-Bis(chlormethyl)-1-methoxy-4-(3',7'-dimethyloctyloxy)benzol und 50% 2,5-Bis(brommethyl)-2',5'-dimethylbiphenyl (Polymer A4):

### Herstellung von Poly(2-methoxy-5-(3,7-dimethyloctyloxy)-p-phenylenvinylen)co-(2-(2',5'-dimethyl)phenyl)-p-phenylenvinylen).

In einem getrockneten 2 L Vierhalskolben mit mechanischem Teflonrührer, Intensivkühler, Thermometer und Tropftrichter wurden 1160 g (= 1.12 L) trockenes 1,4-Dioxan vorgelegt, durch 15 minütiges Durchleiten von N₂ entgast und dann unter Rühren zum Rückfluß (98°C) erhitzt. Anschließend wurden 3.50 g (9.68 mmol) 2,5-Bis(chlormethyl)-1-methoxy-4-(3',7'-dimethyloctyloxy)benzol und 3.56 g (9.68 mmol) 2,5-Bis(brommethyl)-2',5'-dimethylbiphenyl, gelöst in 30 ml trockenem 1,4-Dioxan, zugesetzt. Nun wurde eine Lösung von 5.61 g (50 mmol, 2.6 eq) Kalium-*tert*-butylat in 50 ml getrocknetem 1,4-Dioxan innerhalb von 5 Minuten zu der intensiv gerührten Mischung getropft. Während der Zugabe der Base wurde folgender Farbumschlag beobachtet: farblos-grün-gelb-orangerot. Nach weiteren 5 Minuten Rühren bei dieser Temperatur wurden nochmals 4.90 g (43.7 mmol, 2.25 eq) Kalium-tert-butylat in 50 ml trockenem 1,4-Dioxan innerhalb von einer Minute zugesetzt. Die Temperatur wurde weitere 2 Stunden bei 95-98°C gehalten; nach dieser Zeit wurde auf 50°C abgekühlt und ein Gemisch aus 7.5 ml Essigsäure und 7.5 ml 1,4-Dioxan zugesetzt. Die Farbe der Reaktionsmischung hellte sich dabei etwas auf. Nach 20 Minuten Rühren wurde die Reaktionsmischung auf 1.2 L intensiv gerührtes Wasser gegossen. Es wurde mit 100 ml Methanol versetzt and noch 20 Minuten gerührt. Nach Filtration über einen Polypropylenrundfilter erhielt man 4.90 g (18.7 mmol, 96%) rohes Polymer als hell-orange Flocken.

Nach Trocknung im Vakuum bei Raumtemperatur erfolgte die Reinigung durch zweimaliges Lösen in 500 ml THF und Ausfällen mit 500 ml Methanol. Nach Trocknen erhielt man 2.92 g (11.2 mmol, 58%) Polymer A4.
¹H NMR (400 MHz, CDCl₃): δ (ppm) = 7.9-6.1 (br. m; 6 H); 4.2-3.5 (br. m, 2.5 H); 2.35 (br. s, 1.5 H); 2,1-0.95 (br. m, 6.5 H); 0.85 (s, 4.5 H; 3 x CH₃).
GPC: THF + 0.25% Oxals.; Säulensatz SDV500, SDV1000, SDV10000 (Fa. PSS). 35°C, UV Detektion 254 nm, Polystyrol-Standard: M_{w} = 3.6×10⁵ g/mol, Mₙ = 8.4×10⁴ g/mol.

### Beispiel A5:

### Temäres Copolymer aus 50% 2,5-Bis(chlormethyl)-1-methoxy-4-(3,7-dimethyloctyloxy)benzol, 30% 2,5-Bis(chlormethyl)-2',5'-dimethylbiphenyl und 20% 2,5-Bis(chlormethyl)-3'-(3,7-dimethyloctyloxy)biphenyl (Polymer A5):

### Herstellung von Poly(2-methoxy-5-(3,7-dimethyloctyloxy)-p-phenylenvinylen)co-(2-(3'-(3,7-dimethyloctyloxy)phenyl)-p-phenylenvinylen)co-(2-(2',5'-dimethyl)phenyl)-p-phenylenvinylen).

In einem trockenen 4 L Vierhalskolben mit mechanischem Rührer, Rückflußkühler, Thermometer und Tropftrichter wurden 2.38 kg (2.30 L) trockenes und O₂-freies 1,4-Dioxan vorgelegt und unter Rühren auf 98°C erhitzt. Dann wurde eine Lösung von 5.96 g (16.5 mmol) 2,5-Bis(chlormethyl)-1-methoxy-4-(3,7-dimethyloctyloxy)benzol, 2.29 g (6.60 mmol) 2,5-Bis(chlormethyl)-3'-(3,7-dimethyloctyloxy)biphenyl und 2.76 9 (9.90 mmol) 2,5-Bis(chlormethyl)-2',5'-dimethylbiphenyl, gelöst in 30 ml trockenem 1,4-Dioxan, zugesetzt. Nun wurde eine Lösung von 9.58 g (85.4 mmol, 2.6 eq) Kalium-*tert*-butylat in 86 ml trockenem 1,4-Dioxan innerhalb von 5 Minuten zu der intensiv gerührten Mischung getropft. Die Farbe veränderte sich dabei von farblos über grün nach hell-orange; die Viskosität der Lösung nahm leicht zu. Nach 5 Minuten Rühren bei 98°C wurden nochmals 7.68 g (68.4 mmol, 2.1 eq) Kalium-tert-butylat in 100 ml 1,4-Dioxan innerhalb von einer Minute zugesetzt. Nach weiteren 2 Stunden Rühren bei 95°-98°C wurde auf 50°C abgekühlt und ein Gemisch aus 12.5 ml Essigsäure und 12.5 ml 1,4-Dioxan zugesetzt. Das Polymer wurde nach 20 Minuten Nachrühren durch Zusetzen der Reaktionslösung zu 2.1 L intensiv gerührtem Wasser ausgefällt. Das so erhaltene Polymer wurde abfiltriert und zweimal mit je 100 ml Methanol gewaschen. Nach Vakuumtrocknung bei Raumtemperatur wurden 8.85 g (32.4 mmol, 98%) rohes Polymer erhalten.

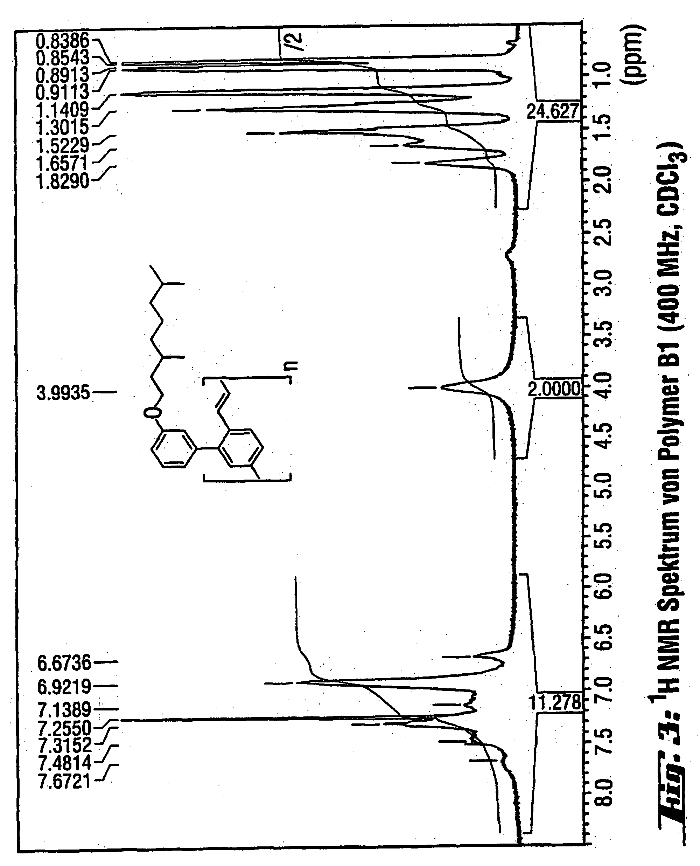

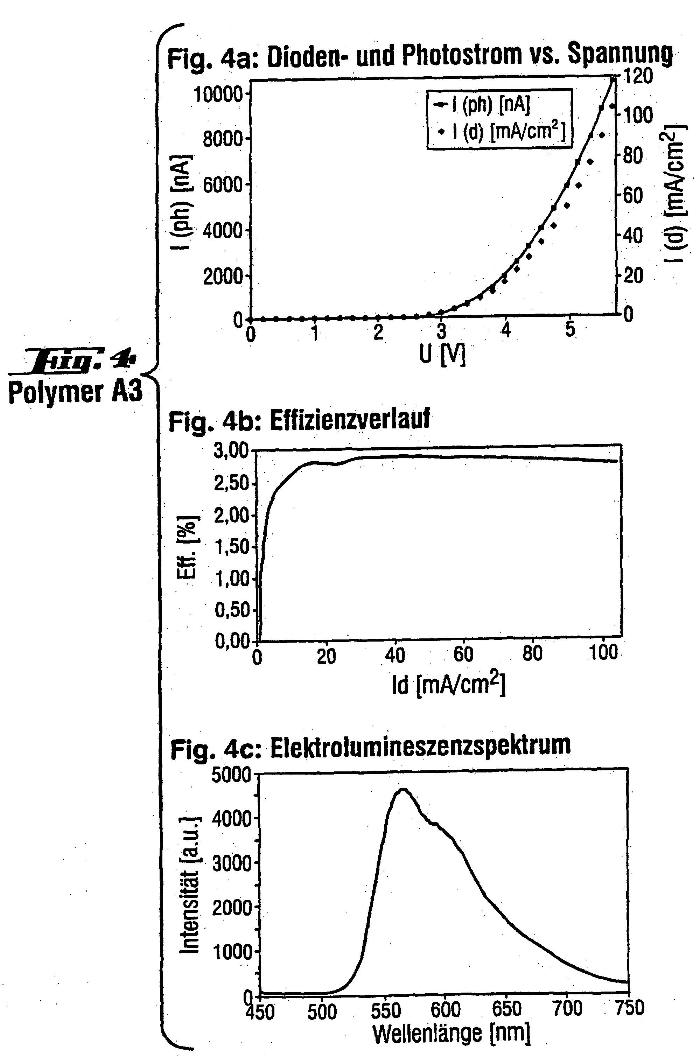

Das Rohprodukt wurde unter Erhitzen auf 60°C in 980 ml THF gelöst und durch Zusatz von 1 L Methanol gefällt. Nach Trocknen im Vakuum und Waschen mit 100 ml Methanol wurde dieser Schritt wiederholt. Man erhielt nach zweitägiger Trocknung im Vakuum 5.85 g (= 21.4 mmol, 65 %) des Polymer A5 als hell-orange Fasern.
¹H NMR (400 MHz, CDCl₃): δ (ppm) = 7.9-6.1 (br. m; 6.2 H); 4.2-3.5 (br. m, 2.9 H); 2.36 (br. s, 0.9 H); 2.1-1.05 (br. m, 7.9 H); 0.86 (br. s, 6.3 H).
GPC: THF + 0.25% Oxals.; Säulensatz SDV500, SDV1000, SDV10000 (Fa. PSS), 35°C, UV Detektion 254 nm, Polystyrol-Standard: M_{w} = 9.8×10⁵ g/mol, Mₙ = 9×10⁴ g/mol.
Das ¹H NMR dieses Polymers ist in Figur 2 wiedergegeben.

### Beispiel A6:

### Ternäres Copolymer aus 4% 2,5-Bis(chlormethyl)-1,4-bis(3,7-dimethyloctyloxy)benzol, 48% 2,5'-Bis(chlormethyl)-3'-(3,7-dimethyloctyloxy)biphenyl und 48% 2,5-Bis(chlormethyl)-4'-(3,7-dimethyloctyloxy)biphenyl(Polymer A6):

### Herstellung von Poly(2,5-bis(3,7-dimethyloctyloxy)-p-phenylenvinylen)co(2-(3'-(3,7-dimethyloctyloxy)phenyl)-p-phenylenvinylen)phenylenvinylen)co(2-(4'-(3,7-dimethyloctyloxy)phenyl)-p-phenylenvinylen)phenylenvinylen)

In einem trockenen 6 L Vierhalskolben mit mechanischem Rührer, Rückflußkühler, Thermometer und Tropftrichter wurden 3.53 kg (3.41 L) trockenes und O₂-freies 1,4-Dioxan vorgelegt und unter Rühren auf 99°C erhitzt. Dann wurde eine Lösung von 975 mg (2.0 mmol) 2,5-Bis(chlormethyl)-1,4-bis(3,7-dimethyloctyloxy)benzol, 9.77 g (24 mmol)2,5-Bis(chlormethyl)-3'-(3,7-dimethyloctyloxy)biphenyl sowie 9.77 g (24 mmol) 2,5-Bis(chlormethyl)-4'-(3,7-dimethyloctyloxy)biphenyl, gelöst in 50 ml trockenem 1,4-Dioxan, zugesetzt. Dann wurde unter Lichtausschluß eine Lösung von 14.59 g (130 mmol, 2.6 eq) Kalium-tert-butylat in 130 ml trockenem 1,4-Dioxan innerhalb von 5 Minuten zu der intensiv gerührten Mischung getropft.
Die Lösung verfärbt sich nach gelb-orange. Nach 5 Minuten Rühren bei 98°C wurden nochmals 11.21 g (100 mmol, 2.0 eq) Kalium-tert-butylat in 100 ml 1,4-Dioxan innerhalb von zwei Minuten zugesetzt. Nach weiteren 2 Stunden Rühren bei 98°-100°C wurde auf 50°C abgekühlt und ein Gemisch aus 13 ml Essigsäure und 13 ml 1,4-Dioxan wurden zugesetzt. Das Polymer wurde nach 10 Minuten Nachrühren durch Zusetzen der Reaktionslösung zu 3.7 L intensiv gerührtem Wasser ausgefällt. Das so erhaltene Polymer wurde abfiltriert und zweimal mit je 300 ml Methanol gewaschen. Nach Vakuumtrocknung bei Raumtemperatur wurden 12.2 g (36.1 mmol, 72%) rohes Polymer A6 als orange Fasern erhalten.

Das Rohprodukt wurde unter Erhitzen auf 60°C in 1360 ml THF gelöst und durch Zusatz von 1.4 L Methanol innerhalb von 2 h gefällt. Nach Trocknen im Vakuum und Waschen mit 200 ml Methanol wurde dieser Schritt wiederholt (1100 ml THF/1100 ml Methanol). Man erhielt nach zweitägiger Trocknung im Vakuum 8.47 g (= 25 mmol, 50 %) des Polymer A6 als hell-orange Fasern.
¹H NMR (400 MHz, CDCl₃): δ (ppm) = 7.9-6.6 (br. m; ca. 9 H); 4.0 (br. s, ca. 2 H); 1.9-0.9 (br. m, ca. 10H); 0.88, 0.87, 0.85, 0.84 (4 s, 9H).
GPC: THF + 0.25% Oxals.; Säulensatz SDV500, SDV1000, SDV10000 (Fa. PSS), 35°C, UV Detektion 254 nm, Polystyrol-Standard: M_{w} = 2.2x10⁵ g/mol,
Mₙ = 1.6x10⁴ g/mol.

### Beispiel A7:

### Copolymer aus 99% 2,5-Bis(chlormethyl)-1-methoxy-4-(3,7-dimethyloctyloxy)benzol und 1% 2,5-Bis(chlormethyl)-4'-(3,7-dimethyloctyloxy)biphenyl (Polymer A7):

### Herstellung von Poly(2-methoxy-5-(3,7-dimethyloctyloxy)-p-phenylenvinylen)co(2-(4'-(3,7-dimethyloctyloxy)phenyl)-p-phenylenvinylen).

In einem ausgeheitzten 6 L Vierhalskolben mit mechanischem Teflonrührer, Rückflußkühler, Thermometer und Tropftrichter wurden 3530 g trockenes und O₂-freies 1,4-Dioxan auf 99°C erhitzt. Dann wurde Lösung von 20.78 g (57.5 mmol) 2,5-Bis(chlormethyl)-1-methoxy-4-(3,7-dimethyloctyloxy)benzol und 0.24 g (0.58 mmol) 2,5-Bis(chlormethyl)-4'-(3,7-dimethyloctyloxy)biphenyl in 30 g trockenem 1,4-Dioxan zugesetzt. Nun wurde eine Lösung von 16.8 g (150 mmol) Kalium-tert-butylat in 150 ml trockenem 1,4-Dioxan innerhalb von 5 Minuten zu der intensiv gerührten Mischung getropft. Die Farbe veränderte sich dabei von farblos über gelb nach orangerot. Nach 5 Minuten wurden weitere 13.46 g (120 mmol) Kalium-tert-butylat, gelöst in 120 ml 1,4-Dioxan, zugegeben. Nach 2 Stunden Rühren bei 95-97°C wurde auf 50°C abgekühlt und ein Gemisch aus 13 ml Essigsäure und 13 ml 1,4-Dioxan wurde zugesetzt. Die nun orange Lösung wurde auf 1.85 L intensiv gerührtes Wasser gegossen. Das ausgefallene fasrige Polymer wurde durch Filtration durch einen Polypropylenfilter isoliert, zweimal mit Methanol gewaschen und im Vakuum getrocknet. Die Rohausbeute lag bei 12.87 g (44.6 mmol, 77%).
Das Polymer wurde unter Erhitzen auf 60°C in 1430 ml THF gelöst und durch Zusatz der gleichen Menge Methanol bei 40°C gefällt. Nach Waschen mit Methanol und Trocknen im Vakuum wurde dieser Schritt wiederholt. Man erhielt nach Trocknung im Vakuum 7.52 g (= 26.06 mmol, 49%) des Polymer A7 als hell-orange Fasern.
¹H NMR (400 MHz, CDCl₃): δ (ppm) = 7.7-6.5 (br. m, 4 H; Hₐᵣₒₘ, Olefin-H); 4.5-3.6 (br. m, 5 H; OCH_{3,} OCH₂); 2.1-0.6 (br. m, 19H; aliph. H).
GPC: THF + 0.25% Oxals.; Säulensatz SDV500, SDV1000, SDV10000 (Fa. PSS), 35°C, UV Detektion 254 nm, Polystyrol-Standard: M_{w} = 1.4×10⁶ g/mol, Mₙ = 2.6×10⁵ g/mol.

### Beispiel A8:

### Copolymer aus 95% 2,5-Bis(chlormethyl)-1-methoxy-4-(3,7-dimethyloctyloxy)benzol und 5% 2,5-Bis(chlormethyl)-4'-(3,7-dimethyloctyloxy)biphenyl (Polymer A8):

### Herstellung von Poly(2-methoxy-5-(3,7-dimethyloctyloxy)-p-phenylenvinylen)co(2-(4'-(3,7-dimethyloctyloxy)phenyl)-p-phenylenvinylen).

In einem ausgeheitzten 6 L Vierhalskolben mit mechanischem Teflonrührer, Rückflußkühler, Thermometer und Tropftrichter wurden 3530 g trockenes und O₂-freies 1,4-Dioxan auf 99°C erhitzt. Dann wurde Lösung von 19.95 g (55.2 mmol) 2,5-Bis(chlormethyl)-1-methoxy-4-(3,7-dimethyloctyloxy)benzol und 1.18 g (2.9 mmol) 2,5-Bis(chlormethyl)-4'-(3,7-dimethyloctyloxy)biphenyl in 30 g trockenem 1,4-Dioxan zugesetzt. Nun wurde Lösung von 16.8 g (150 mmol) Kalium-tert-butylat in 150 ml trockenem 1,4-Dioxan innerhalb von 5 Minuten zu der intensiv gerührten Mischung getropft. Die Farbe veränderte sich dabei von farblos über gelb nach orangerot. Nach 5 Minuten wurden weitere 13.46 g (120 mmol) Kalium-tert-butylat, gelöst in 120 ml 1,4-Dioxan, zugegeben. Nach 2 Stunden Rühren bei 95-97°C wurde auf 50°C abgekühlt und ein Gemisch aus 13 ml Essigsäure und 13 ml 1,4-Dioxan wurde zugesetzt. Die nun orange Lösung wurde auf 3.7 L intensiv gerührtes Wasser ge-gossen. Das ausgefallene fasrige Polymer wurde durch Filtration durch einen Polypropylenfilter isoliert, zweimal mit Methanol gewaschen und im Vakuum getrocknet. Die Rohausbeute lag bei 10.68 g (29.4 mmol, 51%).
Das Polymer wurde unter Erhitzen auf 60°C in 1420 ml THF gelöst und durch Zusatz der gleichen Menge Methanol bei 40°C gefällt. Nach Waschen mit Methanol und Trocknen im Vakuum wurde dieser Schritt wiederholt (1000 ml THF/1000 ml Methanol). Man erhielt nach Trocknung im Vakuum 7.00 g (= 19.2 mmol, 33%) des Polymer A8 als hell-orange Fasern.
¹H NMR (400 MHz, CDCl₃): δ (ppm) = 7.7-6.5 (br. m, 4 H; Hₐᵣₒₘ, Olefin-H); 4.5-3.6 (br. m, 5 H; OCH₃, OCH₂); 2.1-0.6 (br. m, 19H; aliph. H).
GPC: THF + 0.25% Oxals.; Säulensatz SDV500, SDV1000, SDV10000 (Fa. PSS), 35°C, UV Detektion 254 nm, Polystyrol-Standard: M_{w}= 1.4×10⁶ g/mol,
Mₙ = 2.4×10⁵ g/mol.

### Beispiel A9:

### Copolymer aus 82% 2,'5-Bis(chlormethyl)-1-(3,7-dimethyloctyloxy)-4-methoxybenzol und 18% 2,5-Bis(chlormethy)-3'-(3,7-dimethyloctyloxy)-4-methoxybiphenyl (Polymer A9):

### Herstellung von Poly(2-(3,7-dimethyloctyloxy)-5-methoxy-p-phenylenvinylen)co(2-(3'-(3,7-dimethyloctyloxy)phenyl)-5-methoxy-p-phenylenvinylen).

In einem trockenen 1 L Vierhalskolben mit mechanischem Teflonrührer, Rückflußkühler, Thermometer und Tropftrichter wurden 540 ml trockenes und O₂-freies 1,4-Dioxan auf 98°C erhitzt. Dann wurde eine Lösung von 2.37 g (6.56 mmol) 2,5-Bis(chlormethyl)-1-(3,7-dimethyloctyloxy)-4-methoxybenzol und 0.630 g (1.44 mmol) 2,5-Bis(chlormethyl)-3'-(3,7-dimethyloctyloxy)-4-methoxybiphenyl in 10 ml trockenem 1,4-Dioxan zugesetzt. Nun wurde eine Lösung von 2.47 g (22 mmol) Kalium-tert-butylat in 22 ml trockenem 1,4-Dioxan innerhalb von 5 Minuten zu der intensiv gerührten Mischung getropft. Die Farbe veränderte sich dabei von farblos über gelb nach orangerot. Nach 5 Minuten wurden weitere 2,47 g (22 mmol) Kalium-tert-butylat, gelöst in 22 ml 1,4-Dioxan, zugegeben. Nach 2 Stunden Rühren bei 98-99°C wurde auf 42°C abgekühlt. Ein Gemisch aus 6 ml Essigsäure und 6 ml 1,4-Dioxan wurde nun zugesetzt. Die orange trübe Lösung wurde auf 0.6 L intensiv gerührtes Wasser gegossen. Das flockig ausgefallene Polymer wurde durch Filtration durch einen Polypropylenfilter isoliert und im Vakuum getrocknet. Die Rohausbeute betrug 2.46 g (6.56 mmol, 82%).
Das Polymer wurde unter Erhitzen auf Rückfluß in 330 ml THF gelöst. Es wurde durch Zutropfen von 350 ml Methanol gefällt. Nach Trocknen im Vakuum wurde in 300 ml THF gelöst und durch Zugabe von 300 ml Methanol gefällt. Man erhielt nach Waschen mit Methanol und Trocknung im Vakuum 1.62 g (= 4.32 mmol, 54%) von Polymer A09 als orange Fasern.
¹H NMR (400 MHz, CDCl₃): δ (ppm) = 7.9-6.5 (br. m, 4.7 H); 4.4-3.6 (br. m, 5 H); 2.0-0.7 (br. m, 19 H).
Aufgrund der Neigung von Polymer A09 zur Gelbildung konnte keine GPC Messung vorgenommen werden.

### Beispiel A10:

### Copolymer aus 50% 2,5-Bis(chlormethyl)-4'-(3,7-dimethyloctyloxy)biphenyl und 50% 2,5-Bis(chlormethyl)-3'-(3,7-dimethyloctyloxy)biphenyl (Polymer A10):

### Herstellung von Poly(2-(3'-(3,7-dimethyloctyloxy)phenyl)-p-phenylenvinylen))co(2-(4'-(3,7-dimethyloctyloxy)phenyl)-p-phenylenvinylen).

In einem trockenen 2 L Vierhalskolben mit mechanischem Rührer, Rückflußkühler, Thermometer und Tropftrichter wurden 890 ml trockenes und O₂-freies 1,4-Dioxan vorgelegt und unter Rühren auf 98°C erhitzt. Dann wurden 2.45 g (6.00 mmol) 2,5-Bis(chlormethyl)-4'-(3,7-dimethyloctyloxy)biphenyl und 2.45 g (6.00 mmol) 2,5-Bis(chlormethyl)-3'-(3,7-dimethyloctyloxy)biphenyl, gelöst in 20 ml trockenem 1,4-Dioxan, zugesetzt. Nun wurde eine Lösung von 3.37 g (30 mmol, 2.5 eq) Kalium-tert-butylat in 30 ml trockenem 1,4-Dioxan innerhalb von 5 Minuten zu der intensiv gerührten Mischung getropft: Die Farbe veränderte sich dabei von farblos über gelb nach gelb-grün. Nach 5 Minuten Rühren bei 97-98°C wurden nochmals 2.69 g, 24 mmol, 2.0 eq) Kalium-tert-butylat in 24 ml 1,4-Dioxan innerhalb von einer Minute zugesetzt. Nach weiteren 2 Stunden Rühren bei 95°-97°C wurde auf 40°C abgekühlt und ein Gemisch aus 5 ml Essigsäure und 5 ml 1,4-Dioxan wurde zugesetzt. Die Lösung wurde unter intensivem Rühren auf 1 L Wasser gegossen. Das ausgefallene Polymer wurde abfiltriert, einmal mit 50 ml Wasser/Methanol 1:1 und zweimal mit je 50 ml Methanol gewaschen. Nach Vakuumtrocknung wurden 4.05 g rohes Polymer erhalten.

Das Rohprodukt wurde unter Erhitzen auf 60°C in 540 ml THF gelöst und durch Zusatz von 550 ml Methanol gefällt. Das so erhaltene Polymer wurde zweimal mit je 100 ml Methanol gewaschen und im Vakuum getrocknet. Es wurde in 400 ml Chlorbenzol gelöst und mit 400 ml Methanol gefällt. Nach Nachwaschen mit Methanol und zweitägiger Trocknung im Vakuum wurden 3.20 g (= 9.57 mmol, 80%) des Polymers A10 als gelbe Fasern erhalten.
¹H NMR (400 MHz, CDCl₃): δ (ppm) = 7.9-6.6 (br. m; 9 H); 4.0 (br. s, 2 H); 1.9-0.9 (br. m, 10H): 0.88, 0.87, 0.85, 0.84 (4 s, zus. 9H).
GPC: THF + 0.25% Oxals.; Säulensatz SDV500, SDV1000, SDV10000 (Fa. PSS), 35°C, UV Detektion 254 nm, Polystyrol-Standard: M_{w} = 9.1×10⁵ g/mol,
Mₙ = 9×10⁴ g/mol.

### Beispiel A11:

### Copolymer aus 80% 2,5-Bis(chlormethyl)-4'-(3,7-dimethyloctyloxy)biphenyl und 20% 2,5-Bis(chlormethyl)-2',5'-dimethylbiphenyl (Polymer A11):

### Herstellung von Poly(2-(4'-(3,7-dimethyloctyloxy)phenyl)-p-phenylenvinylen)co(2-(2',5'-dimethyl)phenyl)-p-phenylenvinylen).

In einem getrockneten 2 L Vierhalskolben mit mechanischem Teflonrührer, Intensivkühler, Thermometer und Tropftrichter wurde 700 ml trockenes 1,4-Dioxan vorgelegt, durch 30 minütiges Durchleiten von N₂ wurde entgast und dann wurde unter Rühren zum Rückfluß (98°C) erhitzt. Anschließend wurden 2.68 g 2,5-Bis(chlormethyl)-4'-(3,7-dimethyloctyloxy)biphenyl und 0.413 g (2.00 mmol) 2,5-Bis(chlormethyl)-2',5'-dimethylbiphenyl, gelöst in 30 ml trockenem 1,4-Dioxan, zugesetzt. Nun wurde eine Lösung von 2.92 g (26 mmol, 2.6 eq) Kalium-tert-butylat in 26 ml getrocknetem 1,4-Dioxan innerhalb von 5 Minuten zu der intensiv gerührten Mischung getropft. Während der Zugabe der Base wurde folgender Farbumschlag beobachtet: farblos-grün-gelb. Nach weiteren 5 Minuten Rühren bei dieser Temperatur wurden nochmals 2.36 g (21 mmol, 2.1 eq) Kalium-tert-butylat in 21 ml trockenem 1,4-Dioxan innerhalb von einer Minute zugesetzt. Die Temperatur wurde weitere 2 Stunden bei 95-97°C gehalten; nach dieser Zeit wurde auf 50°C abgekühlt und ein Gemisch aus 12.5 ml Essigsäure und 12.5 ml 1,4-Dioxan wurde zugesetzt. Die Farbe der Reaktionsmischung hellt sich dabei etwas auf. Nach 20 Minuten Rühren wurde die Reaktionsmischung auf 0.8 L intensiv gerührtes Wasser gegossen. Es wurde mit 100 ml Methanol versetzt und noch 20 Minuten gerührt. Nach Filtration über einen Polypropylenrundfilter, zweimaligem Nachwaschen mit Methanol und Vakuumtrocknung erhielt man 1.80 g (4.71 mmol, 47%) rohes Polymer als gelbe Fasern.

Nach Trocknung im Vakuum bei Raumtemperatur erfolgt die Reinigung durch zweimaliges Lösen in 240 ml THF und Ausfällen mit 250 ml Methanol. Nach Trocknen erhielt man 1.30 g (3.40 mmol, 34%) Polymer A11 als gelbe Fasern.
¹H NMR (400 MHz, CDCl₃): δ (ppm) = 7.8-6.5, darunter br. s bei 6.9 (br. m; 8.8 H);4.0 (br. s, 1.6 H); 2.3 (br. s, 0.6 H, CH₃); 2.0 (br. s, 0.6 H, CH₃); 1.8, 1.65, 1.55, 1.3, 1.15 (5 x s, zus. 8 H; alkyl-H); 0.91, 0.85 (2 x s, 7.2H; 3 x CH₃).
GPC: THF + 0.25% Oxals.; Säulensatz SDV500, SDV1000, SDV10000 (Fa. PSS), 35°C, UV Detektion 254 nm, Polystyrol-Standard: M_{w} = 7.6×10⁵ g/mol,
Mₙ = 1.9×10⁵ g/mol.

### Beispiel A12:

### Quartemäres Copolymer aus 2% 2,5-Bis(chlormethyl)-1-methoxy-4-(3,7-dimethyloctyloxy)benzol, 13% 2,5-Bis(chlormethyl)-2',5'-dimethylbiphenyl, 25% 2,5-Bis(chlormethyl)-3'-(3,7-dimethyloctyloxy)biphenyl und 60% 2,5-Bis(chlormethyl)-4'-(3,7-dimethyloctyloxy)biphenyl (Polymer A12):

### Herstellung von Poly(2-methoxy-5-(3,7-dimethyloctyloxy)-p-phenylenvinylen)co(2-(3'-(3,7-dimethyloctyloxy)phenyl)-p-phenylenvinylen)phenylenvinylen)co(2-(4'-(3,7-dimethyloctyloxy)phenyl)-p-phenylenvinylen)co(2-(2',5'-dimethyl)phenyl)-p-phenylenvinylen).

In einem trockenen 6 L Vierhalskolben mit mechanischem Rührer, Rückflußkühler, Thermometer und Tropftrichter wurden 3.55 kg (3.40 L) trockenes und O₂-freies 1,4-Dioxan vorgelegt und unter Rühren auf 98°C erhitzt. Dann wurde eine Lösung von 240 mg (0.66 mmol) 2,5-Bis(chlormethyl)-1-methoxy-4-(3,7-dimethyloctyloxy)benzol, 3.38 g (8.29 mmol) 2,5-Bis(chlormethyl)-3'-(3,7-dimethyloctyloxy)biphenyl, 8.11 g (19.9 mmol) 2,5-Bis(chlormethyl)-4'-(3,7-dimethyloctyloxy)biphenyl und 1.20 g (4.31 mmol) 2,5-Bis(chlormethyl)-2',5'-dimethylbiphenyl, gelöst in 50 ml trockenem 1,4-Dioxan, zugesetzt. Dann wurde eine Lösung von 9.30 g (82.9 mmol, 2.6 eq) Kalium-tert-butylat in 83 ml trockenem 1,4-Dioxan innerhalb von 5 Minuten zu der intensiv gerührten Mischung getropft. Die Viskosität der Lösung nahm leicht zu. Nach 5 Minuten Rühren bei 98°C wurden nochmals 7.44 g (66.3 mmol. 2.0 eq) Kalium-tert-butylat in 66 ml 1,4-Dioxan innerhalb von einer Minute zugesetzt. Nach weiteren 2 Stunden Rühren bei 97°-98°C wurde auf 45°C abgekühlt und ein Gemisch aus 19.1 ml Essigsäure und 20 ml 1,4-Dioxan wurde zugesetzt. Das Polymer wurde nach 20 Minuten Nachrühren durch Zusetzen der Reaktionslösung zu 4 L intensiv gerührtem Wasser ausgefällt. Das so erhaltene Polymer wurde abfiltriert und zweimal mit je 300 ml Methanol gewaschen. Nach Vakuumtrocknung bei Raumtemperatur wurden 10.40 g (32.8 mmol. 99%) rohes Polymer erhalten.

Das Rohprodukt wurde unter Erhitzen auf 60°C in 1390 ml THF gelöst und durch Zusatz von 1.4 L Methanol gefällt. Nach Trocknen im Vakuum und Waschen mit 100 ml Methanol wurde dieser Schritt wiederholt (800 ml THF/800 ml Methanol). Man erhielt nach zweitägiger Trocknung im Vakuum 7.90 g (= 24.9 mmol, 75 %) des Polymer A12 als hell-orange Fasern.
¹H NMR (400 MHz, CDCl₃): δ (ppm) = 7.9-6.6 (br. m; ca 9 H); 4.0 (br. s, ca. 2 H); 2.4, 2.1 (2 x br. s, 2 x je H); 1.9-0.8 (br. m, ca. 19 H).
GPC: THF + 0.25% Oxalsäure; Säulensatz SDV500, SDV1000, SDV10000
(Fa. PSS), 35°C, UV Detektion 254 nm, Polystyrol-Standard: M_{w} = 7.8×10⁵ g/mol,
Mₙ = 1.9×10⁵ g/mol.

### Beispiel A13:

### Copolymer aus 50% 2,5-Bis(chlormethyl)-3'-(3,7-dimethyloctyloxy)biphenyl und 50% 2,5-Bis(chlormethyl)-3',4'-bis(2-methylpropyloxy)biphenyl (Polymer A13):

### Herstellung von Poly(2-(3'-(3,7-dimethyloctyloxy)phenyl)-p-phenylenvinylen)co(2-(3',4'-bis(2-methylpropyloxy)phenyl)-p-phenylenvinylen).

In einem ausgeheitzten 1 L Vierhalskolben mit mechanischem Teflonrührer, Intensivkühler, Thermometer und Tropftrichter wurden 600 ml trockenes 1,4-Dioxan vorgelegt, durch 15 minütiges Durchleiten von N₂ wurde entgast und dann wurde unter Rühren zum gelinden Rückfluß (99°C) erhitzt. Anschließend wurden 1.63 g (4.00 mmol) 2,5-Bis(chlormethyl)-3'-(3,7-dimethyloctyloxy)biphenyl und 1.58 g (4.00 mmol), 2,5-Bis(chlormethyl)-3', 4'-bis(2-methylpropyloxy)biphenyl gelöst in 20 ml trockenem 1,4-Dioxan, zugesetzt. Nun wurde eine Lösung von 2.36 g (21 mmol, 2.6 eq) Kalium-tert-butylat in 21 ml getrocknetem 1,4-Dioxan innerhalb von 5 Minuten zu der intensiv gerührten Mischung getropft. Während der Zugabe der Base wurde folgender Farbumschlag beobachtet: farblos-gelb-gelbgrün. Nach weiteren 5 Minuten Rühren bei dieser Temperatur wurden nochmals 1.80 g (16 mmol, 2.0 eq) Kalium-tert-butylat in 16 ml trockenem 1,4-Dioxan innerhalb von einer Minute zugesetzt. Die Temperatur wurde weitere 2 Stunden bei 98-99°C gehalten; nach dieser Zeit wurde auf 45°C abgekühlt und ein Gemisch aus 2.5 ml Essigsäure und 2.5 ml 1,4-Dioxan wurde zugesetzt. Die Farbe der Reaktionsmischung hellte sich dabei etwas auf und die Viskosität stieg an. Nach 20 Minuten Rühren wurde die Reaktionsmischung auf 0.65 L intensiv gerührtes Wasser gegossen. Es wurde mit 100 ml Methanol versetzt und noch 20 Minuten gerührt. Nach Filtration über einen Polypropylenrundfilter, zweimaligem Nachwaschen mit Methanol und Vakuumtrocknung erhielt man 1.30 g (3.93 mmol, 49%) rohes Polymer als gelbe Fasern.

Nach Trocknung im Vakuum bei Raumtemperatur erfolgt die Reinigung durch zweimaliges Lösen in je 100 ml THF und Ausfällen mit je 100 ml Methanol. Nach Trocknen erhielt man 0.99 g (3.00 mmol, 38%) Polymer A13 als gelbe Fasern.
¹H NMR (400 MHz, CDCl₃): δ (ppm) = 7.8-6.5, darunter br. s bei 6.9 (br. m; 8.8 H);4.0 (br. s, 1.6 H); 2.3 (br. s, 0.6 H, CH₃); 2.0 (br. s, 0.6 H, CH₃); 1.8, 1.65, 1.55, 1.3, 1.15 (5 x s, zus. 8 H; alkyl-H); 0.91, 0.85 (2 x s, 7.2H; 3 x CH₃).
GPC: THF + 0.25% Oxals.; Säulensatz SDV500, SDV1000, SDV10000 (Fa. PSS), 35°C, UV Detektion 254 nm, Polystyrol-Standard: M_{w} =1.8×10⁶ g/mol,
Mₙ = 3.9×10⁵ g/mol.

Die Zusammensetzung der Copolymere A1 bis A13 wurde durch oxidativen Abbau und nachfolgende qualitative und quantitative Analyse der so zurückerhaltenen Monomereinheiten beigt. Es wurde gefunden, daß der Anteil der Monomereinheiten im Copolymer gleich dem in der Synthese eingesetzten Verhältnis der Monomere war.

### B. Synthese von Homopolymeren der Monomere nach Formel (II):

### Beispiel B1:

### Polymerisation von 2,5-Bis(chlormethyl)-3'-(3,7-dimethyloctyloxy)biphenyl (Polymer B1) durch Dehydrohalogenierung:

### Herstellung von Poly-2-(3'-(3,7-dimethyloctyloxy)phenyl)-p-phenylenvinylen.

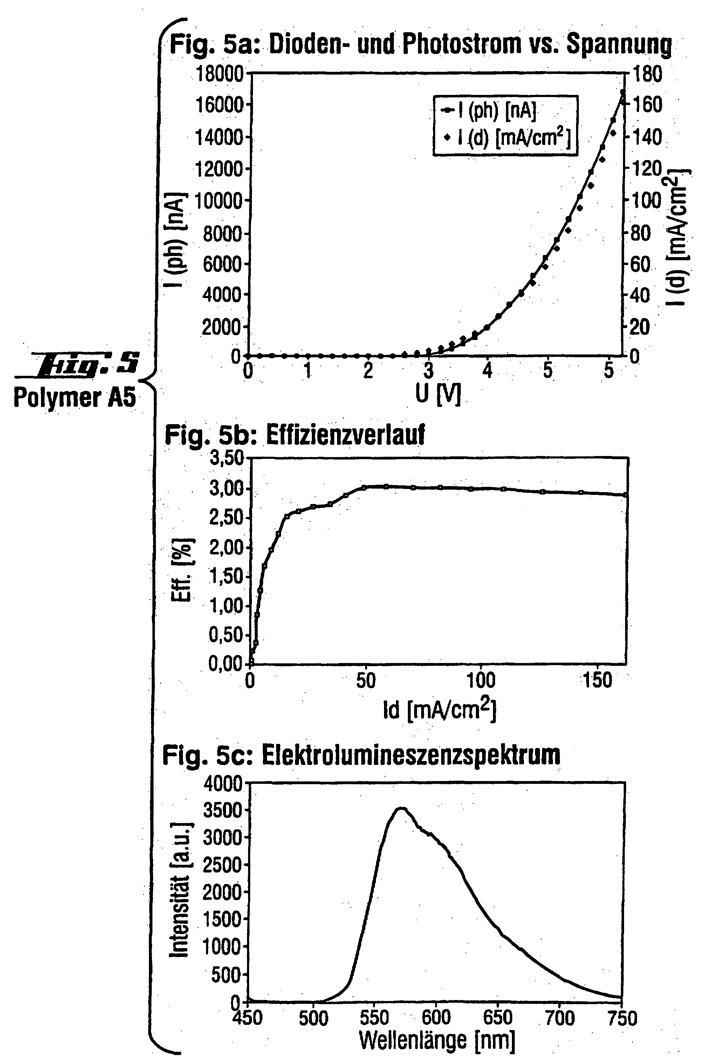

In einer trockenen Reaktionsapparatur (2 L Vierhalsrundkolben mit Rückflußkühler, mechanischem Rührer, Tropftrichter und Thermometer) wurden 640 g (619 ml) trokkenes 1,4-Dioxan vorgelegt und durch 15 minütiges Durchleiten von N₂ entgast.
Nach Umstellen auf N₂-Überlagerung wurde auf 98°C erhitzt. Nun wurden 3.26 g (8.00 mmol) 2,5-Bis(chlormethyl)-3'-(3,7-dimethyloctyloxy)biphenyl (gelöst in 30 ml trockenem 1,4-Dioxan) der siedenden Lösung zugesetzt. Eine Lösung von 2.33 g (20.8 mmol, 2.6 eq) Kalium-*tert*-butylat in 21 ml trockenem 1,4-Dioxan wurde innerhalb von 5 Minuten zugetropft; die Farbe der Reaktionsmischung änderte sich dabei von farblos nach grün. Nach 5 Minuten wurden weitere 1.8 g (16 mmol, 2 eq) Kalium-*tert*-butylat (gelöst in 18 ml trockenem 1,4-Dioxan) innerhalb von einer Minute zugesetzt Es wurde weitere 2 Stunden bei 98°C gerührt. Die Farbe veränderte sich dabei von grün nach gelb-grün. Die Reaktionslösung wurde auf 50°C abgekühlt und mit einem Gemisch aus 3 ml Essigsäure und 3 ml 1,4-Dioxan versetzt. Es wurde weitere 20 Minuten gerührt und dann unter intensivem Rühren auf 700 ml Wasser gegossen. Nach Zugabe von 100 ml Methanol wurde das Polymer (feine grüne Fasem) durch einen Polypropylen Rundfilter abgesaugt, mit 100 ml Methanol/Wasser 1:1 und dann mit 100 ml reinem Methanol gewaschen. Nach Trocknung im Vakuum bei Raumtemperatur wurden 2.60 g (7.77 mmol, 97%) rohes Polymer B1 erhalten.
Die Reinigung erfolgte durch Auflösen des Polymers in 300 ml THF (60°C), Abkühlen auf 30°C und Fällung durch Zutropfen von 300 ml Methanol. Nach Waschen mit 100 ml Methanol wurde bei Raumtemperatur im Vakuum getrocknet. Diese Prozedur wurde noch zweimal mit je 260 ml THF/260 ml Methanol wiederholt. Es wurden 1.85 g (5.53 mmol, 69%) von Polymer B1 als grün fluoreszensierendes faserförmiges Polymer erhalten.
¹H NMR (400 MHz, CDCl₃): δ (ppm) = 7.85-7.02 (br. m, 7 H; Hₐᵣₒₘ); 6.92, 6.67 (br. s, zus. 2H; Olefin-H) 3.99 (br. s, 2 H; OCH₂); 1.82 (br. s, 1H; aliph. H); 1.72-1.45 (m, 3H): 1.40-1.08 (m, 6H), 0.91 (s, 3H; CH₃); 0.85 (s; 3H; CH₃); 0.83 (s, 3H; CH₃). GPC: THF + 0.25% Oxals.; Säulensatz SDV500, SDV1000, SDV10000 (Fa. *PSS*), 35°C, UV Detektion 254 nm, Polystyrol-Standard: M_{w} = 6.3×10⁵ g/mol, Mₙ=6.8×10⁴ g/mol.
Das ¹H NMR dieses Polymers ist in Figur 3 wiedergegeben.

### Beispiel B2:

### Polymerisation von 2,5-Bis(chlormethyl)-2'5'-dimethylbiphenyl (Polymer B2) durch Dehydrohalogenierung:

### Herstellung von 2-(2'5'-Dimethylphenyl)poly-p-phenylenvinylen.

In einer trockenen Reaktionsapparatur (1 L Vierhalsrundkolben mit Rückflußkühler, mechanischem Rührer, Tropftrichter und Thermometer) wurden 650 g (629 ml) trokkenes 1,4-Dioxan vorgelegt und durch 15 minütiges Durchleiten von N2 entgast.

Nach Umstellen auf N₂-Überlagerung wurde auf 98°C erhitzt. Nun wurden 2.33 g (8.00 mmol) 2,5-Bis(chlormethyl)-2'5'-dimethylbiphenyl (gelöst in 30 ml trockenem 1,4-Dioxan) zu der siedenden Lösung zugesetzt. Eine Lösung von 2.47 g (22 mmol, 2.7 eq) Kalium-tert-butylat in 22 ml trockenem 1,4-Dioxan wurde nun innerhalb von 5 Minuten zugetropft; die Farbe der Reaktionsmischung änderte sich dabei von farblos nach grün. Nach 5 Minuten wurden weitere 1.8 g (16 mmol, 2 eq) Kalium-tert-butylat (gelöst in 18 ml trockenem 1,4-Dioxan) innerhalb von einer Minute zugesetzt. Es wurde weitere 2 Stunden bei 98°C gerührt. Die Farbe veränderte sich dabei von grün nach gelb-grün. Die Reaktionslösung wurde auf 50°C abgekühlt und mit einem Gemisch aus 3 ml Essigsäure und 3 ml 1,4-Dioxan versetzt. Es wurde weitere 20 Minuten gerührt und dann unter intensivem Rühren auf 700 ml Wasser gegossen. Nach Zugabe von 100 ml Methanol wurde das Polymer (feine grüne Fasem) durch einen Polypropylen Rundfilter abgesaugt, mit 100 ml Methanol/Wasser 1:1 und dann mit 100 ml reinem Methanol gewaschen. Nach Trocknung im Vakuum bei Raumtemperatur wurden 1.60 g (7.76 mmol, 97%) rohes Polymer B2 erhalten.
Die Reinigung erfolgte durch Auflösen des Polymers in 180 ml THF (60°C), Abkühlen auf 30°C und Fällung durch Zutropfen von 200 ml Methanol. Nach Waschen mit 100 ml Methanol wurde bei Raumtemperatur im Vakuum getrocknet. Diese Prozedur wurde noch zweimal mit je 90 ml THF/90 ml Methanol wiederholt. Es wurden 0.53 g (2.57 mmol, 32%) von Polymer B2 als grün fluoreszierendes pulverförmiges Polymer erhalten.
¹H NMR (400 MHz, CDCl3): δ (ppm) = 7.85-6.6 (br. m, 7.8 H; Hₐᵣₒₘ und Olefin H); 6.14 (br. br. s, zus. 0.2 H; Olefin-H); 2.6-1.8 (m, 6H).
GPC: THF + 0.25% Oxals.; Säulensatz SDV500, SDV1000, SDV10000 (Fa. PSS), 35°C, UV Detektion 254 nm, Polystyrol-Standard: Mw = 4.3×10⁵ g/mol, Mn = 9×10⁴ g/mol.

### Horner Polymerisation

### Beispiel C1:

### Horner Polymerisation von 2,5-Bis(methylendiethylphosphonat)-1-(3,7-dimethyloctyloxy)-4-methoxybenzol und 2-(4'-Hexyloxyphenyl)terephthaldehyd:

### Herstellung von Poly-(4'-Hexyloxyphenyl)phenylenvinylen-co-alt-(2-(3',7'-dimethyloctyloxy)-5-methoxy)phenylenvinylen

2,5-Bis(methylendiethylphosphonat)-1-(3,7-dimethyloctyloxy)-4-methoxybenzol (10.37 g, 18.4 mmol) wurde mit 2-(4'-Hexyloxyphenyl)terephthaldehyd (5.61 g, 18.1 mmol), Bibenzyl-4,4'-dialdehyd (0.132 g, 0.55 mmol) und 70 ml Toluol versetzt. Die gelbe Lösung wurde mit N2 gesättigt. Nach Aufheizen bis zum Rückfluß wurde eine Suspension von Kalium-tert-butylat in 25 ml Dioxan (6.22 g, 55.4 mmol) zugegeben. Der Ansatz wurde nun für 2 Stunden am Rückfluß gerührt, mit 100 ml 4-Fluorbenzaldeyd (0.116 g, 0.93 mmol) versetzt, und für eine weitere Stunde am Rückfluß gerührt, schließlich mit 100 ml Toluol verdünnt, nochmal 20 Minuten am Rückfluß gerührt und heiß in ca. 1.2 L i-Propanol gegossen. Der Niederschlag wurde ca. 1 Stunde ausgerührt, über einen Papierfilter abgesaugt und über Nacht im Ölpumpenvakuum getrocknet.
Der orange Feststoff wurde schließlich durch zweimaliges Umfällen (THF - H2O; THF - MeOH) gereinigt und schließlich im Vakuum getrocknet.
Es wurden 4.40 g (42 %) oranges Polymerpulver erhatten.
¹H NMR (400 MHz, CDCl₃): d (ppm) = 7.8 - 6.5 (br. m, 6.5 H, H_{aryl}, H_{vinyl}), 4.2 - 3.8 (br. m, 3.5 H, OCHx), 2.9 (br., 0.04 H, Ar-CH₂), 2.0 - 0.8 (br - m, 19 H, alkyl H). GPC: THF + 0.25% Oxalsäure; Säulensatz SDV500, SDV1000, SDV10000 (Fa. PSS), 35°C, UV Detektion 254 nm, Polystyrol-Standard: Mw = 8.9 x 10⁴ g/mol, Mn = 1.2 x 10⁴ g/mol.

### V. Vergleichssynthese des Homopolymeren von 2,5-Bis(chlormethyl)-1-methoxy-4-(3,7-dimethyloctyloxy)benzol:

### Beispiel V1:

### Homopolymerisation von 2,5-Bis(chlormethyl)-1-methoxy-4-(3',7'-dimethyloctyloxy)benzol (Polymer V1):

### Herstellung von Poly(2-methoxy-5-(3,7-dimethylocty)-p-phenylenvinylen).

Ein 4 L Vierhalskolben mit mechanischem (Tefton)Rührer, Rückflußkühler, Thermometer und Tropftrichter wurde ausgeheizt (Heißluftfön) und mit N₂ gespült. Dann wurde mit 2.3 L getrocknetem 1,4-Dioxan befüllt und zum Entgasen wurde ca. 15 Minuten N₂ durch das Lösungsmittel geleitet. Es wurde im Ölbad auf 98°C erhitzt und 14.0 g (38.7 mmol) 2,5-Bis(chlormethyl)-1-methoxy-4-(3',7'-dimethyloctyloxy)benzol wurden als Feststoff zugesetzt (es wurde mit etwa 10 ml trokkenem 1,4-Dioxan nachgespühlt). Durch den Tropftrichter wurden 11.3 g (100 mmol, 2.6 eq) Kalium*-tert*-butylat, gelöst in 100 ml 1,4-Dioxan, innerhalb von 5 Minuten zu der Reaktionslösung getropft. Die Reaktionsmischung verfärbte sich dabei von farblos über grünlich nach gelb/orange, die Viskosität nahm deutlich zu. Nach beendeter Zugabe wurde noch ca. 5 min bei 98°C gerührt, dann wurden 8.70 g Kalium-*tert*-butylat (77 mmol, 2 eq) in 100 ml trockenem 1,4-Dioxan innerhalb von einer Minute zugesetzt und es wurde noch 2 h bei 96-98°C weitergerührt. Dann wurde die Lösung innerhalb von ca. 2 Stunden auf 50°C abgekühlt. Die Reaktionsmischung wurde schließlich mit 15 ml (260 mmol, 1.5 eq bez. auf Base) Essigsäure (verdünnt mit der gleichen Menge Dioxan) versetzt und noch 20 Minuten gerührt. Die Lösung war nun tief orange. Zur Aufarbeitung wird die Reaktionslösung langsam auf 2.5 L intensiv gerührtes Wasser geschüttet. Es wurde noch 10 Minuten gerührt, mit 200 ml Methanol versetzt und das ausgefallene Polymer abfiltriert. Es wurde mit 200 ml Methanol gewaschen und im Vakuum bei Raumtemperatur getrocknet. Man erhielt 10.04 g (34.8 mmol, 90%) rohes Polymer als rote Fasern.
Die Reinigung erfolgte durch Auflösen des Polymere in 1.1 L THF (60°C), Abkühlen auf 40°C und Fällung durch Zutropfen von 1.2 L Methanol. Nach Waschen mit 200 ml Methanol wurde bei Raumtemperatur im Vakuum getrocknet. Diese Prozedur wurde nochmals mit je 1.0 L THF/1.0 L Methanol wiederholt. Es wurden 6.03 g (20.9 mmol, 54%) von Polymer V1 als dunkel-oranges faserförmiges Polymer erhalten
¹H NMR (400 MHz, CDCl₃): δ (ppm) = 7.7-6.5 (br. m, 4 H; Hₐᵣₒₘ, Olefin-H); 4.5-3.6 (br. m, 5 H; OCH₃, OCH₂); 2.1-0.6 (br. m, 19H; aliph. H). GPC: THF + 0.25% Oxals.; Säulensatz SDV500, SDV1000, SDV10000 (Fa. *PSS*), 35°C, UV Detektion 254 nm, Polystyrol-Standard: M_{w} = 1.2×10⁶ g/mol, Mₙ = 1.1×10⁵ g/mol.

### Teil 3: Herstellung und Charakterisierung von LEDs:

Die Herstellung von LEDs erfolgte nach dem im folgenden skizzierten allgemeinen Verfahren. Dieses mußte natürlich im Einzelfall auf die jeweiligen Gegebenheiten (z. B. Polymerviskosität und optimale Schichtdicke des Polymers im Device) angepaßt werden. Die im nachfolgenden beschriebenen LEDs waren jeweils Einschichtsysteme, d. h. Substrat//ITO//Polymer//Kathode.

### Allgemeines Verfahren zur Herstellung von hocheffizienten, langlebigen LEDs:

Nachdem man die ITO-beschichteten Substrate (z. B. Glasträger, PET-Folie) auf die richtige Größe zugeschnitten hat, werden sie in mehreren Reinigungsschritten im Ultraschallbad gereinigt (z.B. Seifenlösung, Millipore-Wasser, Isopropanol).
Zur Trocknung werden sie mit einer N₂-Pistole abgepustet und in einem Exsikkator gelagert. Vor der Beschichtung mit dem Polymer werden sie mit einem Ozon-Plasma-Gerät für ca. 20 Minuten behandelt. Von dem jeweiligen Polymer wird eine Lösung (in der Regel mit einer Konzentration von 4-25 mg/ml in beispielsweise Toluol, Chlorbenzol, Xylol:Cyclohexanon (4:1)) angesetzt und durch Rühren bei Raumtemperatur gelöst. Je nach Polymer kann es auch vorteilhaft sein, für einige Zeit bei 50 - 70°C zu rühren. Hat sich das Polymer vollständig gelöst, wird es durch einen 5µm Filter filtriert und bei variablen Geschwindigkeiten (400-6000) mit einem Spincoater aufgeschleudert. Die Schichtdicken können dadurch im Bereich von ca. 50 und 300nm variiert werden.
Auf die Polymerfilme werden noch Elektroden aufgebracht. Dies geschieht in der Regel durch thermisches Verdampfen (Balzer BA360 bzw. Pfeifer PL S 500). Anschließend wird die durchsichtige ITO-Elektrode als Anode und die Metallelektrode (z. B. Ca) als Kathode kontaktiert and die Device-Parameter bestimmt.

Die mit den beschriebenen Polymeren erhaltenen Resultate sind in Tabelle 1 zusammengefaßt:

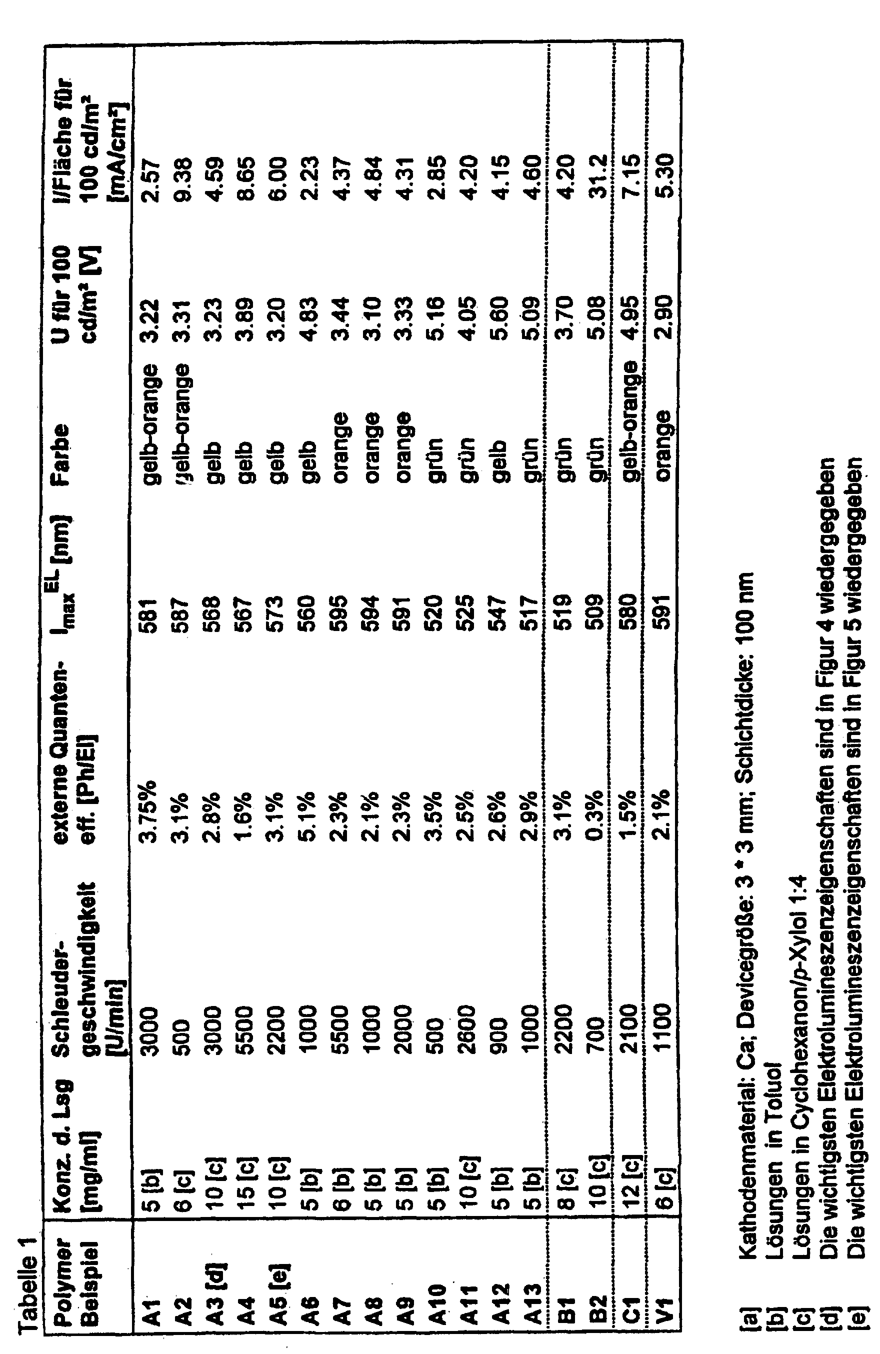

## Patentansprüche

1. Poly(p-arylenvinylen), enthaltend Wiederholeinheiten der Formel (I), 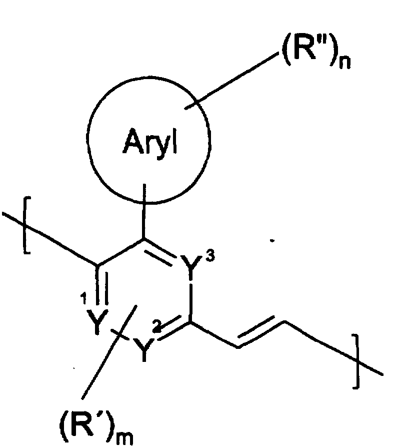 wobei die Symbole und Indizes folgende Bedeutungen haben:
Y¹, Y², Y³ gleich oder verschieden, CH, N;
Aryl eine Arylgruppe mit 4 bis 14 C-Atomen;
R' gleich oder verschieden eine geradkettige oder verzweigte oder cyclische Alkyl- oder Alkoxygruppe mit 1 bis 20 C-Atomen, wobei ein oder mehrere nicht benachbarte CH₂-Gruppen durch -O-, -S-, -CO-, -COO-, -O-CO-, -NR¹-, -(NR²R³)⁺-A⁻, oder -CONR⁴- ersetzt sein können und wobei ein oder mehrere H-Atome durch F ersetzt sein können, CN, F, Cl oder eine Arylgruppe mit 4 bis 14 C-Atome, die durch einen oder mehrere, nicht aromatische Reste R' substituiert sein kann;
R" gleich oder verschieden eine geradkettige oder verzweigte oder cyclische Alkylgruppe mit 1 bis 20 C-Atomen oder eine geradkettige oder verzweigte oder cyclische Alkoxygruppe mit 4 bis 20 C-Atomen, wobei ein oder mehrere nicht benachbarte CH₂-Gruppen durch -O-, -S-, -CO-, -COO-, -O-CO-, -NR¹-, -(NR²R³)⁺-A⁻, oder -CONR⁴- ersetzt sein können und wobei ein oder mehrere H-Atome durch F ersetzt sein können, Cl oder eine Arylgruppe mit 4 bis 14 C-Atome, die durch einen oder mehrere, nicht aromatische Reste R' substituiert ist;
R¹,R²,R³,R⁴ gleich oder verschieden aliphatische oder aromatische Kohlenwasserstoffreste mit 1 bis 20 C-Atomen oder auch H.
A⁻ ein einfach geladenes Anion oder dessen Äquivalent;
m 0, 1 oder 2;
n 1, 2, 3, 4 oder 5.

2. Poly(p-arylenvinylen) gemäß Anspruch 1, **dadurch gekennzeichnet, daß** es 2 bis 10 000 Wiederholeinheiten aufweist.

3. Poly(p-arylenvinylen) gemäß Anspruch 1 und/oder 2, bestehend im wesentlichen aus Wiederholeinheiten der Formel (I).

4. Poly(p-arylenvinylen)-Copolymere, enthaltend Wiederholeinheiten der Formel (I), 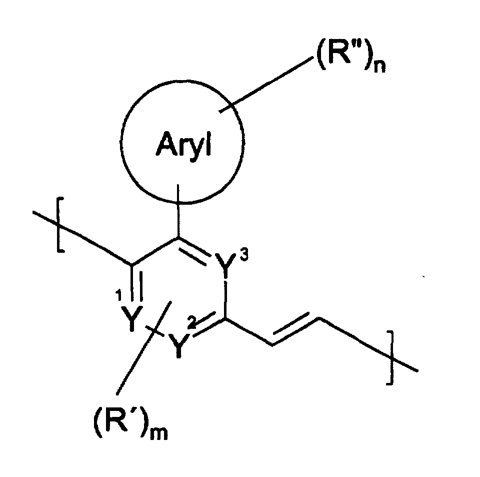 wobei die Symbole und Indizes folgende Bedeutungen haben:
Y¹, Y², Y³ gleich oder verschieden, CH, N;
Aryl eine Arylgruppe mit 4 bis 14 C-Atomen;
R', R" gleich oder verschieden eine geradkettige oder verzweigte oder cyclische Alkyl- oder Alkoxygruppe mit 1 bis 20 C-Atomen, wobei ein oder mehrere nicht benachbarte CH₂-Gruppen durch -O-, -S-, -CO-, -COO-, -O-CO-, -NR¹-, -(NR²R³)⁺-A⁻, oder -CONR⁴- ersetzt sein können und wobei ein oder mehrere H-Atome durch F ersetzt sein können, CN, F, Cl oder eine Arylgruppe mit 4 bis 14 C-Atome, die durch einen oder mehrere, nicht aromatische Reste R' substituiert sein kann;
R¹,R²,R³,R⁴ gleich oder verschieden aliphatische oder aromatische Kohlenwasserstoffreste mit 1 bis 20 C-Atomen oder auch H.
A⁻ ein einfach geladenes Anion oder dessen Äquivalent;
m 0, 1 oder 2;
n 1, 2, 3, 4 oder 5.

5. Poly(p-arylenvinylen) gemäß Anspruch 4, **dadurch gekennzeichnet, daß** es mindestens zwei verschiedene Wiederholeinheiten der Formel (I) enthält.

6. Poly(p-arylenvinylen) gemäß Anspruch 5, **dadurch gekennzeichnet, daß** es neben einer oder mehreren Wiederholeinheiten der Formel (I) eine oder mehrere weitere Poly(p-arylenvinylen)-Wiederholeinheiten enthält.

7. Poly(p-arylenvinylene) gemäß Anspruch 6, **dadurch gekennzeichnet, daß** sie eine oder mehrere 2,5-Dialkoxy-1,4-phenylenvinylen-Wiederholeinheiten enthalten.

8. Poly(p-arylenvinylen) gemäß einem oder mehreren der vorhergehenden Ansprüche, wobei die Symbole und Indizes folgende Bedeutungen haben:
Y¹, Y², Y³ CH;
Aryl Phenyl, 1- bzw. 2-Naphthyl, 1-, 2- bzw. 9-Anthracenyl, 2-, 3- bzw. 4-Pyridinyl, 2-, 4- bzw. 5-Pyrimidinyl, 2-Pyrazinyl, 3- bzw. 4-Pyridazinyl, 2-, 3-, 4-, 5-, 6-, 7- bzw. 8-Chinolin, 2- bzw. 3-Thiophenyl, 2- bzw. 3-Pyrrolyl und 2- bzw. 3-Furanyl;
R' gleich oder verschieden geradkettige oder verzweigte Alkoxygruppe mit 1 bis 12 C-Atomen;
R" gleich oder verschieden geradkettige oder verzweigte Alkylgruppe mit 1 bis 12 C-Atomen oder eine geradkettige oder verzweigte Alkoxygruppe mit 4 bis 12 C-Atomen;
m 0, 1,
n 1, 2, 3.

9. Poly(p-arylenvinylen) gemäß Anspruch 8, **dadurch gekennzeichnet, daß** der Arylsubstituent in der Formel (I) folgende Bedeutung hat: Phenyl, 1-Naphthyl, 2-Naphthyl oder 9-Anthracenyl.

10. Poly(p-arylenvinylen) gemäß Anspruch 9, **dadurch gekennzeichnet, daß** in der Wiederholeinheit der Formel (I) der Arylsubstituent folgendes Substitutionsmuster aufweist:
2-, 3- bzw. 4-Alkyl(oxy)phenyl, 2,3-, 2,4-, 2,5-, 2,6-, 3,4- bzw. 3,5-Dialkyl(oxy)phenyl, 2,3,4,-, 2,3,5-, 2,3,6-, 2,4,5, 2,4,6- bzw. 3,4,5-Trialkyl(oxy)phenyl, 2-, 3-, 4-, 5-, 6-, 7-bzw. 8-Alkyl(oxy)-1-naphthyl, 1-, 3-, 4-, 5-, 6-, 7- bzw. 8-Alkyl(oxy)-2-naphthyl und 10-Alkyl(oxy)-9-anthracenyl.

11. Verwendung eines Poly(p-arylenvinylens) gemäß einem oder mehreren der Ansprüche 1 bis 10 als Elektrolumineszenzmaterial.

12. Elektrolumineszenzmaterial, enthaltend ein oder mehrere Poly(p-arylenvinylene) gemäß einem oder mehreren der Ansprüche 1 bis 10.

13. Verfahren zur Herstellung eines Elektrolumineszenzmaterials gemäß Anspruch 12, **dadurch gekennzeichnet, daß** man ein oder mehrere Poly(p-arylenvinylene), enthaltend Wiederholeinheiten der Formel (I), als Film auf ein Substrat aufbringt, das gegebenenfalls weitere Schichten enthält.

14. Elektrolumineszenzvorrichtung, enthaltend eine oder mehrere aktive Schichten, wobei mindestens eine dieser aktiven Schichten ein oder mehrere Poly(p-arylenvinylene) gemäß einem oder mehreren der Ansprüche 1 bis 10 enthält.

## Claims

1. A poly(p-arylene-vinylene) comprising repeating units of the formula (I), 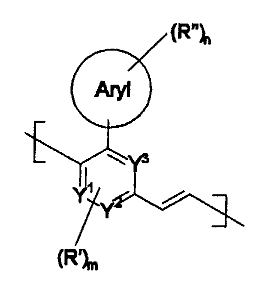 where the symbols and indices have the following meanings:
Y¹, Y², Y³ : identical or different, CH, N;
Aryl : an aryl group having from 4 to 14 carbon atoms;
R' : identical or different, each a straight-chain or branched or cyclic alkyl or alkoxy group having from 1 to 20 carbon atoms, where one or more non-adjacent CH₂ groups may be replaced by -O-, -S-, -CO-, -COO-, -O-CO-, -NR¹⁻-, -(NR²R³)⁺-A⁻, or -CONR⁴- and one or more H atoms may be replaced by F, or else CN, F, Cl or an aryl group having from 4 to 14 carbon atoms which may be substituted by one or more nonaromatic radicals R';
R" : identical or different, each a straight-chain or branched or cyclic alkyl group having from 1 to 20 carbon atoms or a straight-chain or branched or cyclic alkoxy group having from 4 to 20 carbon atoms, where one or more non-adjacent CH₂ groups may be replaced by -O-, -S-, -CO-, -COO-, -O-CO-, -NR¹-, -(NR²R³)⁺-A⁻, or -CONR⁴- and one or more H atoms may be replaced by F, or else Cl or an aryl group having from 4 to 14 carbon atoms which is substituted by one or more nonaromatic radicals R';
R¹, R², R³, R⁴ : identical or different, aliphatic or aromatic hydrocarbon radicals having from 1 to 20 carbon atoms or else H;
A⁻ : a singly charged anion or its equivalent;
m : 0, 1 or 2;
n : 1, 2, 3, 4 or 5.

2. A poly(p-arylene-vinylene) as claimed in claim 1 which comprises from 2 to 10,000 repeating units.

3. A poly(p-arylene-vinylene) as claimed in claim 1 and/or 2 consisting essentially of repeating units of the formula (I).

4. A poly(p-arylene-vinylene) copolymer comprising repeating units of the for a (I), 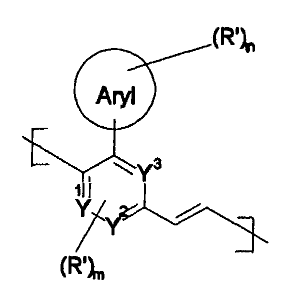 where the symbols and indices have the following meanings:
Y¹, Y², Y³ : identical or different, CH, N;
Aryl : an aryl group having from 4 to 14 carbon atoms;
R', R" : identical or different, each a straight-chain or branched or cyclic alkyl or alkoxy group having from 1 to 20 carbon atoms, where one or more non-adjacent CH₂ groups may be replaced by -O-, -S-, -CO-, -COO-, -O-CO-, -NR¹-, -(NR²R³)⁺-A⁻, or -CONR⁴- and one or more H atoms may be replaced by F, or else CN, F, Cl or an aryl group having from 4 to 14 carbon atoms which may be substituted by one or more nonaromatic radicals R';
R¹,R²,R³,R⁴ : identical or different, aliphatic or aromatic hydrocarbon radicals having from 1 to 20 carbon atoms or else H;
A⁻ : a singly charged anion or its equivalent;
m 0, 1 or 2;
n : 1, 2, 3, 4 or 5.

5. A poly(p-arylene-vinylene) as claimed in claim 4 which comprises at least two different repeating units of the formula (I).

6. A poly(p-arylene-vinylene) as claimed in claim 5 which comprises not only one or more repeating units of the formula (I) but also one or more further poly(p-arylene-vinylene) repeating units.

7. A poly(p-arylene-vinylene) as claimed in claim 6 which comprises one or more 2,5-dialkoxy-1,4-phenylene-vinylene repeating units.

8. A poly(p-arylene-vinylene) as claimed in one or more of the preceding claims, wherein the symbols and indices have the following meanings:
Y¹, Y², Y³ : CH;
Aryl : phenyl, 1- or 2-naphthyl, 1-, 2- or 9-anthracenyl, 2-, 3- or 4-pyridinyl, 2-, 4- or 5-pyrimidinyl, 2-pyrazinyl, 3- or 4-pyridazinyl, 2-, 3-, 4-, 5-, 6-, 7- or 8-quinolinyl, 2- or 3-thiophenyl, 2- or 3-pyrrolyl or 2- or 3-furanyl;
R' : identical or different, each a straight-chain or branched alkoxy group having from 1 to 12 carbon atoms;
R" : identical or different, each a straight-chain or branched alkyl group having from 1 to 12 carbon atoms or a straight-chain or branched alkoxy group having from 4 to 12 carbon atoms;
m : 0, 1;
n : 1, 2, 3.

9. A poly(p-arylene-vinylene) as claimed in claim 8, wherein the aryl substituent in the formula (I) is phenyl, 1-naphthyl, 2-naphthyl or 9-anthracenyl.

10. A poly(p-arylene-vinylene) as claimed in claim 9, wherein, in the repeating unit of the formula (I), the aryl substituent has the following substitution pattern:
2-, 3- or 4-alkyl(oxy)phenyl, 2,3-, 2,4-, 2,5-, 2,6-, 3,4- or 3,5-dialkyl(oxy)phenyl, 2,3,4-, 2,3,5-, 2,3,6-, 2,4,5-, 2,4,6- or 3,4,5-trialkyl(oxy)phenyl, 2-, 3-, 4-, 5-, 6-, 7- or 8-alkyl(oxy)-1-naphthyl, 1-, 3-, 4-, 5-, 6-, 7- or 8-alkyl(oxy)-2-naphthyl or 10-alkyl(oxy)-9-anthracenyl.

11. The use of a poly(p-arylene-vinylene) as claimed in one or more of claims 1 to 10 as electroluminescence material.

12. An electroluminescence material comprising one or more poly(p-arylene-vinylenes) as claimed in one or more of claims 1 to 10.

13. A process for producing an electroluminescence material as claimed in claim 12, which comprises applying one or more poly(p-arylene-vinylenes) comprising repeating units of the formula (I) as a film onto a substrate which may, if desired, comprise further layers.

14. An electroluminescence device comprising one or more active layers, wherein at least one of these active layers comprises one or more poly(p-arylene-vinylenes) as claimed in one or more of claims 1 to 10.

## Revendications

1. Poly(p-arylènevinylène), contenant des motifs répétitifs de formule (I) 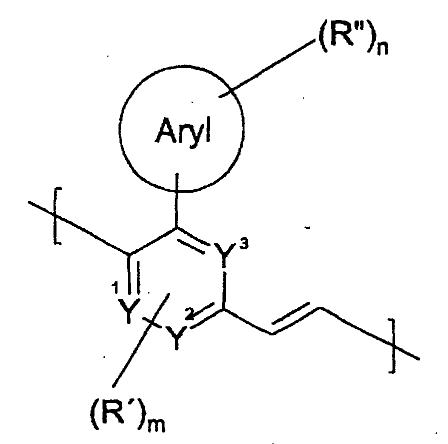 les symboles et les indices ayant les significations suivantes :
Y¹, Y², Y³ identiques ou différents représentent des groupes CH, N ;
aryle un groupe aryle ayant 4 à 14 atomes de carbone ;
R' identiques ou différents représentent, un groupe alkyle ou alkoxy linéaire ou ramifié ou cyclique ayant 1 à 20 atomes de carbone, un ou plusieurs groupes CH₂ non adjacents pouvant être remplacés par des groupes -O-, -S-, -CO-, -COO-, -O-CO-, -NR¹-, -(NR²R³)⁺-A⁻ ou -CONR⁴- et un ou plusieurs atomes de H pouvant être remplacés par F, représentent aussi CN, F, Cl ou un groupe aryle ayant 4 à 14 atomes de carbone, qui peuvent être substitués par un ou plusieurs restes R' non aromatiques ;
R" identiques ou différents représentent un groupe alkyle ou alkoxy linéaire ou ramifié ou cyclique ayant 1 à 20 atomes de carbone ou un groupe alkoxy linéaire ou ramifié ou cyclique ayant 4 à 20 atomes de carbone ou un ou plusieurs groupes CH₂ non adjacents pouvant être remplacés par des groupes -O-, -S-, -CO-, -COO-, -O-CO-, -NR¹-, -(NR²R³)⁺-A⁻ ou -CONR⁴- et un ou plusieurs atomes de H pouvant être remplacés par F, représentent aussi Cl ou un groupe aryle ayant 4 à 14 atomes de carbone, qui peuvent être substitués par un ou plusieurs restes R' non aromatiques ;
R¹, R², R³, R⁴ des restes hydrocarbonés aliphatiques ou aromatiques ayant 1 à 20 atomes de carbone, identiques ou différents, ou aussi H;
A un anion à charge simple ou son équivalent ;
m vaut 0, 1 ou 2 ;
n vaut 1, 2, 3, 4 ou 5.

2. Poly(p-arylènevinylène) selon la revendication 1, **caractérisé en ce qu'**il présente de 2 à 10000 motifs répétitifs.

3. Poly(p-arylènevinylène) selon la revendication 1 et/ou 2, **caractérisé en ce qu'**il est constitué essentiellement de motifs répétitifs de formule (I).

4. Copolymères de poly(p-arylène-vinylène) présentant des motifs répétitifs de formule 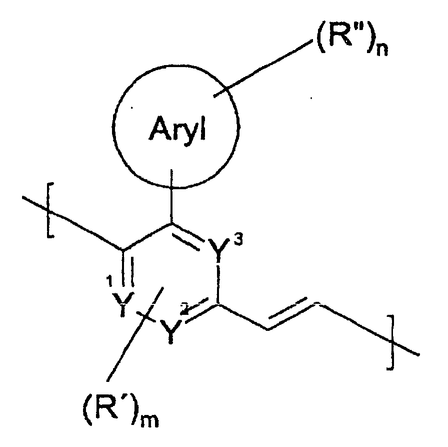 les symboles et les indices ayant les significations suivante :
Y¹, Y², Y³ identiques ou différents et représentent des groupes CH, N ;
aryle un groupe aryle ayant 4 à 14 atomes de carbone ;
R', R" identiques ou différents et représentent, un groupe alkyle ou alkoxy linéaire ou ramifié ou cyclique ayant 1 à 20 atomes de carbone, un ou plusieurs groupes CH₂ non adjacents pouvant être remplacés par des groupes -O-, -S-, -CO-, -COO-, -O-CO-, -NR¹-, -(NR²R³)⁺-A⁻ ou -CONR⁴- et un ou plusieurs atomes de H pouvant être remplacés par F, représentent aussi CN, F, Cl ou un groupe aryle ayant 4 à 14 atomes de carbone, qui peuvent être substitués par un ou plusieurs restes R' non aromatiques ;
R¹, R², R³, R⁴ des restes hydrocarbonés aliphatiques ou aromatiques ayant 1 à 20 atomes de carbone, identiques ou différents, ou aussi H ;
A⁻ un anion à charge simple ou son équivalent ;
m vaut 0, 1 ou 2 ;
n vaut 1, 2, 3, 4 ou 5.

5. Poly(p-arylènevinylène) selon la revendication 4, **caractérisé en ce qu'**il présente au moins deux motifs répétitifs différents de formule (I).

6. Poly(p-arylènevinylène) selon la revendication 5, **caractérisé en ce qu'**il présente, au côté d'un ou plusieurs motifs répétitifs de formule (I), un ou plusieurs motifs répétitifs de poly(p-arylènevinylène).

7. Poly(p-arylènevinylènes) selon la revendication 6, **caractérisés en ce qu'**ils présentent un ou plusieurs motifs répétitifs 2,5-dialkoxy-1,4-phénylènevinylène.

8. Poly(p-arylènevinylène) selon une ou plusieurs des revendications précédentes, les symboles et les indices possèdant les significations suivantes :
Y¹, Y², Y³ un groupe CH ;
aryle un groupe phényle, 1- ou 2-naphtyle, 1-, 2- ou 9-anthracényle, 2-, 3- ou 4-pyridinyle, 2-, 4- ou 5-pyrimidinyle, 2-pyrazinyle, 3- ou 4-pyridazinyle, 2-, 3-, 4-, 5-, 6-, 7- ou 8-quinoléine, 2- ou 3-thiophényle, 2- ou 3-pyrrolyle, 2- ou 3-furanyle ;
R' des groupes alkoxy linéaires ou ramifiés, identiques ou différents, ayant 1 à 12 atomes de carbone ;
R" des groupes alkyle linéaires ou ramifiés, identiques ou différents, ayant 1 à 12 atomes de carbone ou des groupes alkoxy linéaires ou ramifiés ayant 4 à 12 atomes de carbone ;
m vaut 0, 1 ;
n vaut 1, 2, 3.

9. Poly(p-arylènevinylène) selon la revendication 8, **caractérisé en ce que** le substituant aryle à la formule (I) possède les significations suivantes : phényle, 1-naphtyle, 2-naphtyle ou 9-anthracényle.

10. Poly(p-arylènevinylène) selon la revendication 9, **caractérisé en ce que** dans le motif répétitif de formule (I), le substituant aryle présente la configuration de substitution suivante : 2-, 3- ou 4-alkyl(oxy)phényle, 2,3-, 2,4-, 2,5-, 2,6-, 3,4- ou 3,5-dialkyl(oxy)phényle, 2,3,4-, 2,3,5-, 2,3,6-, 2,4,5-, 2,4,6- ou 3,4,5-trialkyl(oxy)phényle, 2-, 3-, 4-, 5-, 6-, 7- ou 8-alkyl(oxy)-1-naphtyle, 1-, 3-, 4-, 5-, 6-, 7- ou 8-alkyl (oxy)-2-naphtyle et 10-alkyl(oxy)-9-anthracényle.

11. Utilisation d'un poly(p-arylènevinylène) selon une ou plusieurs des revendications 1 à 10 en tant que matière électroluminescente.

12. Matière électroluminescente contenant un ou plusieurs poly(p-arylènevinylène) selon une ou plusieurs des revendications 1 à 10.

13. Procédé pour la préparation d'une matière électroluminescente selon la revendication 12, **caractérisé en ce qu'**on applique un ou plusieurs poly(p-arylènevinylènes) présentant des motifs répétitifs de formule (I), sous forme de film sur un substrat, qui présente éventuellement d'autres couches.

14. Dispositif électroluminescent qui présente une ou plusieurs couches actives, au moins l'une de ces couches actives contenant un ou plusieurs poly(p-arylènevinylènes) selon une ou plusieurs des revendications 1 à 10.
